# EUROPEAN PATENT APPLICATION

(11) **EP 4 509 516 A1**
(43) Date of publication of application: **19.02.2025**
(21) Application number: 23784160.6
(22) Date of filing: 21.03.2023
(51) Int. Cl.: C07F 15/00, C09K 11/06

(54) **METAL PLATINUM (II) AND PALLADIUM (II) COMPLEXES, ORGANIC LIGHT-EMITTING DEVICE, AND DISPLAY OR LIGHTING APPARATUS**

(30) Priority: 09.04.2022 CN 202210370303
(71) Applicant: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Guijie, Hangzhou, Zhejiang 310014 (CN); SHE, Yuanbin, Hangzhou, Zhejiang 310014 (CN); HUANG, Disheng, Hangzhou, Zhejiang 310014 (CN); ZHAO, Xiaoyu, Jiaxing, Zhejiang 314107 (CN)
(74) Representative: Chung, Hoi Kan
(86) International application number: PCT/CN2023/082640
(87) International publication number: WO 2023/193596

(57) **Abstract**

The present invention provides a metal platinum (II) and palladium (II) complex, an organic light-emitting device and a display or lighting apparatus, wherein a structure of the metal platinum (II) and palladium (II) complex is as shown in the following formula (I).

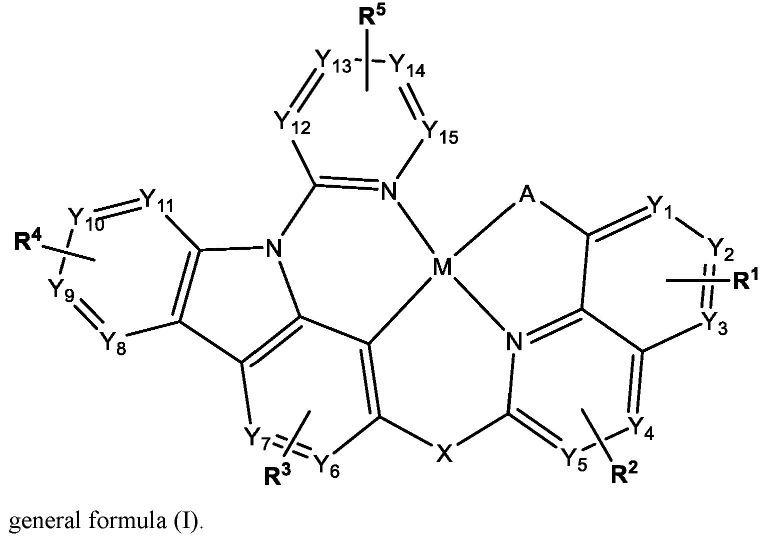

A cyclometalated platinum (II) and palladium (II) complex based on a tetradentate ligand according to the present invention contains molecules having relatively strong rigidity, can effectively inhibit non-radiative transition generated by molecular vibration, and has relatively high quantum efficiency and luminous intensity. Meanwhile, a tetradentate phosphorescent metal complex of the present invention is a novel parent nucleus structure, which may be developed into a series of efficient phosphorescent metal platinum complexes. The present invention has excellent application prospects in the fields of OLED display and lighting and the like, especially in the field of light-emitting layer materials.

## Description

### TECHNICAL FIELD

The present invention relates to a metal platinum (II) and palladium (II) complex, and more particularly, to a metal platinum (II) and palladium (II) complex, an organic light-emitting device, and a display or lighting apparatus, belonging to the technical field of organic light-emitting materials.

### BACKGROUND

Organic light-emitting diodes (OLEDs) are of a new generation of full-color display and lighting technologies. Compared with the shortcomings of slow response speed, small viewing angle, need for a backlight source, and high energy consumption in liquid crystal display, OLED, as an autonomous light-emitting device, requires no backlight source and is thus energy-saving; has low driving voltage, fast response speed, high resolution and contrast, wide viewing angle, and outstanding low-temperature performance; and can be made thinner and also be made into a flexible structure. In addition, it also has the advantages of low production cost, simple production process, large-area production and the like. Therefore, OLED has a wide and huge application prospect in high-end electronic products and aerospace. With the gradual increase of investment, further deepening of research and development, and upgrading of production equipment, OLEDs have a very wide range of application scenarios and development prospects in the future.

The core of OLED development is to design and develop light-emitting materials. In early OLED devices, light-emitting materials are mainly organic small molecule fluorescent materials. However, the spin-based statistical quantum science shows that in the case of electroluminescence, singlet excitons and triplet excitons produced are 25% and 75%, respectively. The maximum theoretical internal quantum efficiency is only 25% because traditional fluorescent materials can only use singlet excitons. In 1998, Professor Forrest of Princeton University and Professor Thompson of the University of Southern California discovered an electrophosphorescence phenomenon of heavy metal organic complex molecules at room temperature. Due to a strong spin-orbit coupling effect of heavy metal atoms, it is easier for excitons to undergo intersystem crossing (ISC) from a singlet state to a triplet state, so that OLED devices can make full use of all singlet and triplet excitons generated by electrical excitation, and the theoretical internal quantum efficiency of light-emitting materials can reach 100% (Nature, 1998, 395, 151). It has opened up a precedent for the research of phosphorescent OLED materials.

At present, heavy metal phosphorescent organic complex molecules and cyclometalated iridium (III) complex molecules are applied in limited quantities. The content of platinum in the earth's crust and the annual output of iridium in the world are about ten times that of iridium metal respectively, and the price of IrCl₃·H₂O (1100 RMB/g) for the preparation of iridium (III) complex phosphorescent materials is also much higher than that of PtCl₂ (210 RMB/g) for the preparation of platinum (II) complex phosphorescent materials. In addition, the preparation of the iridium (III) complex phosphorescent materials involves a four-step reaction of ligand exchange of iridium (III)-containing dimer and iridium (III) intermediate, synthesis of *mer*-iridium (III) complexes and *mer-* to *fac*-iridium (III) complex isomer conversion, which greatly reduces a total yield, greatly reduces a utilization rate of raw material IrCl₃·H₂O, and improves the preparation cost of the iridium (III) complex phosphorescent materials. In contrast, the preparation of the platinum (II) complex phosphorescent materials includes metallization of ligands only in the last step to design the reaction of platinum salts, and a utilization rate of platinum element is high, which can further reduce the preparation cost of the platinum (II) complex phosphorescent materials. In summary, the preparation cost of the platinum (II) complex phosphorescent materials is much lower than that of the iridium (III) complex phosphorescent materials.

Alq₃, an 8-hydroxyquinoline aluminum complex, is an early type of fluorescent OLED metal complexes, which achieves green light emission with a maximum wavelength of 550 nm, laying the foundation for the development of OLED. However, fluorescent molecules of aluminum complexes cannot be used as ideal light-emitting layer materials because of low quantum efficiency. In 2016, Ilya Taydakov et al. designed an 8-hydroxyquinoline-based bidentate platinum complex that achieved red-orange light emission at 640 nm, but the quantum efficiency thereof in a solution could only reach about 1.5%.

A cyclometalated platinum (II) complex based on bidentate ligands has low molecular rigidity, and two bidentate ligands are easy to distort and vibrate, resulting in non-radiative attenuation and accordingly low phosphorescent quantum efficiency. However, a molecule of a cyclometalated platinum (II) complex based on tridentate ligands requires a second coordination anion (such as alkyne anion, Cl- or carbene), which will also lead to the reduction of the chemical and thermal stability of the complex. The above reasons are not conducive to the application of this complex as a phosphorescent material in OLED devices. In contrast, a cyclometalated metal platinum (II) complex based on a tetradentate ligand has strong molecular rigidity, high radiation luminescence rate, greatly improved quantum efficiency, as well as high chemical and thermal stability, and thus serves as ideal molecules for the development of novel OLED phosphorescent materials. The development of stable and efficient novel phosphorescent materials is still of great significance to the development of the OLED industry.

### SUMMARY

The present invention provides a metal platinum (II) and palladium (II) complex (phosphorescent material) containing a quinoline structural unit and a bridging structure, which can be used as a light-emitting material in OLED devices.

A cyclometalated platinum (II) and palladium (II) complex based on a tetradentate ligand according to the present invention contains molecules having relatively strong rigidity, can effectively inhibit non-radiative transition generated by molecular vibration, and has relatively high quantum efficiency and luminous intensity. Meanwhile, a tetradentate phosphorescent metal complex of the present invention is a novel parent nucleus structure, which may be developed into a series of efficient phosphorescent metal platinum complexes.

The present invention provides a metal platinum (II) and palladium (II) complex containing a quinoline structural unit and a bridging structure, the metal platinum (II) and palladium (II) complex containing the quinoline structural unit and the bridging structure has a structure as shown in general equation (I): 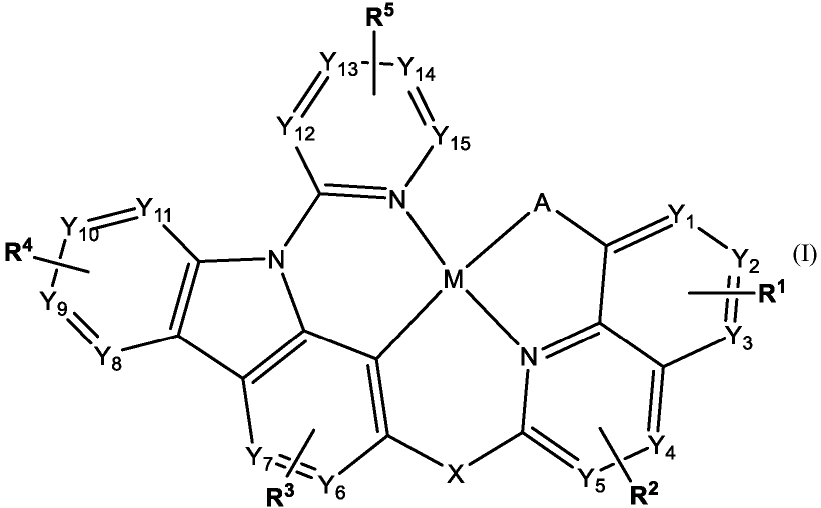 in which:
M is selected from Pt or Pd;
X may be O, S, CH₂, CHD, CD₂, CR⁷R⁸, C=O, SiR⁹R¹⁰, NR¹¹, PH, PD, PR¹², R¹³P=O, S=O , or SO₂;
A is selected from O, S or NR⁶;
Y¹, Y², Y³, Y⁴, Y⁵, Y⁶, Y⁷, Y⁸, Y⁹, Y¹⁰, Y¹¹, Y¹², Y¹³, Y¹⁴ and Y¹⁵ are each independently N or CH; and
substitution modes of R¹, R², R³, R⁴ and R⁵ are each independently expressed as single substitution, double substitution, triple substitution, quadruple substitution or no substitution; R¹, R², R³, R⁴ and R⁵ are each independently expressed as hydrogen, deuterium, alkyl, haloalkyl, cycloalkyl, alkoxyl, aryl, heteroaryl, aryloxyl, halogen, cycloalkenyl, heterocyclyl, alkenyl, alkynyl, hydroxyl, sulfhydryl, nitro, cyano, amino, monoalkylamino or dialkylamino, monoarylamino or diarylamino, ester group, nitrile group, isonitrile group, alkoxycarbonyl, acylamino, alkoxycarbonylamino, aryloxycarbonylamino, sulfonylamino, sulfamido, aminocarbonyl, alkylthio, sulfinyl, uramido, phosphinamide group, imido, sulfo, carboxyl, hydrazino, silyl, substituted silyl, polymerized group, or a combination thereof; and two or more adjacent R¹, R², R³, R⁴ and R⁵ can be selectively linked to form a fused ring.

Preferably, the metal platinum (II) and palladium (II) complex containing the quinoline structural unit has a structure as shown in the followings:

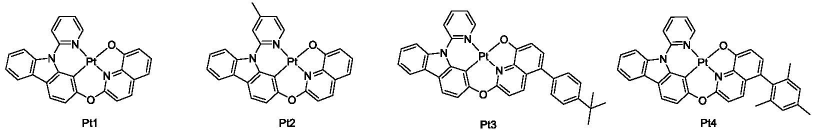

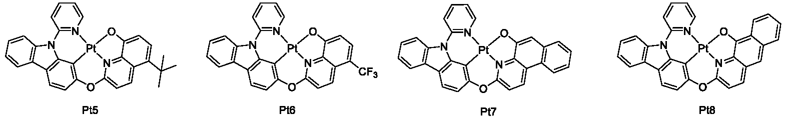

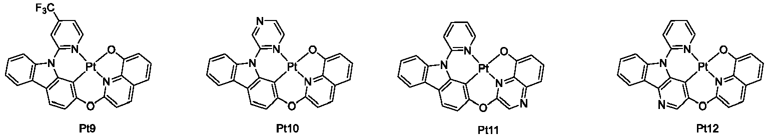

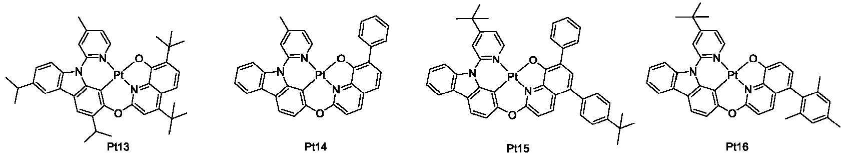

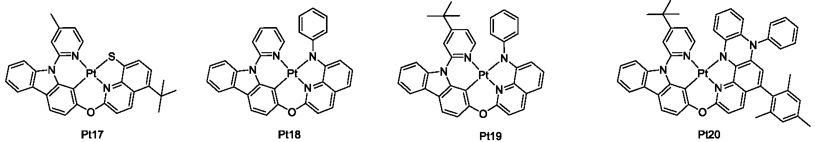

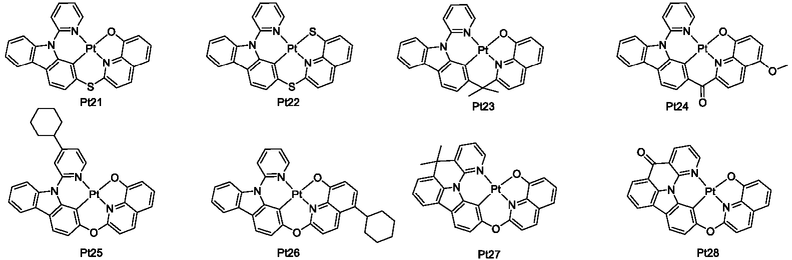

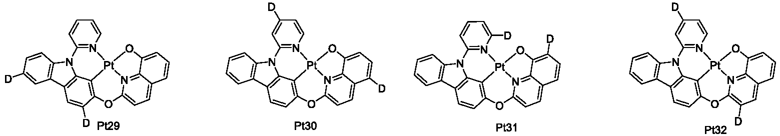

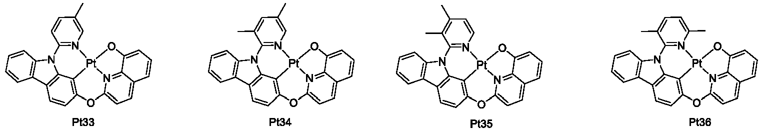

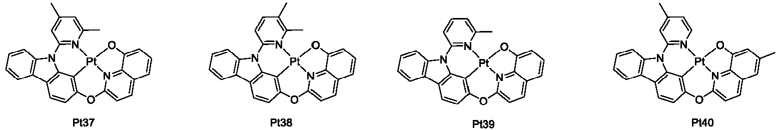

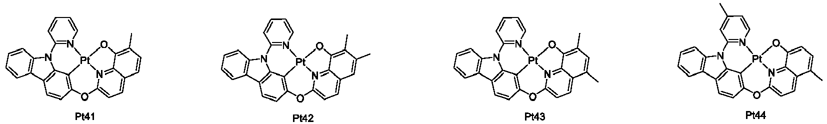

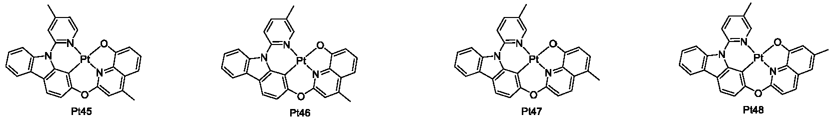

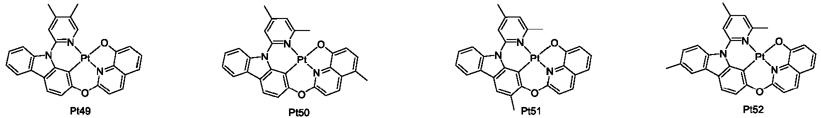

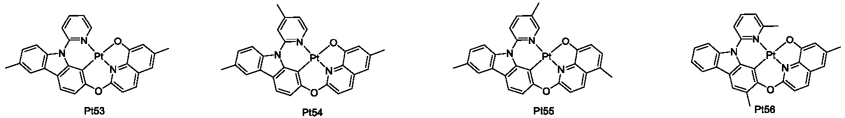

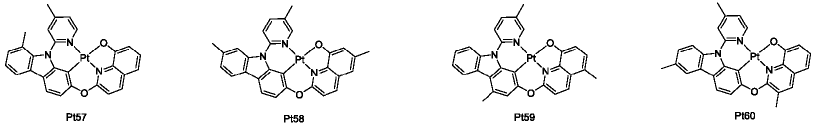

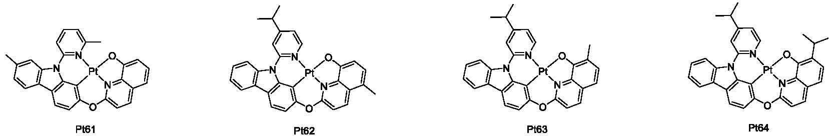

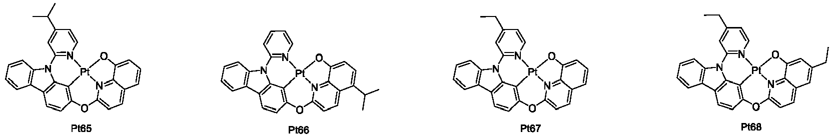

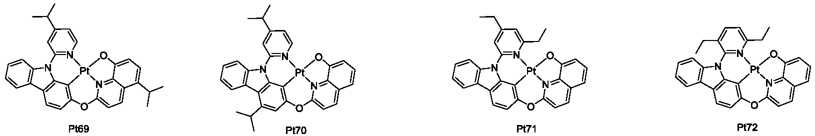

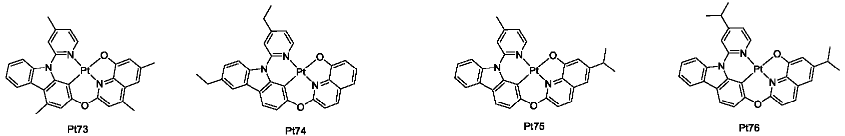

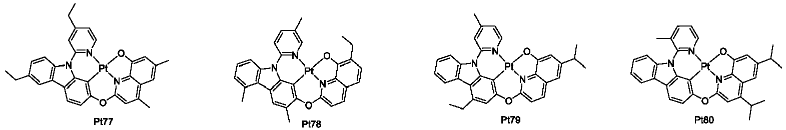

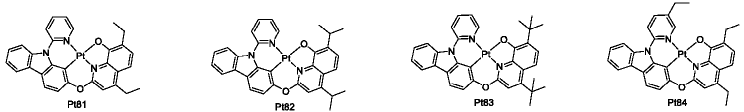

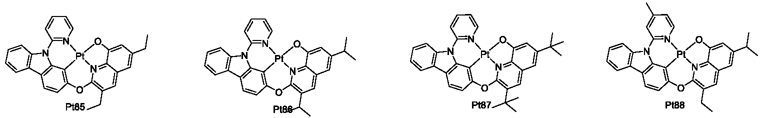

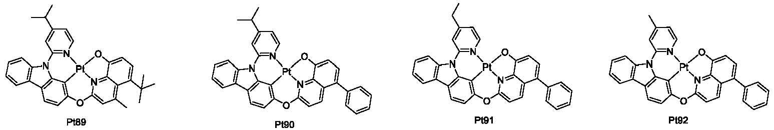

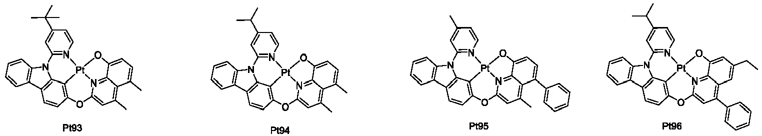

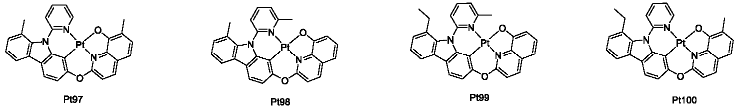

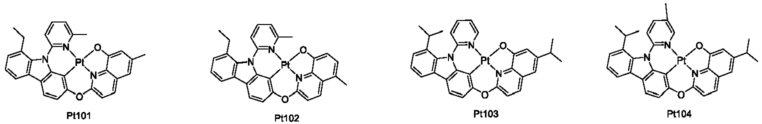

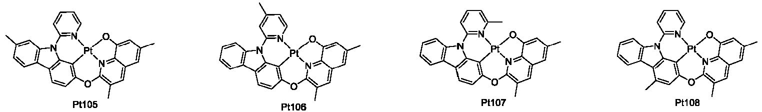

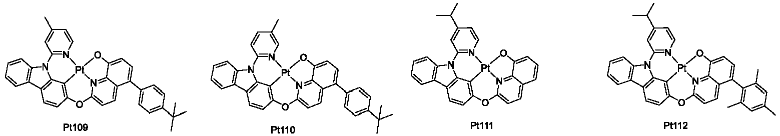

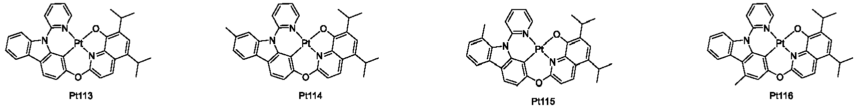

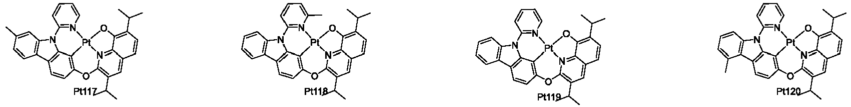

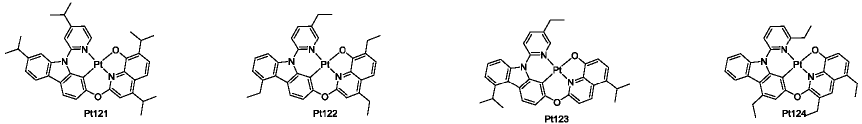

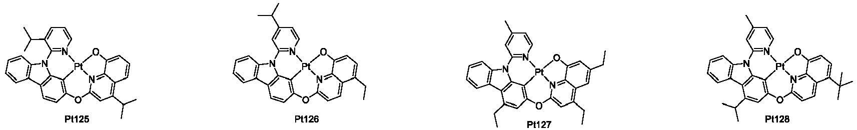

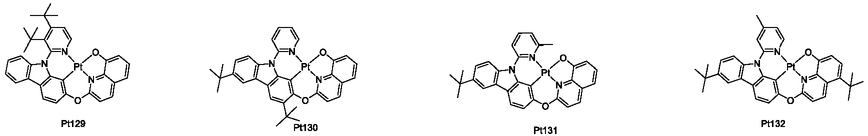

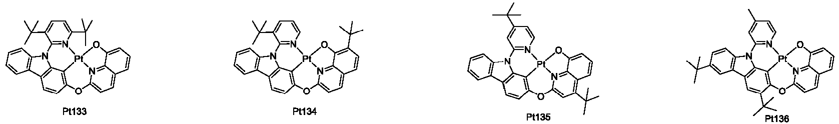

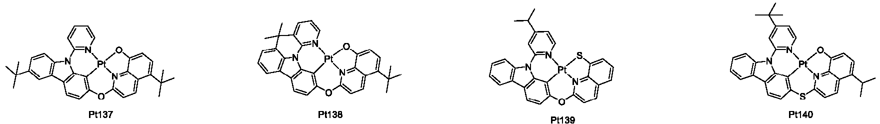

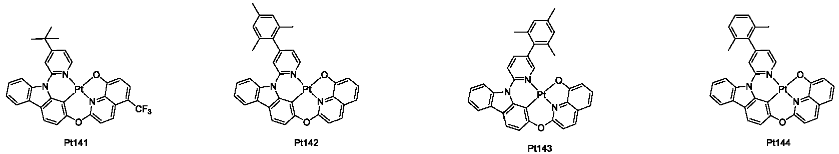

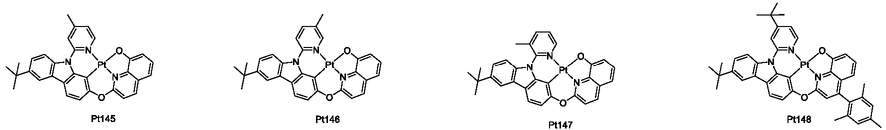

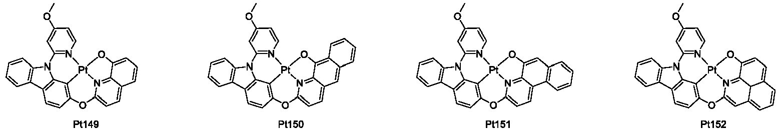

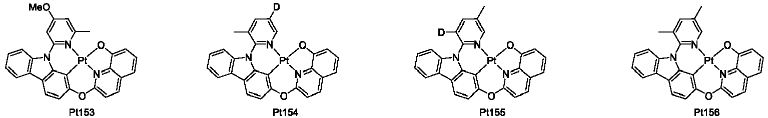

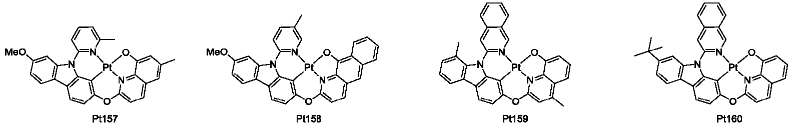

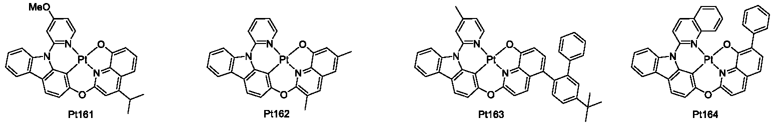

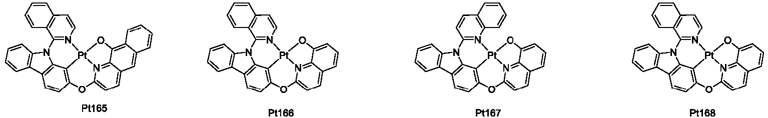

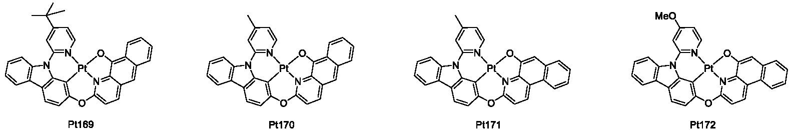

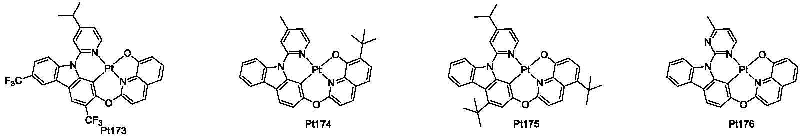

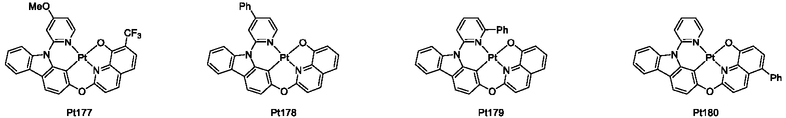

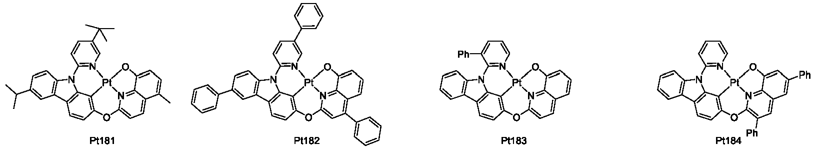

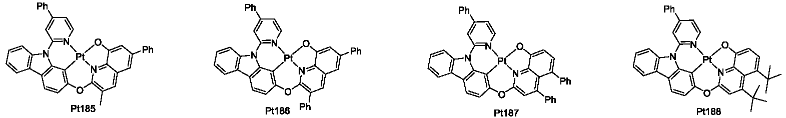

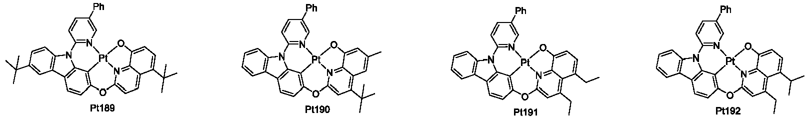

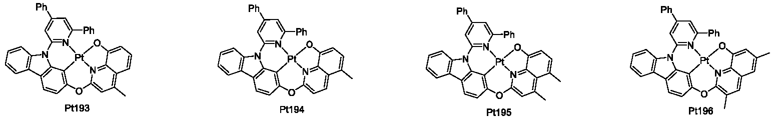

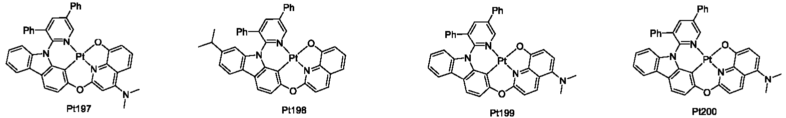

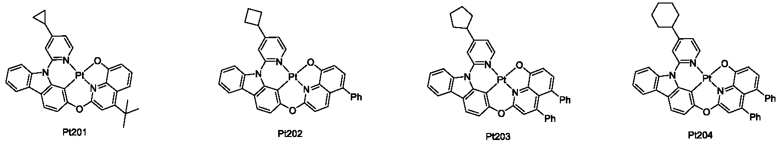

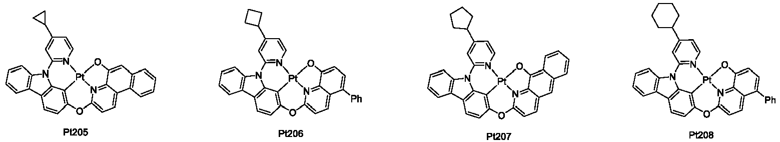

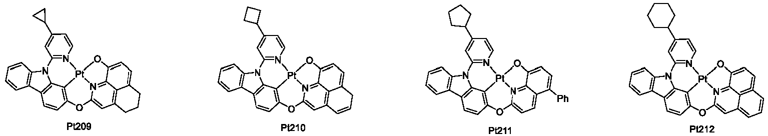

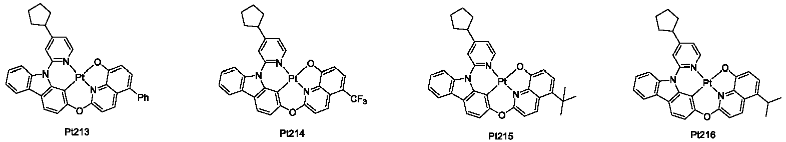

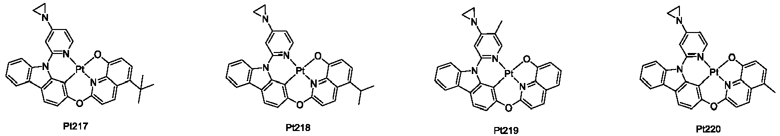

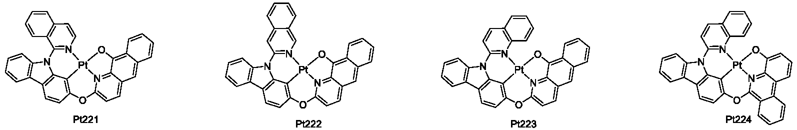

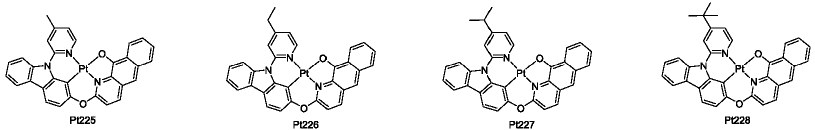

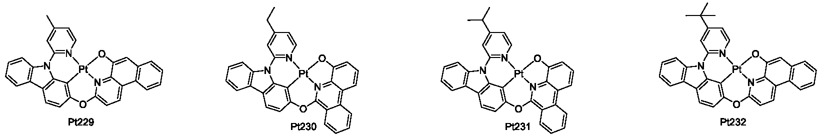

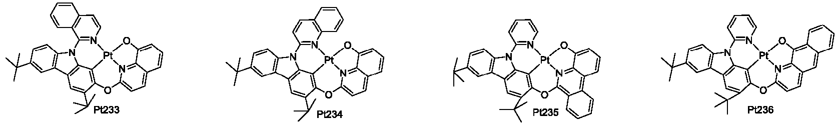

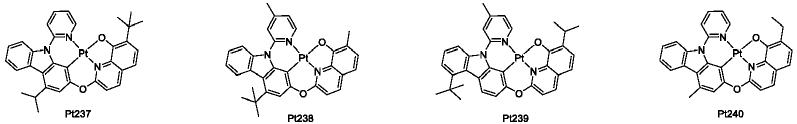

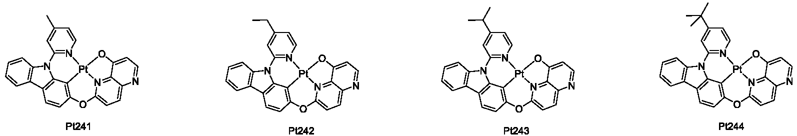

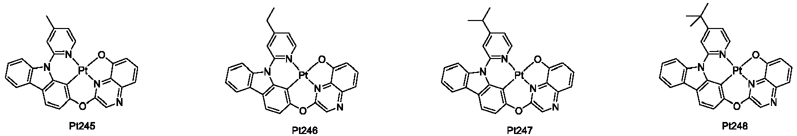

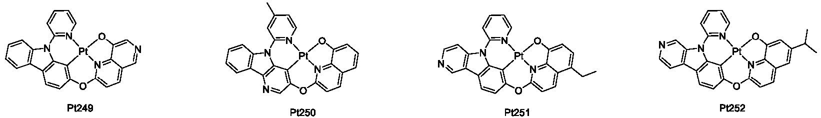

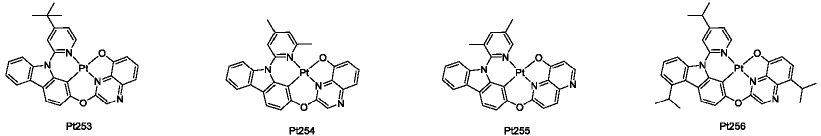

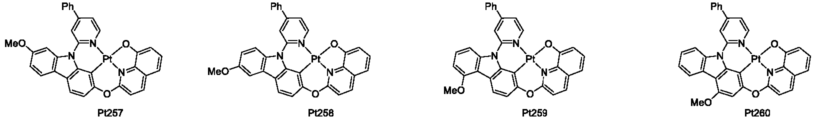

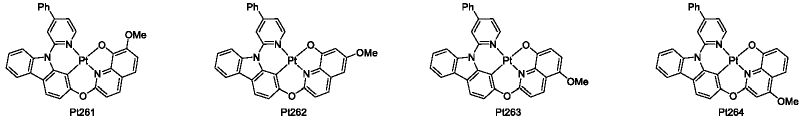

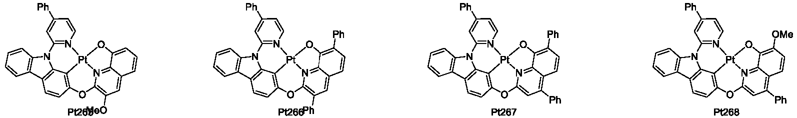

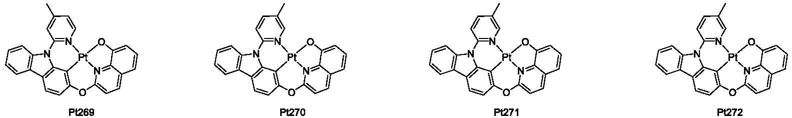

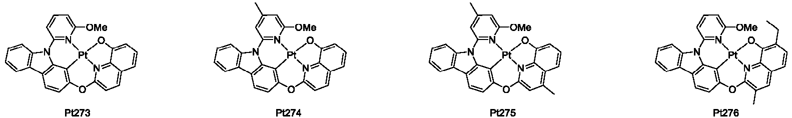

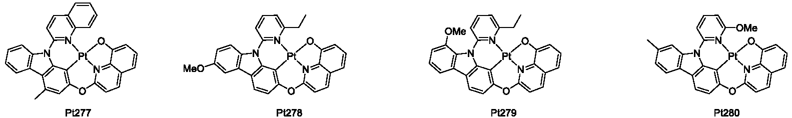

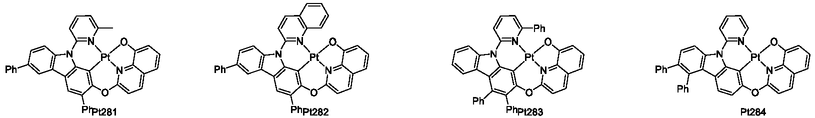

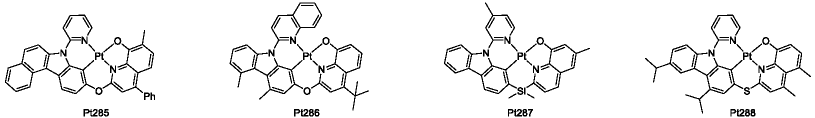

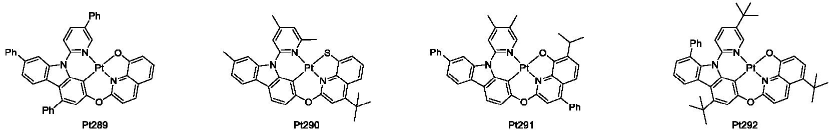

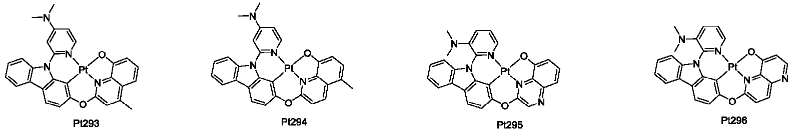

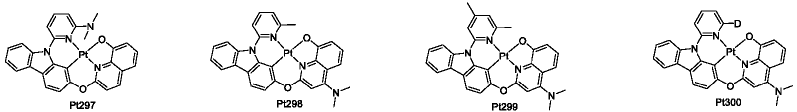

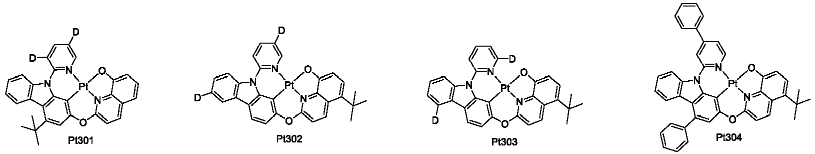

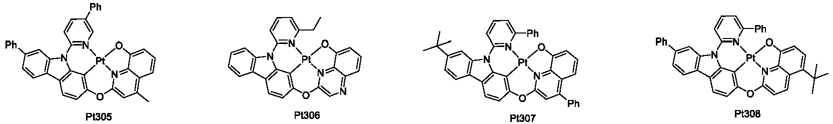

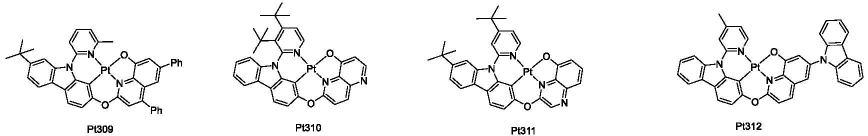

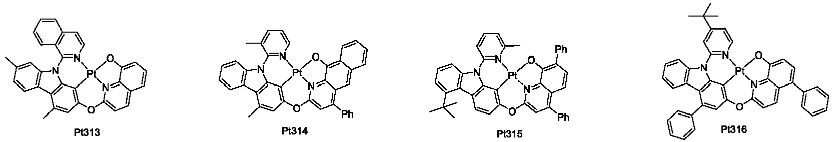

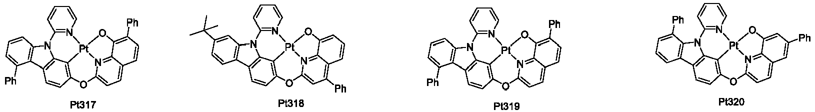

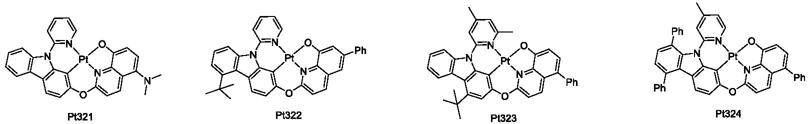

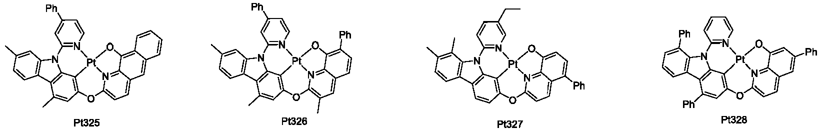

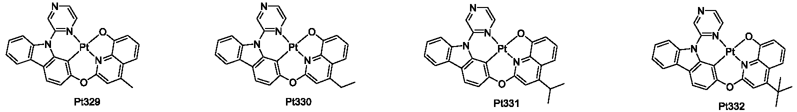

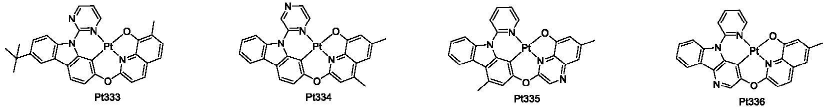

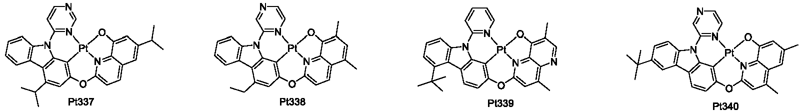

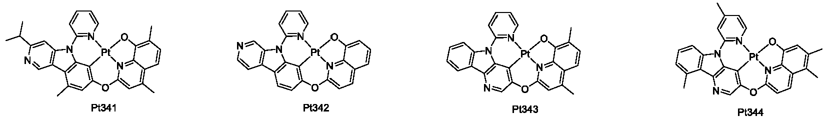

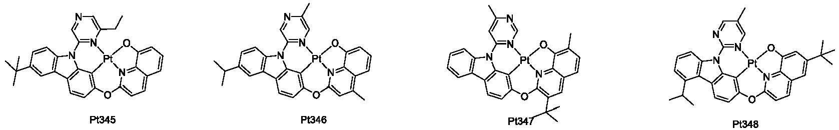

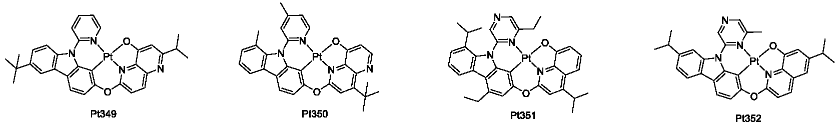

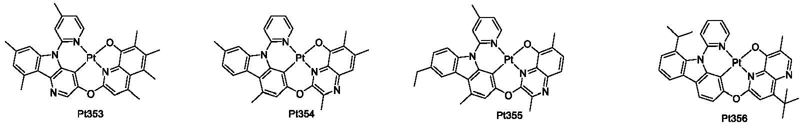

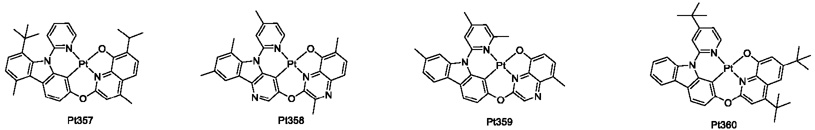

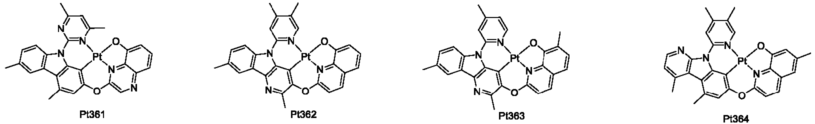

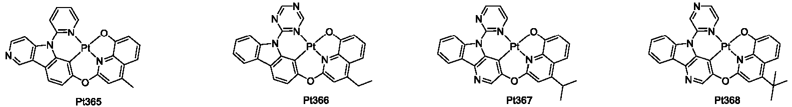

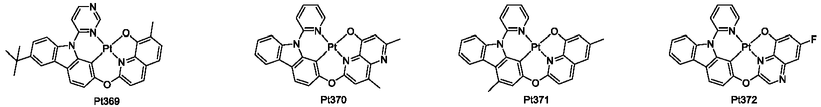

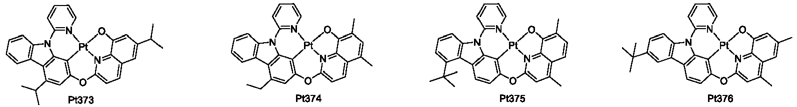

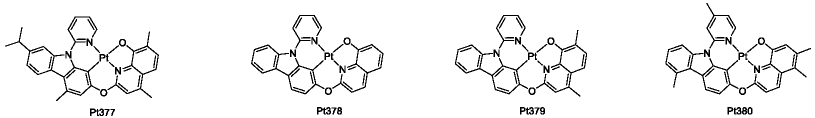

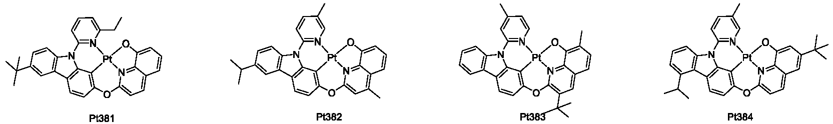

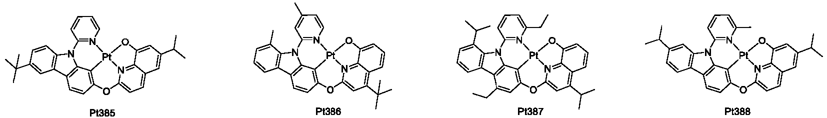

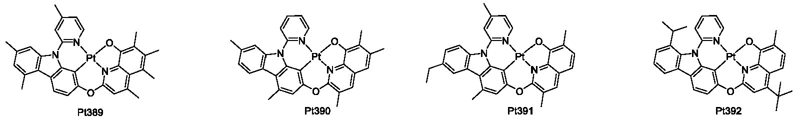

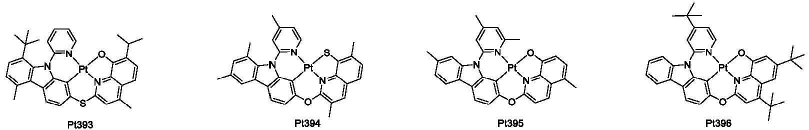

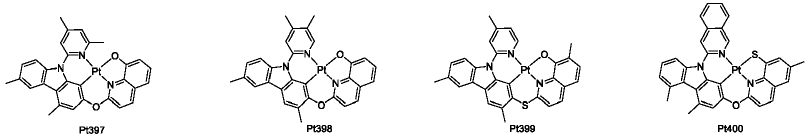

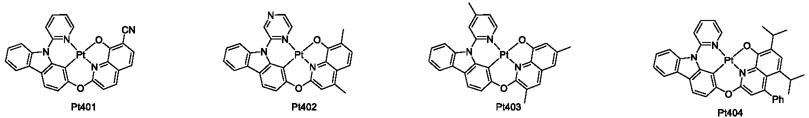

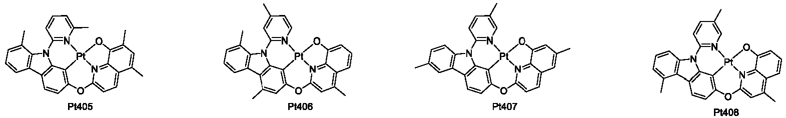

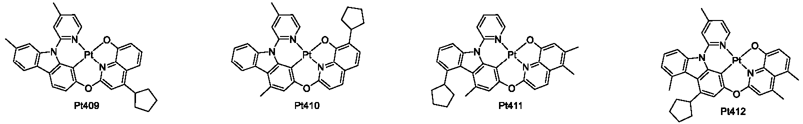

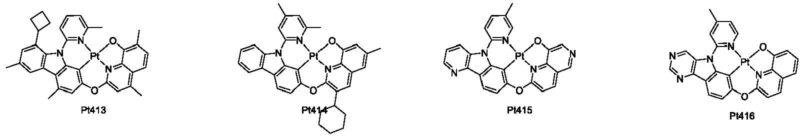

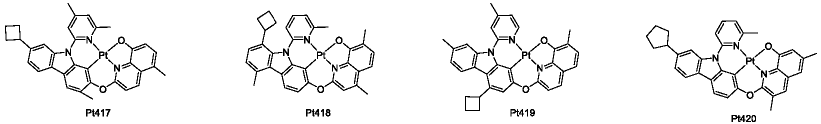

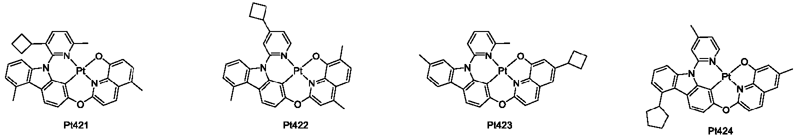

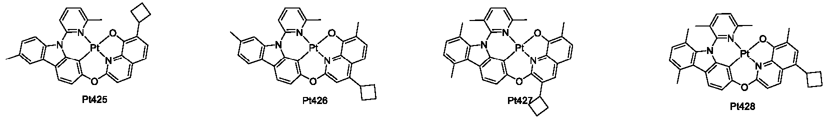

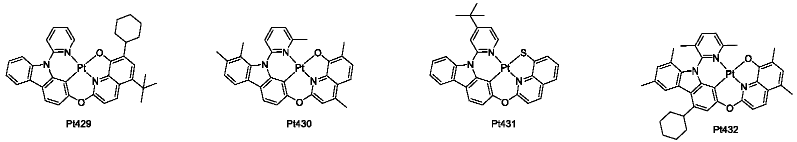

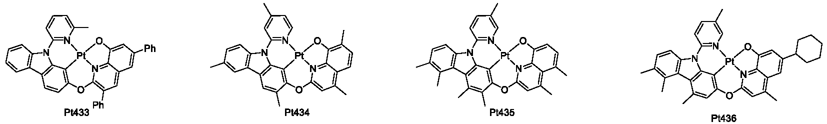

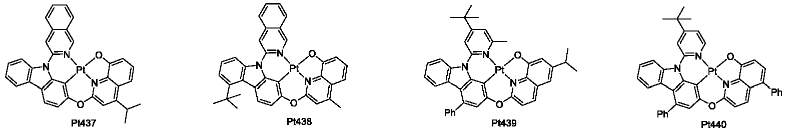

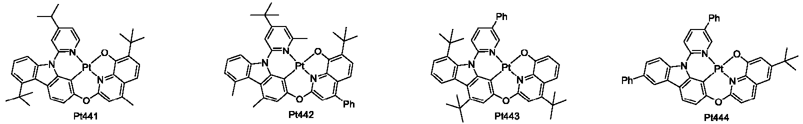

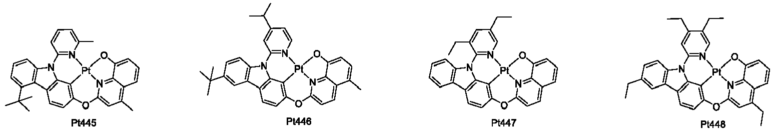

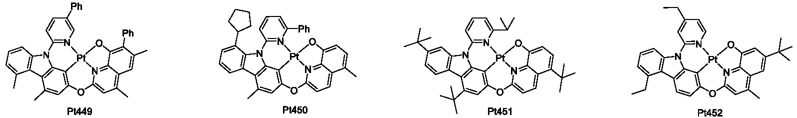

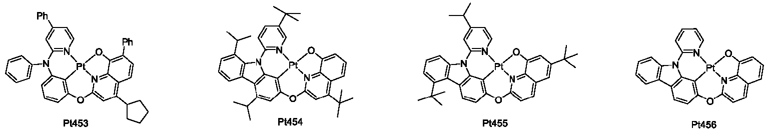

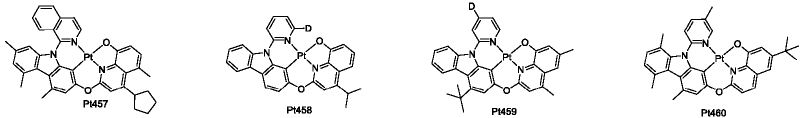

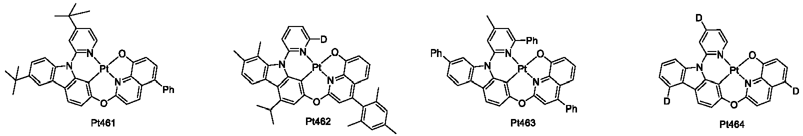

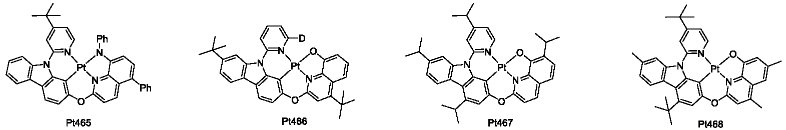

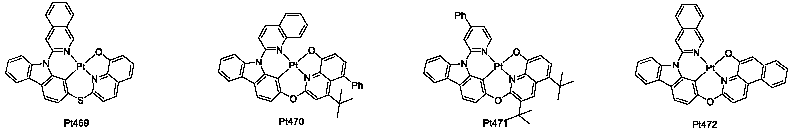

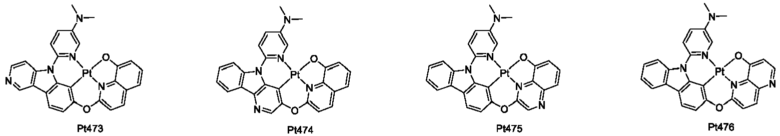

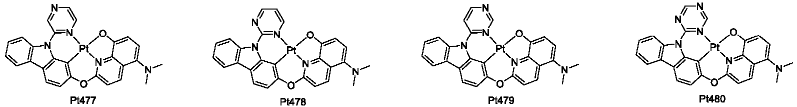

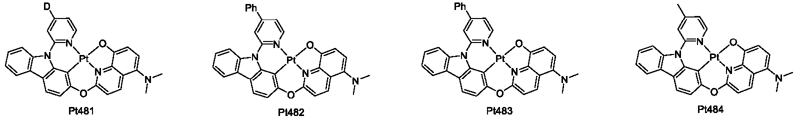

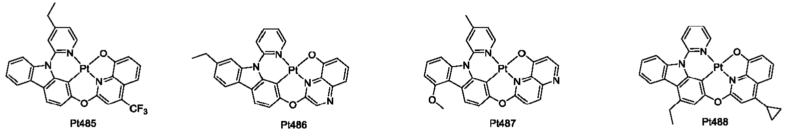

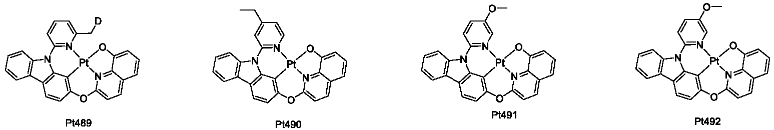

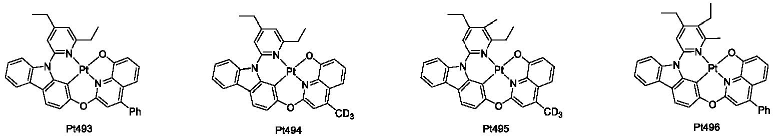

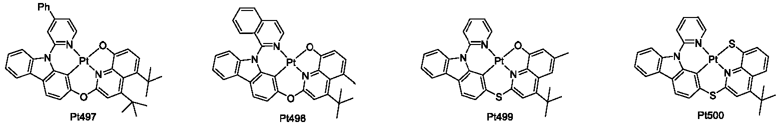

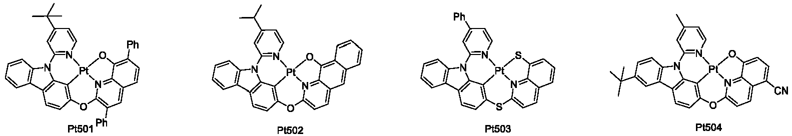

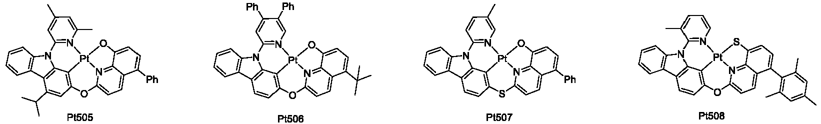

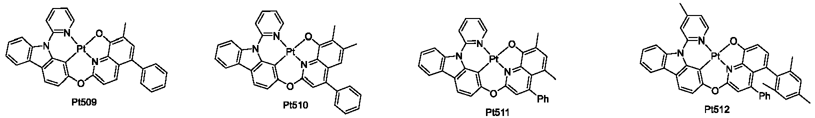

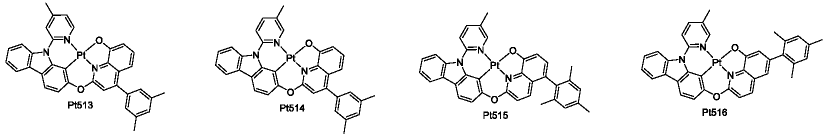

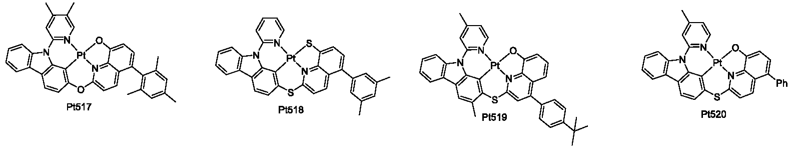

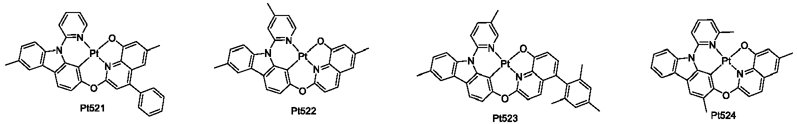

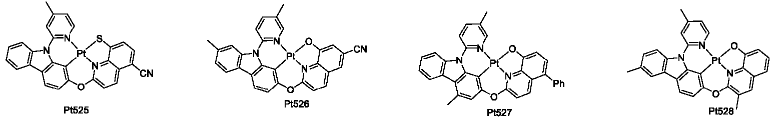

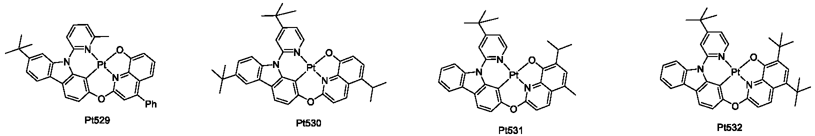

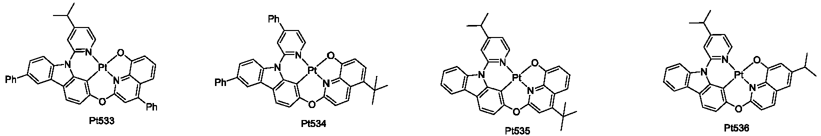

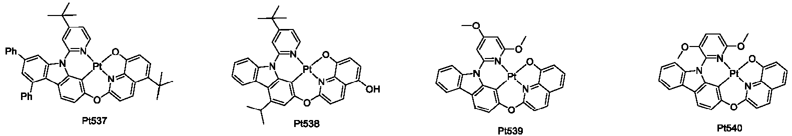

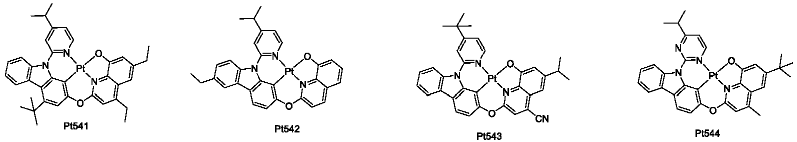

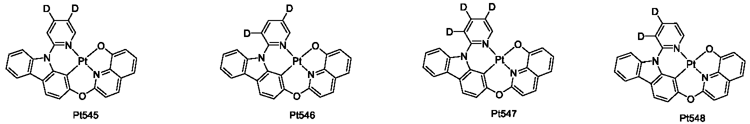

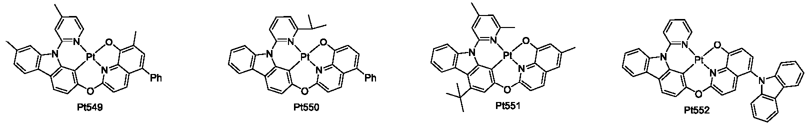

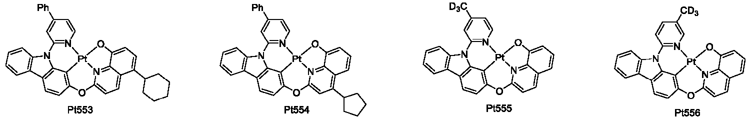

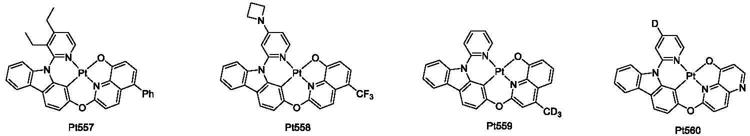

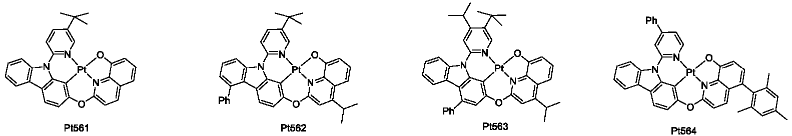

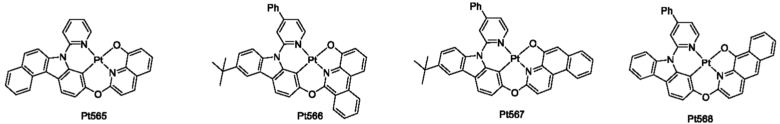

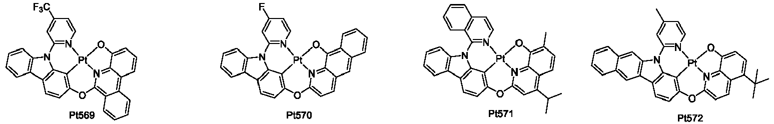

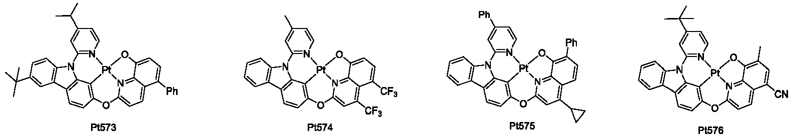

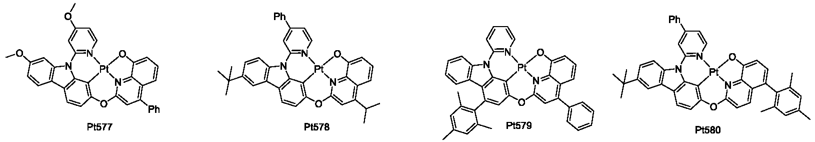

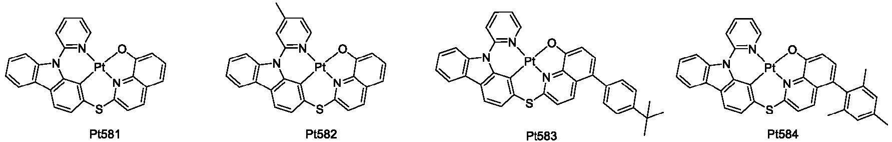

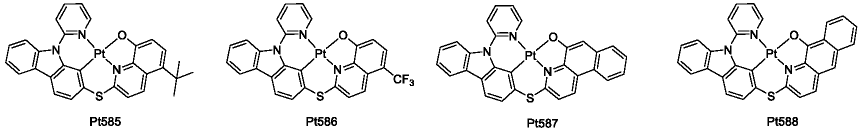

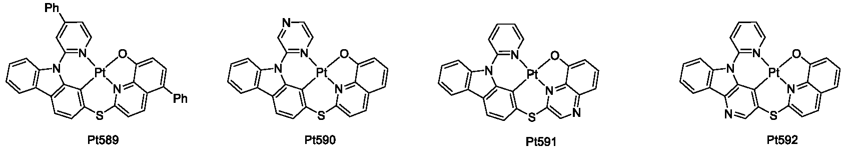

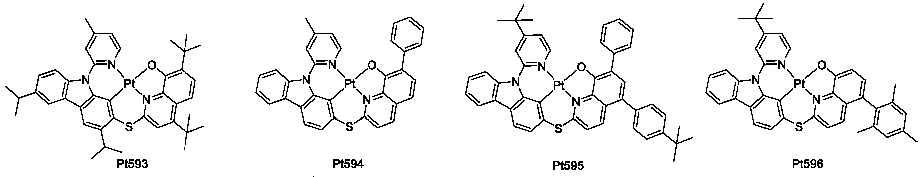

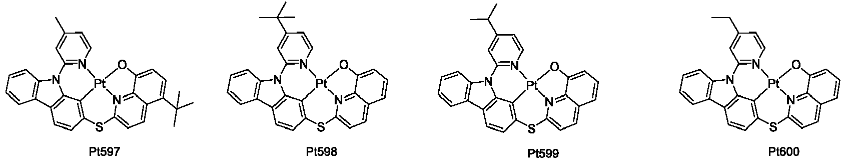

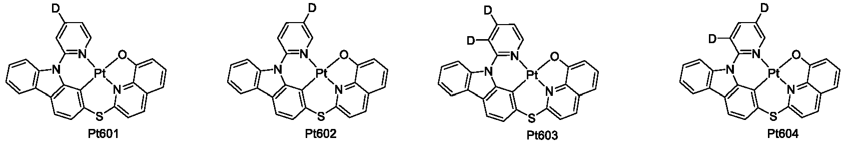

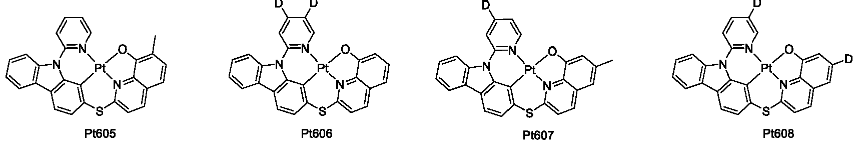

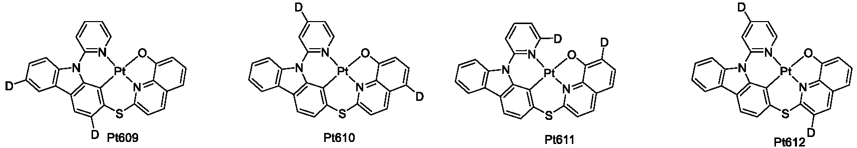

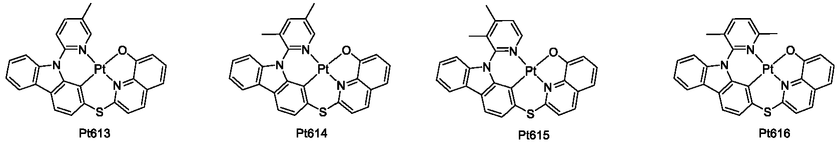

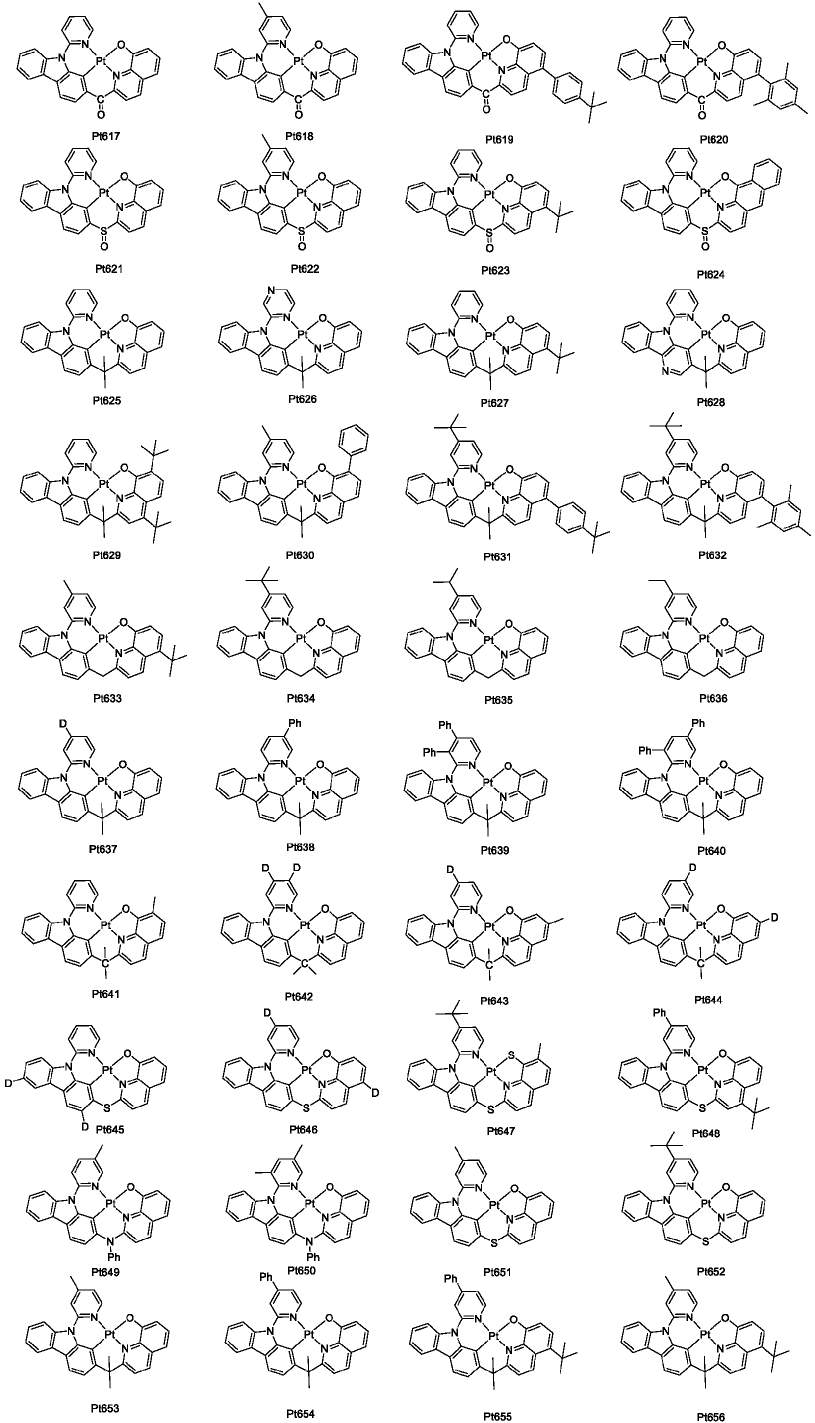

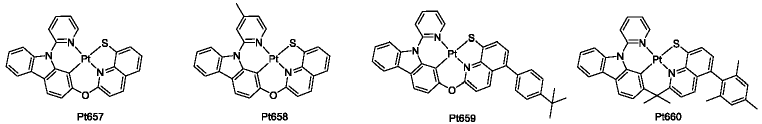

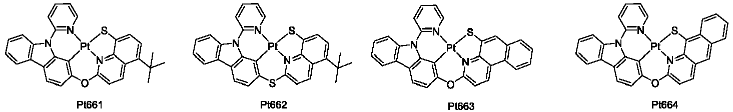

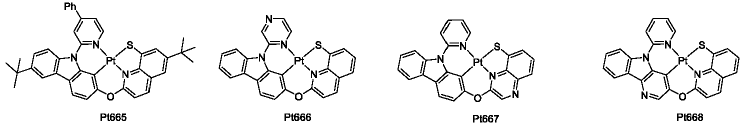

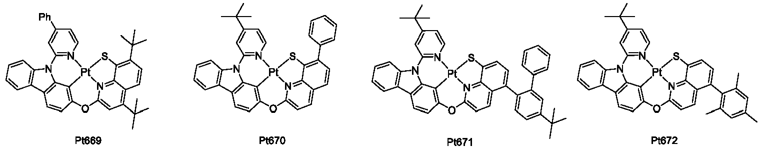

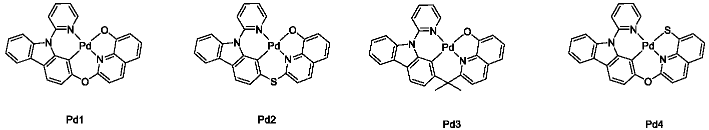

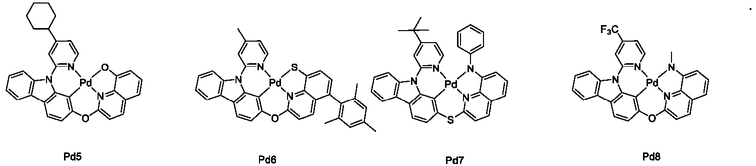

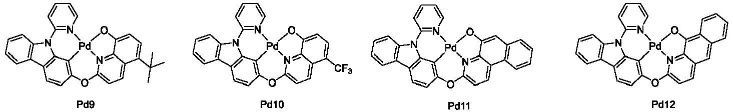

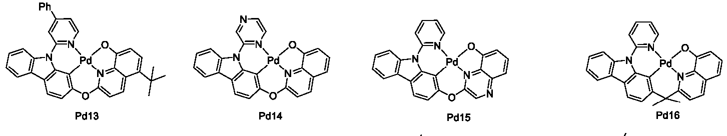

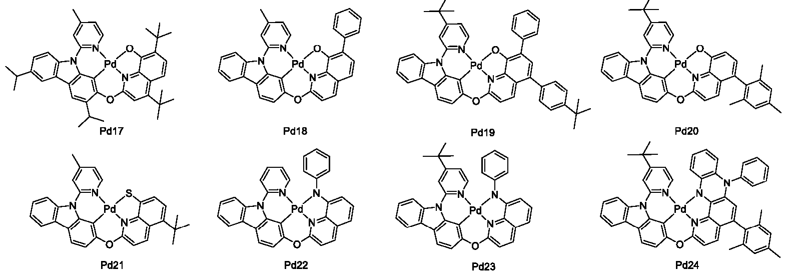

The present invention further provides an organic light-emitting device, which includes a light-emitting layer on a substrate, the light-emitting layer containing the metal platinum (II) and palladium (II) complex containing the quinoline structural unit and the bridging structure.

The present invention further provides a device, the device containing the metal platinum (II) and palladium (II) complex containing the quinoline structural unit and the bridging structure.

Preferably, the device is a full-color display, a photovoltaic device, a light-emitting display device or an organic light-emitting diode.

Preferably, the device includes at least one cathode, at least one anode and at least one light-emitting layer, wherein at least one of the light-emitting layers contains the metal platinum (II) and palladium (II) complex containing the quinoline structural unit and the bridging structure.

More preferably, the device is an organic light-emitting diode which has a light-emitting layer, the light-emitting layer containing a corresponding host material and the metal platinum (II) and palladium (II) complex containing the quinoline structural unit and the bridging structure, wherein a mass percentage of the metal platinum (II) or palladium (II) complex ranges 1% from 50%, and the host material is not limited.

The present invention further provides a display or lighting apparatus, the display or lighting apparatus including the device described above.

The present invention further provides an application of the metal platinum (II) and palladium (II) complex in the manufacture of an organic light-emitting device.

The metal platinum (II) and palladium (II) complex containing the quinoline structural unit and the bridging structure of the present invention may be used as a light-emitting material for an electroluminescent device. Further, this complex may be applied to a full-color display, a light-emitting display device or an organic light-emitting diode. This device includes at least one cathode, at least one anode and at least one light-emitting layer, wherein at least one of the light-emitting layers contains the metal platinum (II) and palladium (II) complex containing the quinoline structural unit according to any one of aspects.

The present invention has the beneficial effect that two bidentate ligands are easy to vibrate and distort, resulting in non-radiative attenuation and accordingly low phosphorescence efficiency. Compared with a bidentate platinum complex, a tetradentate platinum complex has a rigid structure that can effectively inhibit the non-radiative attenuation caused by molecular vibration and can achieve both high-efficiency luminescence and good thermal stability, and thus serves as a more ideal phosphorescent material. According to the present invention, the photophysical properties of the metal platinum complex are adjusted by changing a ligand structure around a metal center and regulating a substituent structure on a ligand. The metal platinum (II) and palladium (II) complex of the present invention has broad application prospects in OLED display and lighting, and other fields, especially as a light-emitting layer material.

### BRIEF DESCRIPTION OF DRAWINGS

To describe the technical solutions in the examples of the present invention more clearly, the following briefly introduces the accompanying drawings required for describing the examples. Apparently, the accompanying drawings in the following description show merely some examples of the present invention, and a person of ordinary skill in the art may still derive other drawings from these accompanying drawings without paying creative efforts, in which:
FIG. 1 is an emission spectrum of a platinum complex Pt1 in a dichloromethane solution at room temperature in a specific embodiment;
FIG. 2 is an emission spectrum of a platinum complex Pt3 in a dichloromethane solution at room temperature in a specific embodiment;
FIG. 3 shows HOMO and LUMO orbital distributions and their energy level comparisons of Pt1, Pt2, Pt3 and Pt4 calculated by the density functional theory (DFT);
FIG. 4 shows HOMO and LUMO orbital distributions and their energy level comparisons of Pt5, Pt6, Pt7 and Pt8 calculated by the density functional theory (DFT);
FIG. 5 shows HOMO and LUMO orbital distributions and their energy level comparisons of Pt9, Pt10, Pt11 and Pt12 calculated by the density functional theory (DFT); and
FIG. 6 shows HOMO and LUMO orbital distributions and their energy level comparisons of Pt13, Pt14, Pt15 and Pt16 calculated by the density functional theory (DFT); and
FIG. 7 is a schematic structural diagram of an organic light-emitting element.

### DETAILED DESCRIPTION OF THE EMBODIMENTS

It should be noted that the foregoing general description and the following detailed description are only exemplary and explanatory, but not restrictive.

The present disclosure may be more easily understood by referring to the following specific embodiments and the examples contained therein.

Prior to disclosing and describing compounds, devices and/or methods of the present invention, it should be understood that they are not limited to specific synthesis methods (otherwise they will be indicated additionally), or specific reagents (otherwise they will be indicated additionally), because they are of course changeable. It should also be understood that the terms used in the present invention are intended only to describe specific aspects and are not intended to be restrictive. Although any method and material similar or equivalent to those described in the present invention may be used in the practice or test, the following exemplary methods and materials are described below.

In a preferred embodiment of the present invention, an OLED device of the present invention contains a hole transport layer. A hole transport material may be preferably selected from known or unknown materials, and in particular preferably from the following structure, but does not mean that the present invention is limited to the following structure:

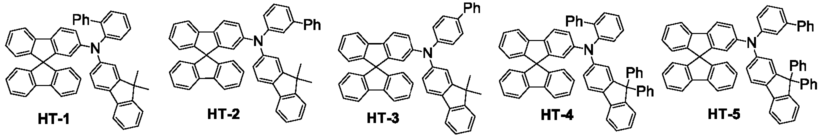

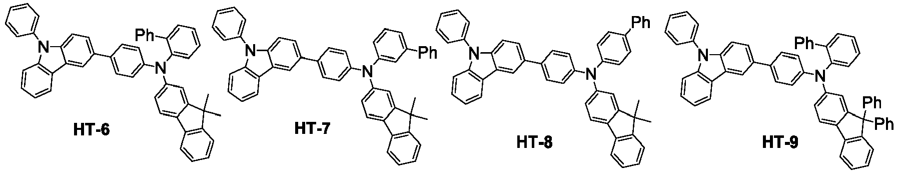

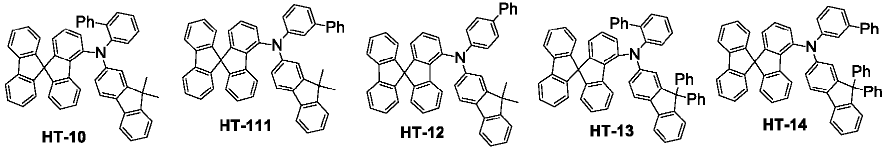

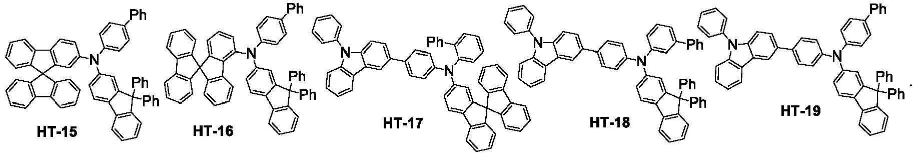

In a preferred embodiment of the present invention, a hole transport layer contained in the OLED device of the present invention contains one or more p-type dopants. Preferably, the p-type dopant in the present invention has the following structure, but does not mean that the present invention is limited to the following structure:

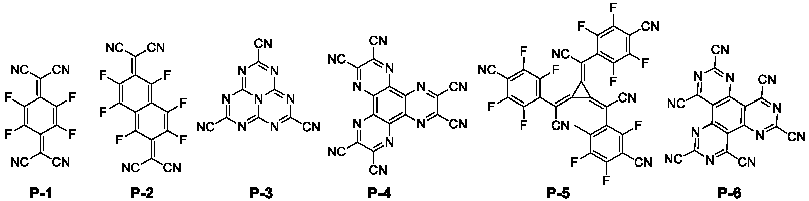

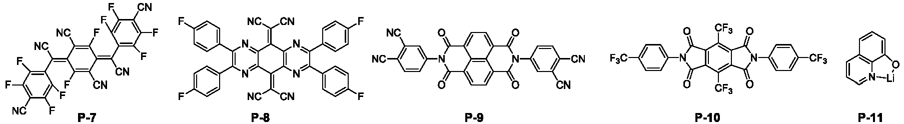

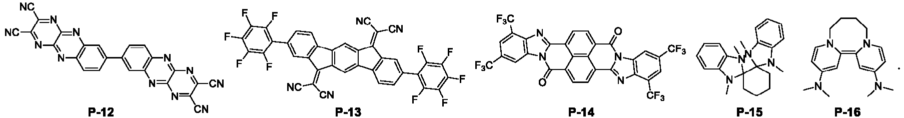

In a preferred embodiment of the present invention, an electron transport layer may be selected from at least one of compounds ET-1 to ET-13, but does not mean that the present invention is limited to the following structure:

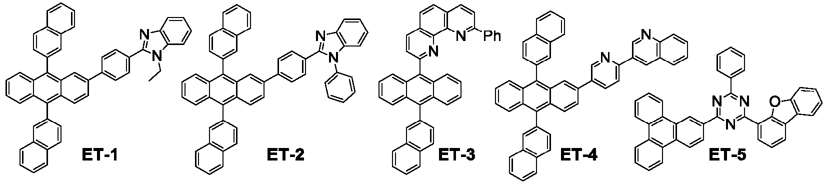

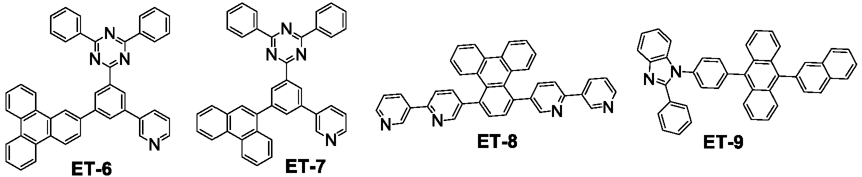

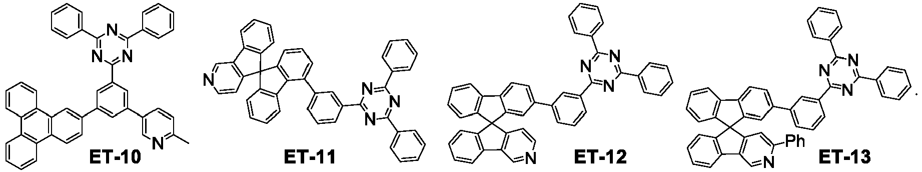

The term "optional" or "optionally" used in the present invention means that an event or situation described later may or may not occur, this description including the occurrence of the event or situation and the non-occurrence of the event or situation.

Components that may be used to prepare a composition described in the present invention and the composition itself in a method to be used in the present invention are disclosed. These and other substances are disclosed in the present invention, and it should be understood that when combinations, subsets, interactions, groups, etc. of these substances are disclosed, and the specific references to various individual and aggregate combinations and displacements of each of these compounds cannot be specifically disclosed, each of these compounds is specifically expected and described in the present invention. For example, if a specific compound is disclosed and discussed, and a number of modifications that can be made to many molecules containing the compound are discussed, various and every combination and displacement of the compound are specifically expected and these modifications may be made, otherwise they will be specifically pointed out separately and specifically to the contrary. Therefore, if examples of a class of molecules A, B and C and a class of molecules D, E and F, as well as a combination of molecules A-D are disclosed, consideration is given to disclose each of the individually and aggregately intended combinations of meanings, A-E, A-F, B-D, B-F, C-D, C-E and C-F, even if each is not separately documented. Similarly, any subset or combinations of these subsets are disclosed. Therefore, for example, consideration should be given to disclose groups A-E, B-F and C-E. These concepts apply to all aspects of the present invention, including, but not limited to, the steps in the method for preparing and using the composition. Therefore, if there are various additional steps that can be carried out, it should be understood that these additional steps can each be carried out in the specific embodiment of the method or a combination of the embodiments.

A linking atom used in the present invention is capable of linking two groups, e.g., N and C groups. This linking atom is capable of optionally (if a valence bond allows) having other attached chemical moieties. For example, in an aspect, oxygen may not have any other chemical groups attached because the valence bond has already been satisfied once bonded to two atoms (e.g., N or C). Conversely, when carbon functions as a linking atom, two additional chemical moieties can attach to this carbon atom. Suitable chemical moieties include, but are not limited to, hydrogen, hydroxyl, alkyl, alkoxyl, =O, halogen, nitro, amine, amide, sulfydryl, aryl, heteroaryl, cycloalkyl, and heterocyclyl.

The term "cyclic structure" or similar terms used in the present invention refer to any cyclic chemical structure, including, but not limited to, aryl, heteroaryl, cycloalkyl, cycloalkenyl, heterocyclyl, carbene, and N-heterocyclic carbene.

The term "substituted" used in the present invention is intended to contain all permissible substituents of an organic compound. In terms of broadness, permissible substituents include non-cyclic and cyclic, branched and unbranched, carbocyclic and heterocyclic, and aromatic and non-aromatic substituents of the organic compound. Descriptive substituents include, for example, those described below. For a suitable organic compound, one or more substituents which are the same or different are allowed. For the purposes of the present invention, a heteroatom (e.g., nitrogen) is capable of having a hydrogen substituent and/or any permissible substituent of the organic compound of the present invention satisfying a valence bond of this heteroatom. The present disclosure is not intended to impose any restriction in any way with permissible substituents for the organic compound. Similarly, the term "substitution" or "substituted" encompasses an implicit condition that such substitution conforms to valence bonds allowed by the substituted atom and this substituent, and that such substitution leads to a stable compound (e.g., a compound that does not undergo spontaneous transformations (e.g., by rearrangement, cyclization, and elimination)). It is also expected that, in some respects, unless explicitly to the contrary noted, individual substituents can be further optionally substituted (i.e., further substituted or unsubstituted).

As various terms are defined, "R¹", "R²", "R³" and "R⁴" are used as general symbols in the present invention to denote various specific substituents. These symbols may be any substituent, not limited to those disclosed in the present invention. When these symbols are limited to certain substituents in one case, they may be limited as some other substituents in other cases.

The term "alkyl" used in the present invention is saturated hydrocarbyl of 1 to 24 branched or unbranched carbon atoms, such as: methyl, ethyl, n-propyl, isopropyl, n-butyl, isobutyl, sec-butyl, tert-butyl, n-amyl, isoamyl, sec-amyl, neoamyl, hexyl, heptyl, semi-base, nonyl, decyl, dodecyl, tetradecyl, hexadecyl, eicosyl, and tetracosyl. This alkyl may be cyclic or non-cyclic. This alkyl may be branched or non-branched. This alkyl may be substituted or unsubstituted. For example, in this alkyl, one or more groups may be substituted, including, but not limited to: optionally substituted alkyl, cycloalkyl, alkoxyl, amino, halogen, hydroxyl, nitro, silyl, sulfo-oxo or sulfydryl as described in the present invention. The "lower alkyl" group is alkyl containing 1 to 6 (e.g., 1 to 4) carbon atoms.

Throughout the specification, "alkyl" is often used to refer to both unsubstituted and substituted alkyl. However, substituted alkyl is also specifically mentioned in the present invention by determining specific substituents on the alkyl. For example, the term "halogenated alkyl" or "haloalkyl" specifically refers to alkyl in which one or more halogens (e.g., fluorine, chlorine, bromine or iodine) are substituted. The term "alkoxyalkyl" specifically refers to alkyl in which one or more alkoxyl is substituted, as described below. The term "alkylamino" specifically refers to alkyl in which one or more amino is substituted, as described below. When the term "alkyl" is used in one case, while a specific term such as "alkyl alcohol" is used in another, it does not imply that the term "alkyl" does not refer to a specific term such as "alkyl alcohol" at the same time.

The present practice is also used for the other groups described in the present invention. That is, when a term such as "cycloalkyl" refers to both unsubstituted and substituted cycloalkyl moieties, these substituted moiety may additionally be specifically determined in the present invention. For example, specific substituted cycloalkyl may be called, for example, "alkylcycloalkyl". Similarly, substituted alkoxyl may be specifically referred to, for example, "halogenated alkoxyl", and specific substituted alkenyl may be, for example, "enol". Similarly, the practice of using a general term such as "cycloalkyl" and a specific term such as "alkylcycloalkyl" is not intended to imply that the general term does not include that specific term at the same time.

The term "cycloalkyl" used in the present invention is a non-aromatic carbon-based ring composed of at least three carbon atoms. Examples of cycloalkyl include, but are not limited to, cyclopropyl, cyclobutyl, cyclopentyl, cyclohexyl, cyclononyl, and the like. The term "heterocycloalkyl" refers to a class of cycloalkyl defined above. In addition, in the meaning of the term "cycloalkyl", at least one cyclocarbon atom is substituted by a heteroatom such as, but not limited to, N, O, S, or P. This cycloalkyl and heterocycloalkyl may be substituted or unsubstituted. In this cycloalkyl and heterocycloalkyl, one or more groups may be substituted, including, but not limited to: alkyl, cycloalkyl, alkoxyl, amino, halogen, hydroxyl, nitro, silyl, sulfo-oxo or sulfydryl as described in the present invention.

The term "polyolefin group" used in the present invention refers to containing two or more CH₂ groups connected to other identical moieties. The "polyolefin group" may be expressed as -(CH₂)ₐ-, where "a" is an integer from 2 to 500.

The terms "alkoxyl" and "alkoxyl group" used in the present invention refer to alkyl or cycloalkyl bonded by an ether linking group. In other words, "alkoxyl" may be defined as - OR¹, where R¹ is alkyl or cycloalkyl as defined above. "Alkoxyl" also contains a polymer of alkoxyl just described. In other words, the alkoxyl may be a polyether such as -OR¹-OR² or - OR¹- (OR²)ₐ-OR³, where "a" is an integer from 1 to 200, and R¹, R² and R³ are each independently alkyl, cycloalkyl or a combination thereof.

The term "alkenyl" used in the present invention is hydrocarbyl of 2 to 24 carbon atoms and has a structural formula containing at least one C-C double bond. Asymmetric structures such as (R¹R²)C=C(R³R⁴) are intended to contain E and Z isomers. This may be presumed in the structural formula of the present invention in which asymmetric olefin exists or may be clearly indicated by a bond symbol C=C. In this alkenyl, one or more groups may be substituted, including, but not limited to: alkyl, cycloalkyl, alkoxyl, alkenyl, cycloalkenyl, alkynyl, cycloalkynyl, aryl, heteroaryl, formyl, amino, carboxyl, ester group, halogen, hydroxyl, carbonyl, azido, nitro, silyl, sulfo-oxo, or sulfydryl.

The term "cycloalkenyl" used in the present invention is a non-aromatic carbon-based ring that is composed of at least three carbon atoms and contains at least one carbon-carbon double bond, i.e., C=C. Examples of cycloalkenyl include, but are not limited to, cyclopropenyl, cyclobutenyl, cyclopentenyl, cyclopentadienyl, cyclohexenyl, cyclohexadienyl, norbornenyl, etc. The term "heterocycloalkenyl" refers to a class of cycloalkenyl as defined above. In addition, in the meaning of the term "cycloalkenyl", at least one carbon atom in this ring is substituted by a heteroatom such as, but not limited to, N, O, S, or P. This cycloalkenyl and heterocycloalkenyl may be substituted or unsubstituted. In this cycloalkenyl and heterocycloalkenyl, one or more groups may be substituted, including, but not limited to: alkyl, cycloalkyl, alkoxyl, alkenyl, cycloalkenyl, alkynyl, cycloalkynyl, aryl, heteroaryl, formyl, amino, carboxyl, ester group, halogen, hydroxyl, carbonyl, azido, nitro, silyl, sulfo-oxo, or sulfydryl as described in the present invention.

The term "alkynyl" used in the present invention is hydrocarbyl of 2 to 24 carbon atoms and has a structural formula containing at least one C-C triple bond. The alkenyl may be unsubstituted, or one or more groups in the alkenyl may be substituted, including, but not limited to: alkyl, cycloalkyl, alkoxyl, alkenyl, cycloalkenyl, alkynyl, cycloalkynyl, aryl, heteroaryl, formyl, amino, carboxyl, ester group, halogen, hydroxyl, carbonyl, azido, nitro, silyl, sulfo-oxo or sulfydryl as described in the present invention.

The term "cycloalkynyl" used in the present invention is a non-aromatic carbon-based ring that is composed of at least seven carbon atoms and contains at least one carbon-carbon triple bond. Examples of cycloalkynyl include, but are not limited to, cycloheptynyl, cyclooctynyl, cyclononynyl, and the like. The term "heterocycloalkynyl" refers to a class of cycloalkynyl as defined above. In addition, in the meaning of the term "cycloalkynyl", at least one carbon atom in this ring is substituted by a heteroatom such as, but not limited to, N, O, S or P. This cycloalkynyl and heterocycloalkynyl may be substituted or unsubstituted. In this cycloalkynyl and heterocycloalkynyl, one or more groups may be substituted, including, but not limited to: alkyl, cycloalkyl, alkoxyl, alkenyl, cycloalkenyl, alkynyl, cycloalkynyl, aryl, heteroaryl, formyl, amino, carboxyl, ester group, halogen, hydroxyl, carbonyl, azido, nitro, silyl, sulfo-oxo or sulfydryl as described in the present invention.

The term "aryl" used in the present invention is a group containing any carbon-based aromatic group, and the carbon-based aromatic group includes, but is not limited to, benzene, naphthalene, phenyl, biphenyl, phenoxybenzene, and the like. The term "aryl" also includes "heteroaryl", which is defined as a group containing an aromatic group that has at least one heteroatom within a ring into which the aromatic group is introduced. Examples of the heteroatoms include, but are not limited to, N, O, S, and P. Similarly, the term "non-heteroaryl" (which is also included in the term "aryl") defines a group containing an aromatic group that does not contain heteroatoms. This alkyl may be substituted or unsubstituted. In this aryl, one or more groups may be substituted, including, but not limited to: alkyl, cycloalkyl, alkoxyl, alkenyl, cycloalkenyl, alkynyl, cycloalkynyl, aryl, heteroaryl, formyl, amino, carboxyl, ester group, halogen, hydroxyl, carbonyl, azido, nitro, silyl, sulfo-oxo or sulfydryl as described in the present invention. The term "biaryl" is a specific type of aryl and is included in the definition of "aryl". Biaryl refers to two aryl bound together by a fused ring structure, as in naphthalene; or two aryl linked by one or more C-C bonds, as in biphenyl.

The term "aldehyde" used in the present invention is indicated by a formula -C(O)H. Throughout the specification, "C(O)" is an abbreviated form of carbonyl (i.e., C=O).

The term "amine" or "amino" used in the present invention is indicated by a formula - NR¹R², where R¹ and R² may be independently selected from hydrogen, alkyl, cycloalkyl, alkenyl, cycloalkenyl, alkynyl, cycloalkynyl, aryl or heteroaryl.

The term "alkylamino" used in the present invention is indicated by a formula -NH(-alkyl), where alkyl is as described in the present invention. Representative examples include, but are not limited to, methylamino, ethylamino, propylamino, isopropylamino, butylamino, isobutylamino, (sec-butyl)amino, (tert-butyl)amino, amylamino, isoamylamino, (tert-amyl)amino, hexylamino, and the like.

The term "dimethylamino" used in the present invention is indicated by a formula -N(-alkyl)₂, where alkyl is as described in the present invention. Representative examples include, but are not limited to, dimethylamino, diethylamino, dipropylamino, diisopropylamino, dibutylamino, diisobutylamino, di(sec-butyl)amino, di(tert-butyl)amino, diamylamino, diisoamylamino, di(tert-amyl)amino, dihexylamino, N-ethyl-N-methylamino, N-methyl-N-propylamino, N-ethyl-N-propylamino, and the like.

The term "carboxylic acid" used in the present invention is indicated by a formula - C(O)OH.

The term "ester" used in the present invention is indicated by a formula -OC(O)R¹ or -C(O)OR¹, where R¹ may be alkyl, cycloalkyl, alkenyl, cycloalkenyl, alkynyl, aryl or heteroaryl as described in the present invention. The term "polyester" used in the present invention is indicated by a formula -(R¹O(O)C-R²-C(O)O)ₐ- or -(R¹P(O)C-R²-OC(O))ₐ-, where R¹ and R² may be independently alkyl, cycloalkyl, alkenyl, cycloalkenyl, alkynyl, aryl, or heteroaryl as described in the present invention, and "a" is an integer from 1 to 500. The term "polyester" is used to describe a group which is generated by the reaction between a compound with at least two carboxyl and a compound with at least two hydroxyl.

The term "ether" used in the present invention is indicated by a formula R¹OR², where R¹ and R² may be independently alkyl, cycloalkyl, alkenyl, cycloalkenyl, alkynyl, cycloalkynyl, aryl or heteroaryl as described in the present invention. The term "polyether" used in the present invention is indicated by a formula -(R¹O-R²O)ₐ-, where R¹ and R² may be independently alkyl, cycloalkyl, alkenyl, cycloalkenyl, alkynyl, cycloalkynyl, aryl, or heteroaryl as described in the present invention, and "a" is an integer from 1 to 500. Examples of the polyether group include polyethylene oxide, polypropylene oxide, and polybutylene oxide.

The term "halogen" used in the present invention refers to halogen, fluorine, chlorine, bromine and iodine.

The term "heterocyclyl" used in the present invention refers to a monocyclic and polycyclic non-aromatic ring system of 3 to 30 carbon atoms, and the term "heteroaryl" used in the present invention refers to a monocyclic and polycyclic aromatic ring system: at least one of ring members is not carbon. This term includes azacyclobutyl, dioxanyl, furanyl, imidazolyl, isothiazolyl, isoxazolyl, morpholino, and oxazolyl; oxazolyl including 1,2,3-oxadiazolyl, 1,2,5-oxadiazolyl and 1,3,4-oxadiazolyl; piperazinyl, piperidinyl, pyrazinyl, pyrazolyl, pyridazinyl, pyridyl, pyrimidinyl, pyrrolyl, pyrrolidinyl, tetrahydrofuranyl, and tetrahydropyranyl; tetrazinyl including 1,2,4,5-tetrazinyl; tetrazolyl including 1,2,3,4-tetrazolyl and 1,2,4,5-tetrazolyl; thiadiazolyl including 1,2,3-thiadiazolyl, 1,2,5-thiadiazolyl and 1,3,4-thiadiazolyl; thiazolyl, and thiophenyl; triazinyl including 1,3,5-triazinyl and 1,2,4-triazinyl; triazolyl including 1,2,3-triazolyl and 1,3,4-triazol, etc.

The term "hydroxyl" used in the present invention is indicated by a formula -OH.

The term "ketone" used in the present invention is indicated by a formula R¹C(O)R², where R¹ and R² may be independently alkyl, cycloalkyl, alkenyl, cycloalkenyl, alkynyl, cycloalkynyl, aryl or heteroaryl as described in the present invention.

The term "azido" used in the present invention is indicated by a formula -N₃.

The term "nitro" used in the present invention is indicated by a formula -NO₂.

The term "nitrile" used in the present invention is indicated by a formula -CN.

The term "silyl" used in the present invention is indicated by a formula -SiR¹R²R³, where R¹, R² and R³ may be independently hydrogen, or alkyl, cycloalkyl, alkoxyl, alkenyl, cycloalkenyl, alkynyl, cycloalkynyl, aryl or heteroaryl as described in the present invention.

The term "sulfo-oxo group" used in the present invention is indicated by a formula - S(O)R¹, -S(O)²R¹, -OS(O)²R¹ or -OS(O)²OR¹, where R¹ may be hydrogen, or alkyl, cycloalkyl, alkenyl, cycloalkenyl, alkynyl, cycloalkynyl, aryl, or heteroaryl as described in the present invention. Throughout the specification, "S(O)" is an abbreviated form of S=O. The term "sulfonyl" used in the present invention is a sulfo-oxo group indicated by a formula -S(O)²R¹, where R¹ may be alkyl, cycloalkyl, alkenyl, cycloalkenyl, alkynyl, cycloalkynyl, aryl or heteroaryl. The term "sulfone" used in the present invention is indicated by a formula R¹S(O)₂R², where R¹ and R² may be independently alkyl, cycloalkyl, alkenyl, cycloalkenyl, alkynyl, cycloalkynyl, aryl or heteroaryl as described in the present invention. The term "sulfoxide" used in the present invention is indicated by a formula R¹S(O)R², where R¹ and R² may be independently alkyl, cycloalkyl, alkenyl, cycloalkenyl, alkynyl, cycloalkynyl, aryl or heteroaryl as described in the present invention.

The term "sulfydryl" used in the present invention is indicated by a formula -SH.

The "R¹", "R²", "R³", "Rⁿ" (where n is an integer) used in the present invention may each independently have one or more of the groups as listed above. For example, if R¹ is linear alkyl, one hydrogen atom of the alkyl may optionally be substituted with hydroxyl, alkoxyl, alkyl, halogen, and the like. Depending on selected groups, a first group may be bound within a second group or, optionally, the first group may be suspended (i.e., linked) to the second group. For example, for the phrase "amino-containing alkyl", amino may be bound within a backbone of alkyl. Optionally, amino may be linked to the backbone of alkyl. The nature of the selected groups will determine whether the first group is embedded or linked to the second group.

The compound of the present invention may contain an "optionally substituted" moiety. In general cases, the term "substituted" (whether or not the term "optional" exists previously) means that one or more hydrogens of the indicated moiety are substituted by suitable substituents. Unless otherwise specified, the "optionally substituted" group may have a suitable substituent at each substitutable position of the group, and the substituent at each position may be the same or different when more than one position in any given structure may be substituted with more than one substituent selected from a specified group. The combinations of substituents envisaged in the present invention are preferably those that form stable or chemically feasible compounds. In some respects, unless explicitly to the contrary noted, it is also encompassed that individual substituents may be further optionally substituted (i.e., further substituted or unsubstituted).

The term "fused ring" used in the present invention refers to the fact that two adjacent substituents may be fused into a six-membered aromatic ring and a heteroaromatic ring, such as a benzene ring, a pyridine ring, a pyrazine ring, a pyridazine ring, a meta-diazacyclic ring, etc., as well as a saturated six-membered or seven-membered carbon ring or a carbon heterocycle.

The compound has a structure as expressed by: 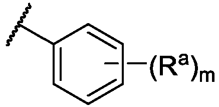
which is understood to be equivalent to the following formula: 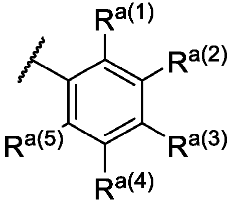
in which: n is usually an integer. That is, Rⁿ is understood to represent five individual substituents R^{a(1)}, R^{a(2)}, R^{a(3)}, R^{a(4)}, and R^{a(5)}. "Individual substituents" mean that each R substituent may be qualified independently. For example, if R^{a(m)} is halogen in a case, R^{a(n)} is not necessarily halogen in that case.

R¹, R², R³, R⁴, R⁵, R⁶, etc. are mentioned several times in the chemical structures and moieties disclosed and described in the present invention. Any description of R¹, R², R³, R⁴, R⁵, R⁶, etc., in the specification shall apply to referring any structure or moiety of R¹, R², R³, R⁴, R⁵, R⁶, etc., respectively, unless otherwise stated.

Optoelectronic devices using organic materials are becoming more and more urgent for a number of reasons. Many materials used to manufacture such devices are relatively inexpensive, so organic optoelectronic devices have the potential for cost advantages over inorganic devices. In addition, intrinsic properties of organic materials, such as their flexibility, may make them well-suited for special applications such as manufacture on flexible substrates. Examples of organic optoelectronic devices include organic light-emitting devices (OLEDs), organic phototransistors, organic photovoltaic cells, and organic photodetectors. For OLEDs, organic materials may have performance advantages over conventional materials. For example, a wavelength at which an organic light-emitting layer emits light may often be tuned with an appropriate dopant.

Excitons decay from a singlet excited state to a ground state to produce instant luminescence, i.e., fluorescence. If excitons decay from a triplet excited state to a ground state to produce luminescence, i.e., phosphorescence. Due to strong spin-orbit coupling of heavy metal atoms between singlet and triplet excited states, intersystem crossing (ISC) is effectively enhanced, so a phosphorescent metal complex (e.g., a platinum complex) has shown the potential to utilize both singlet and triplet excitons to achieve 100% internal quantum efficiency. Therefore, the phosphorescent metal complex is a good choice of a dopant in an emitting layer of an organic light-emitting device (OLED) and has received great attention in academia and industry. Over the past decade, many results have been achieved, leading to the lucrative application of this technology. For example, OLEDs have been used in advanced displays for smartphones, TVs, and digital cameras.

However, blue electroluminescent devices still fall within the most challenging area of this technology, and the stability of blue devices is a major issue. It has been proven that the choice of a host material is very important for the stability of blue devices. However, the minimum energy of a blue light-emitting material in a triple excited state (T1) is very high, which means that the minimum energy of a host material of the blue device in a triple excited state (T1) should be higher. This makes it more difficult to develop the host material of the blue devices.

The metal complex of the present invention may be customized or tuned to a specific application where specific emission or absorption characteristics are expected. The optical properties of the metal complex disclosed in the present invention can be adjusted by changing a structure of a ligand surrounding a metal center or by changing a structure of a fluorescent luminaire on the ligand. For example, metal complexes or electron-withdrawing substituents with ligands for electron-donating substituents can often exhibit different optical properties in emission and absorption spectra. The color of the metal complex can be adjusted by modifying conjugated groups on fluorescent luminaire and ligands.

The emission of the complex of the present invention can be regulated, for example, by changing the structures of the ligands or fluorescent luminaire, e.g. from ultraviolet to near-infrared. The fluorescent luminaire is a group of atoms in an organic molecule, which can absorb energy to produce a singlet excited state that rapidly decay to produce instant luminescence. In an aspect, the complex of the present invention may provide the emission of most of visible spectra. In a specific example, the complex of the present invention may emit light within a waveband range of visible or near-infrared light. In another aspect, the complex of the present invention has improved stability and efficiency compared with traditional emission complexes. In addition, the complex of the present invention may be used as a luminescent marker in emitters or combinations thereof, for example, in biological applications, anticancer agents, and organic light-emitting diodes (OLEDs). In another aspect, the complex of the present invention may be used in light-emitting devices, such as compact fluorescent lamps (CFLs), light-emitting diodes (LEDs), incandescent lamps and a combination thereof.

The present invention discloses a platinum-containing compound or composite complex. The term "compound" or "complex" is used interchangeably in the present invention. In addition, the compound disclosed by the present invention has neutral charges.

The compound disclosed by the present invention exhibits desired properties and has emission and/or absorption spectra that can be adjusted by selecting suitable ligands. In another aspect, the present invention may exclude any one or more compounds, structures or moieties thereof specifically described herein.

The compound disclosed herein is suitable for use in a wide variety of optical and electro-optical apparatuses, including but not limited to: light-absorbing apparatuses such as solar and photosensitive apparatuses, organic light-emitting diodes (OLEDs), light-emitting devices, or devices capable of being compatible with light absorption and emission, and used as markers for biological applications.

As mentioned above, the compound disclosed herein is a platinum complex. At the same time, the compound disclosed herein may be used as a host material for OLED applications, such as panchromatic displays.

The compound disclosed herein may be used in a variety of applications. As a light-emitting material, the compound may be used in organic light-emitting diodes (OLEDs), light-emitting apparatuses and displays, and other light-emitting devices.

In addition, compared with traditional materials, the compound in the present invention is used in light-emitting devices (e.g., OLEDs), which can improve the luminous efficiency and the operating time of the device.

The compound of the present invention may be prepared using a variety of methods, including but not limited to those described in the examples provided herein.

The compound disclosed herein may be a delayed fluorescence and/or phosphorescence emitter. In an aspect, the compound disclosed herein may be a delayed fluorescence emitter. In an aspect, the compound disclosed herein may be a phosphorescence emitter. In another aspect, the compound disclosed herein may be a delayed fluorescence emitter and/or a phosphorescence emitter.

The compound disclosed in the embodiment of the present invention is suitable for use in a wide variety of optical and electro-optical apparatuses, including but not limited to: light-absorbing devices such as solar and photosensitive devices, organic light-emitting diodes (OLEDs), light-emitting devices, or devices capable of being compatible with light absorption and emission, and used as markers for biological applications.

The compound provided by the embodiment of the present invention may be used in a light-emitting device such as an OLED. This device includes at least one cathode, at least one anode and at least one light-emitting layer, wherein at least one of the light-emitting layers contains the tetradentate cyclometalated complex based on phenylcarbazole. Specifically, the light-emitting device may include an anode, a hole transport layer, a light-emitting layer, an electron transport layer, and a cathode which are formed in sequence by deposition. The hole transport layer, the light-emitting layer, and the electron transport layer are all organic layers, and the anode and cathode are electrically connected.

### Synthetic examples

The following examples of compound synthesis, components, devices, or methods are intended to provide a general approach to the industry and are not intended to limit the protection scope this patent. The data (quantity, temperature, etc.) mentioned in this patent are as accurate as possible, but there may also be some errors. Unless otherwise specified, weighing is carried out separately, the temperature is °C or room temperature, and the pressure is close to normal pressure.

The following example provides a preparation method of a new compound, but the preparation of such compound is not limited to this method. In this technical field, because the compound protected in this patent is easy to modify and prepare, this compound may be prepared by the methods as listed below or by other methods. The following examples are exemplary only and are not intended to limit the protection scope of this patent. Temperatures, catalysts, concentrations, reactants and reaction processes can all be changed for different reactants, and different conditions can be selected to prepare the compound.

¹H NMR (500 MHz), ¹H NMR (400 MHz) and ¹³C NMR (126 MHz) spectra were measured on an ANANCE III (500 M) nuclear magnetic resonance spectrometer. Unless otherwise specified, DMSO-*d₆* or CDCl₃ containing 0.1% TMS was used as a solvent for NMR, wherein in the ¹H NMR spectra, TMS (δ = 0.00 ppm) was used as an internal standard when CDCl₃ was used as the solvent; and when DMSO-*d₆* was used as the solvent, TMS (δ = 0.00 ppm) or residual DMSO peak (δ = 2.50 ppm) or residual water peak (δ = 3.33 ppm) was used as an internal standard. In the ¹³C NMR spectrum, CDCl₃ (δ = 77.00 ppm) or DMSO-*d₆* (δ = 39.52 ppm) was used as an internal standard. HPLC-MS was measured in an Agilent 6210 TOF LC/MS mass spectrometer; and an HRMS spectrum was measured on an Agilent 6210 TOF LC/MS liquid chromatography-time-of-flight mass spectrometer. ¹H NMR spectrogram data: s = singlet, d = doublet, t = triplet, q = quartet, p = quintet, m = multiplet, br = broad.

### Synthesis route

### Example 1: platinum complex Pt1 may be synthesized according to the following route:

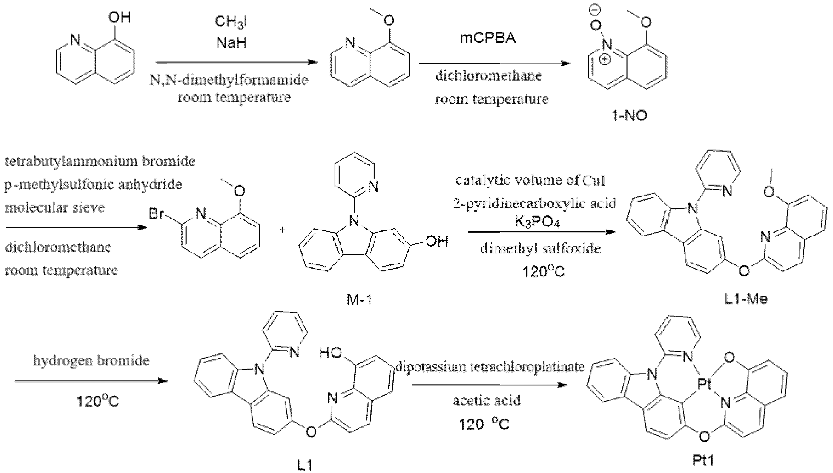

**Synthesis of intermediate 8-methoxyquinoline:** 8-hydroxyquinoline (5.00 g, 34.5 mmol, 1.00 equivalent) and N,N-dimethylformamide (40 mL) were added to a 100 mL three-mouth bottle with a magnetic rotor, then stirred in a low temperature bath, added slowly with sodium hydride (1.38 g, 34.5 mmol, 1.00 equivalent) with a mass fraction of 60% after the temperature was lowered, placed at room temperature, then added with methyl iodide (5.14 g, 36.3 mmol, 1.05 equivalent), and reacted for 8 h. A reaction mixture was quenched with ethanol and distilled at reduced temperature to remove a solvent, and then extracted three times with ethyl acetate; organic phases were merged, and dried with anhydrous sodium sulfate; the obtained crude product was separated and purified with an eluent (petroleum ether/acetone) = 2:1 by silica gel column chromatography, and distilled at reduced pressure to obtain 4.76 g of black-red solid with a yield of 87%. ¹H NMR (400 MHz, CDCl₃): *δ* 4.10 (s, 3H), 7.06 (d, *J* = 8.0 Hz, 1H), 7.38-7.49 (m, 3H), 8.13 (d, *J =* 8.0 Hz, 1H), 8.94 (dd, *J =* 3.6Hz, 0.8 Hz, 1H).

**Synthesis of intermediate 1-NO:** 8-methoxyquinoline (5.4 g, 34.2 mmol, 1.00 equivalent) and dichloromethane (170 mL) were added to a 500 mL three-mouth bottle with a magnetic rotor; the three-mouth bottle was fixed in a low-temperature reaction bath for cooling, and then added slowly with m-chloroperoxybenzoic acid (8.84 g, 51.3 mmol, 1.50 equivalent); and the three-mouth bottle was taken out and reacted at room temperature for 24 h. A reaction mixture was quenched with sodium thiosulfate, diluted with water, then extracted with dichloromethane for 4-5 times, and distilled at reduced pressure to remove a solvent, thereby obtaining 4.15 g of crude black-red solid with a yield of 69%. The product was used for next step directly.

**Synthesis of intermediates 2-bromo-8-methoxyquinoline:** an intermediate 1-NO (6.90 g, 39.4 mmol, 1.00 equivalent), n-butylammonium bromide (19.05 g, 59 mmol, 1.50 equivalent), a molecular sieve and 700 mL of dichloromethane were added to a 1000 mL three-mouth bottle with a magnetic rotor, stirred at room temperature for 10 min, added with p-toluenesulfonic anhydride (19.28 g, 59 mmol, 1.50 equivalent), and reacted at room temperature for 24 h. A reaction mixture was filtered; filter residues were washed with dichloromethane; a crude product obtained was separated and purified with an eluent (petroleum ether/ethyl acetate = 10:1) by silica gel column chromatography, and distilled at reduced pressure to remove a solvent, thereby obtaining 4.3 g of white solid with a yield of 46%. ¹H NMR (400 MHz, CDCl₃): *δ* 4.06 (s, 3H), 7.08 (d, *J =* 8.0 Hz, 1H), 7.37 (d, *J =* 8.0 Hz, 1H),7.47-7.51 (m, 1H), 7.55 (d, *J* = 8.8 Hz, 1H), 7.96 (d, *J* = 8.8 Hz, 1H).

**Synthesis of intermediate L1-Me:** 2-bromo-8-methoxyquinoline (480 mg, 2.02 mmol, 1.05 equivalent), M-1 (500 mg, 1.9 mmol, 1.00 equivalent), CuI (36.6 mg, 0.19 mmol, 0.1 equivalent), 2-pyridinecarboxylic acid (47.3 mg, 0.38 mmol, 0.2 equivalent), and K₃CO₄ (856 mg, 3.99 mmol, 2.1 equivalent) were added to a 50 mL three-mouth bottle with a magnetic rotor with a magnetic rotor, subjected to nitrogen replacement three times, then added with 15 mL of dimethyl sulfoxide by injection, heated to 120°C, and reacted for 48 h. A reaction mixture was quenched with water, diluted with ethyl acetate, extracted three times with ethyl acetate and dried with anhydrous sodium sulfate; the crude product obtained was separated and purified with an eluent (petroleum ether/dichloromethane/ethyl acetate 10: 2:1) by silica gel column chromatography, and distilled at reduced pressure to remove a solvent, thereby obtaining 630 mg of yellow solid with a yield of 78%. The product was used for reaction in the next step directly.

**Synthesis of intermediate L1:** L1-Me (610 mg, 1.46 mmol, 1.00 equivalent) and 5 mL of hydrogen bromide were added to a 50 mL three-mouth bottle with a magnetic rotor, heated to 120°C, and subjected to a reflux reaction. The reaction was performed for 12 h. The reaction mixture was diluted with ethyl acetate, added dropwise with a saturated sodium bicarbonate solution to neutralize PH to alkaline, and extracted three times with ethyl acetate; and organic phases were merged, dried with anhydrous sodium sulfate, and distilled at reduced pressure to remove a solvent. A crude product obtained was separated and purified with an eluent (petroleum ether/ethyl acetate = 10:1) by silica gel column chromatography, and distilled at reduced pressure to remove a solvent, thereby obtaining 315 mg of white foamy solid with a yield of 52%. ¹H NMR (400 MHz, CDCl₃): *δ* 7.10 (dd, *J* = 7.2, 2.0 Hz, 1H), 7.16 (d, *J* = 8.8 Hz, 1H), 7.20 (dd, *J* = 8.4, 2.0 Hz, 1H), 7.27-7.31 (m, 5H), 7.43-7.47 (m, 1H), 7.66 (d, *J =* 8.0 Hz, 1H), 7.81-7.83 (m, 2H), 7.92 (td, *J =* 8.0, 2.0 Hz, 1H), 8.12-8.14 (m, 2H), 8.15 (d, *J* = 2.0 Hz, 1H), 8.04 (dd, *J* = 4.8, 1.2 Hz, 1H) .

**Synthesis of Pt1:** L1 (250 mg, 0.62 mmol, 1.00 equivalent) and dipotassium tetrachloroplatinate (270 mg, 0.65 mmol, 1.05 equivalent) were added to a 50 mL three-mouth bottle with a magnetic rotor, subjected to nitrogen replacement three times, and added with acetic acid by injection, bubbled with nitrogen for 30 min, stirred at room temperature for 8 h, then heated 120°C, and reacted for 24 h. The reaction mixture was distilled at reduced temperature to remove acetic acid; the reaction mixture was then separated and purified with an eluent (dichloromethane/ethyl acetate = 30:1) by silica gel column chromatography, and distilled at reduced pressure to remove a solvent, thereby obtaining 330 mg of yellow solid with a yield of 89%. ¹H NMR (500 MHz, DMSO-*d*₆) *δ* 7.11 (dd, *J* = 7.5, 1.5 Hz, 2H), 7.39 (d, *J* = 8.5 Hz, 1H), 7.41-7.50 (m, 4H), 7.56 (ddd, *J* = 8.5, 7.0, 1.0 Hz, 1H), 8.05 (d, *J* = 8.5 Hz, 1H), 8.25 (d, *J* = *8.5* Hz, 1H), 8.27-8.32 (m, 2H), 8.40 (d, *J* = 8.0 Hz, 1H), 8.58 (d, *J =* 9.0 Hz, 1H), 10.14 (dd, *J* = 6.0, 1.5 Hz, 1H).

### Example 2: platinum complex Pt3 may be synthesized according to the following route:

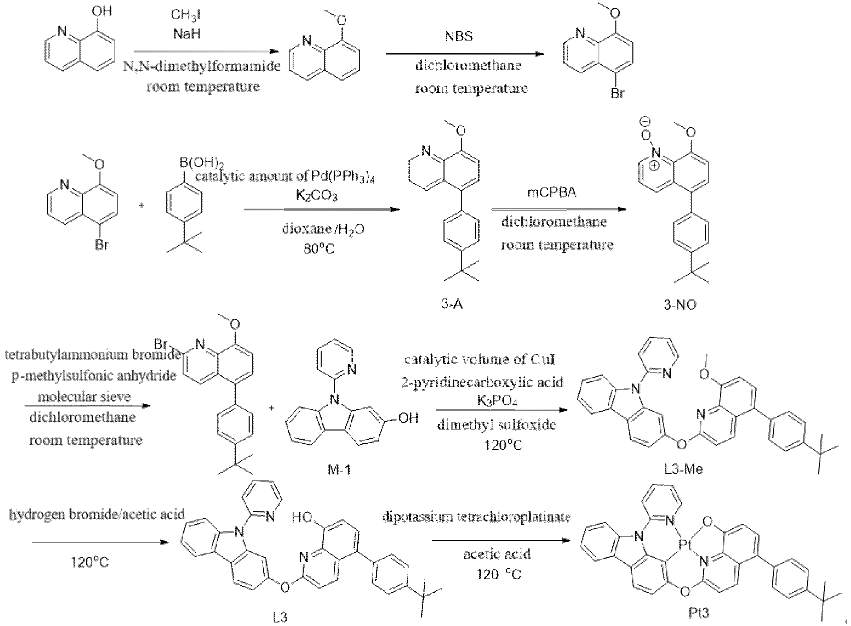

**Synthesis of 5-bromo-8-methoxyquinoline:** 8-methoxyquinoline (4.76 g, 29.9 mmol, 1.00 equivalent) and 230 mL of acetonitrile were added to a 500 mL three-mouth bottle with a magnetic rotor, then added slowly with N-bromosuccinimide (5.32 g, 31.3 mmol, 1.05 equivalent), and reacted for 8 h. The reaction mixture was quenched with an aqueous sodium sulfite solution, diluted with dichloromethane, and extracted three times with dichloromethane; and organic phases were merged and dried with anhydrous sodium sulfate. A crude product was then separated and purified with an eluent (dichloromethane/ethyl acetate = 10:1) by silica gel column chromatography, and distilled at reduced pressure to remove a solvent, thereby obtaining 5.8 g of faint yellow solid with a yield of 82%. The product was used for reaction in the next step directly.

**Synthesis of intermediate 3-A:** 5-bromo-8-methoxyquinoline (500 mg, 2.1 mmol, 1.00 equivalent), p-tert-butylphenylboronic acid (374 mg, 2.1 mmol, 1.00 equivalent), Pd(PPh₃)₄ (73 mg, 0.06 mmol, 0.03 equivalent), and K₂CO₃ (726 mg, 5.25 mmol, 2.5 equivalent) were added to a reaction tube with a magnetic rotor, subjected to nitrogen replacement three times, added with dioxane/H₂O = 8: 2 ml by injection, heated to 85°C, and reacted for 24 h. The reaction mixture was diluted with ethyl acetate, and extracted three times with ethyl acetate; organic phases were merged, and dried with anhydrous sodium sulfate; a crude product was separated and purified with an eluent (petroleum ether/ethyl acetate=3:2) by silica gel column chromatography, and distilled at reduced pressure to remove a solvent, thereby obtaining 580 mg of white solid with a yield of 94%. ¹H NMR (400 MHz, CDCl₃): *δ* 1.40 (s, 9H), 4.14 (s, 3H), 7.11 (d, *J* = 8.0 Hz 1H), 7.37-7.40 (m, 3H), 7.44 (d, *J* = 8.0 Hz, 1H), 7.49-7.52 (m, 2H), 8.28 (dd, *J* = 8.4, 1.6 Hz 1H), 8.94 (dd, *J* = 8.4 Hz, 2.0 Hz 1H).

**Synthesis of intermediate 3-NO:** 3-A (5.00 g, 17.2 mmol, 1.00 equivalent) and dichloromethane (100 mL) were added to a 500 mL three-mouth bottle with a magnetic rotor; the three-mouth bottle was fixed in a low-temperature reaction bath for cooling, and then added slowly with m-chloroperoxybenzoic acid (5.9 g, 34.4 mmol, 2.00 equivalent); and the three-mouth bottle was taken out and reacted at room temperature for 24 h. The reaction mixture was quenched with sodium thiosulfate, diluted with water, extracted with dichloromethane for 4-5 times, and distilled at reduced pressure to remove a solvent; a crude product obtained was separated and purified by silica gel column chromatography to obtain 2.1 g of black-red solid, which was then distilled at reduced pressure to remove a solvent. A yield was 40%. The product was used for next step directly.

**Synthesis of intermediate 3-Br:** an intermediate 3-NO (2.1 g, 7.2 mmol, 1.00 equivalent), n-butylammonium bromide (3.48 g, 10.81 mmol, 1.50 equivalent), a molecular sieve and dichloromethane (180 ml) were sequentially added to a 500 mL three-mouth bottle with a magnetic rotor, stirred at room temperature for 10 min, added with p-toluenesulfonic anhydride (3.53 g, 10.81 mmol, 1.50 equivalent), stirred overnight at room temperature, and reacted for 24 h. The reaction mixture was filtered; filter residues were washed with dichloromethane, and distilled at reduced pressure to remove a solvent; and a crude product obtained was separated and purified with an eluent (petroleum ether/ethyl acetate = 20:1) by silica gel column chromatography, and distilled at reduced pressure to remove a solvent, thereby obtaining 800 mg of faint yellow solid with a yield of 30%. ¹H NMR (400 MHz, CDCl₃): *δ* 1.40 (s, 9H), 4.10 (s, 3H), 7.13 (d, *J* = 8.0 Hz 1H), 7.33-7.35 (m, 2H), 7.44-7.52 (m, 4H), 8.10 (d, *J* = 8.8 Hz 1H).

**Synthesis of intermediate L3-Me:** 3-Br (200 mg, 0.54 mmol, 1.00 equivalent), M-1 (148 mg, 0.56 mmol, 1.05 equivalent), CuI (15 mg, 0.05 mmol, 0.1 equivalent), 2-pyridinecarboxylic acid (18 mg, 0.1 mmol, 0.2 equivalent), and K₃CO₄ (223 mg, 1.13 mmol, 2.1 equivalent) were added to a 50 mL three-mouth bottle with a magnetic rotor, subjected to nitrogen replacement three times, then added with 8 mL of dimethyl sulfoxide by injection, heated to 120°C, and reacted for 48 h. The reaction mixture was quenched with water, diluted with ethyl acetate, extracted three times with ethyl acetate and dried with anhydrous sodium sulfate; a crude product obtained was separated and purified with an eluent (petroleum ether/ethyl acetate=10:1) by silica gel column chromatography, and distilled at reduced pressure to remove a solvent, thereby obtaining 250 mg of white solid with a yield of 84%. ¹H NMR (500 MHz, CDCl₃): *δ* 1.38 (s, 9H), 4.00 (s, 3H), 6.98 (d, *J =* 9.0 Hz, 1H), 7.09 (d, *J* = 8.0 Hz, 1H), 7.20 (dd, *J* = 8.5, 2.0 Hz, 1H), 7.26-7.28 (m, 2H), 7.31-7.37 (m, 4H), 7.43 (ddd, *J* = 8.0, 7.5, 1.5 Hz, 1H), 7.47-7.50 (m, 2H), 7.71 (d, *J* = 8.0 Hz, 1H), 7.82 (d, *J* = 7.0 Hz, 1H), 7.87-7.90 (m, 2H), 8.09-8.11 (m, 2H), 8.22 (d, *J =* 9.0 Hz, 1H), 8.68 (ddd, *J* = 5.0, 2.0, 0.5 Hz, 1H) .

**Synthesis of intermediate L3:** L3-Me (250 mg, 0.45 mmol, 1.00 equivalent), 5 mL of hydrogen bromide and 120 mL of acetic acid were added to a 50 mL three-mouth bottle with a magnetic rotor, heated to 120°C, and subjected to a reflux reaction. The reaction was performed for 12 h. The reaction mixture was diluted with ethyl acetate, added dropwise with a saturated sodium bicarbonate solution to neutralize PH to alkaline, and extracted three times with ethyl acetate; and organic phases were merged, dried with anhydrous sodium sulfate, and distilled at reduced pressure to remove a solvent. A crude product obtained was separated and purified with an eluent (petroleum ether/ethyl acetate = 15:1) by silica gel column chromatography, and distilled at reduced pressure to remove a solvent, thereby obtaining 60 mg of white foamy solid A yield was 25%. ¹H NMR (500 MHz, CDCl₃): *δ* 1.40 (s, 9H), 7.11 (d, *J* = 9.5 Hz, 1H), 7.14 (d, *J* = 8.0 Hz, 1H), 7.21 (dd, *J* = 8.5, 2.0 Hz, 1H), 7.27-7.30 (m, 3H), 7.34-7.38 (m, 3H), 7.43-7.44 (m, 1H), 7.45-7.47 (m, 1H), 7.49-7.51 (m, 2H), 7.66 (d, *J* = 8.0, 1H), 7.82-7.84 (m, 2H), 7.92 (td, *J* = 8.0, 2.0 Hz, 1H), 8.14 (t, *J* = 16.0 Hz, 2H), 8.30 (d, *J* = 9.0 Hz, 1H), 8.71-8.72 (m, 1H) .

**Synthesis of Pt3:** L3 (60 mg, 0.11 mmol, 1.00 equivalent) and dipotassium tetrachloroplatinate (49 mg, 0.12 mmol, 1.05 equivalent) were added to a 50 mL three-mouth bottle with a magnetic rotor, subjected to nitrogen replacement three times, and added with acetic acid by injection, bubbled with nitrogen for 30 min, stirred at room temperature for 8 h, then heated 120°C, and reacted for 24 h. The reaction mixture was distilled at reduced pressure to remove acetic acid; the reaction mixture was then separated and purified with an eluent (dichloromethane/ethyl acetate = 10:1) by silica gel column chromatography, and distilled at reduced pressure to remove a solvent, thereby obtaining 70 mg of red solid with a yield of 86%. ¹H NMR (500 MHz, DMSO-*d*₆): *δ* 1.38 (s, 9H), 7.17 (d, *J* = 8.5 Hz, 1H), 7.41-7.46 (m, 6H), 7.50 (t, *J* = 15.0 Hz, 1H), 7.54-7.58 (m, 3H), 8.07 (d, *J* = 8.5, 1H), 8.26 (d, *J* = 8.5 Hz, 1H), 8.29-8.33 (m, 2H), 8.40 (d, *J* = 9.5 Hz, 1H), 8.46 (d, *J* = 9.5 Hz, 1H), 10.16-10.18 (m, 1H).

### Example 3: platinum complex Pt10 may be synthesized according to the following route:

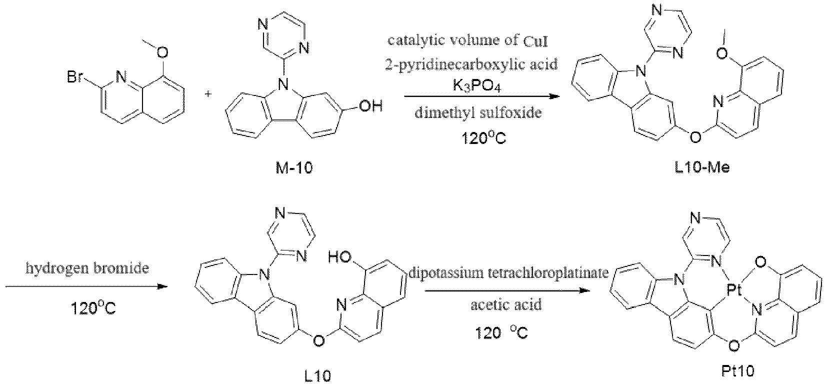

**Synthesis of intermediate L10-Me:** 2-bromo-8-methoxyquinoline (1.00 equivalent), M-10 (1.05 equivalent), CuI (0.1 equivalent), 2-pyridinecarboxylic acid (0.2 equivalent), and K₃CO₄ (2.1 equivalent) were added to a three-mouth bottle with a magnetic rotor, subjected to nitrogen replacement three times, then added with dimethyl sulfoxide by injection, heated to 120°C, and reacted for 48 h. The reaction mixture was quenched with water, diluted with ethyl acetate, extracted three times with ethyl acetate and dried with anhydrous sodium sulfate; the obtained crude product was separated and purified by silica gel column chromatography, and distilled at reduced pressure to remove a solvent, thereby obtaining a product L10-Me.

**Synthesis of intermediate L10:** L10-Me (1.00 equivalent) and a mixed system of hydrogen bromide and acetic acid were sequentially added to a three-mouth bottle with a magnetic rotor, heated to 120°C, and subjected to a reflux reaction. The reaction was performed for 12 h. The reaction mixture was diluted with ethyl acetate, added dropwise with a saturated sodium bicarbonate solution to neutralize PH to alkaline, and extracted three times with ethyl acetate; and organic phases were merged, dried with anhydrous sodium sulfate, and distilled at reduced pressure to remove a solvent. The crude product obtained was separated and purified by silica gel column chromatography to obtain a product L10.

**Synthesis of Pt10:** L10 (1.00 equivalent) and dipotassium tetrachloroplatinate (1.05 equivalent) were sequentially added to a three-mouth bottle with a magnetic rotor, subjected to nitrogen replacement three times, added with acetic acid by injection, bubbled with nitrogen for 30 min, stirred at room temperature for 8 h, then heated 120°C, and reacted for 24 h. The reaction mixture was distilled at reduced pressure to remove acetic acid; and the reaction mixture was then separated and purified by silica gel column chromatography, and distilled at reduced pressure to remove a solvent, thereby obtaining a solid product Pt10.

### Example 4: platinum complex Pt16 may be synthesized according to the following route:

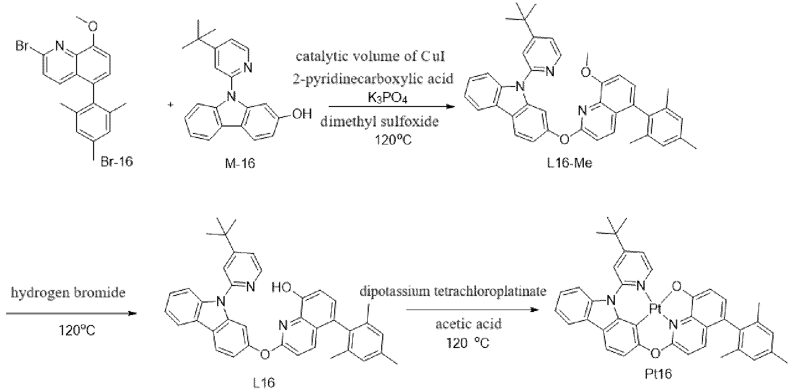

**Synthesis of intermediate L16-Me:** Br-16 (1.00 equivalent), M-16 (1.05 equivalent), CuI (0.1 equivalent), 2-pyridinecarboxylic acid (0.2 equivalent), and K₃CO₄ (2.1 equivalent) were sequentially added to a three-mouth bottle with a magnetic rotor, subjected to nitrogen replacement three times, then added with dimethyl sulfoxide by injection, heated to 120°C, and reacted for 48 h. The reaction mixture was quenched with water, diluted with ethyl acetate, extracted three times with ethyl acetate and dried with anhydrous sodium sulfate; and a crude product obtained was separated and purified by silica gel column chromatography, and distilled at reduced pressure to remove a solvent, thereby obtaining a product L16-Me.

**Synthesis of intermediate L16:** L16-Me (1.00 equivalent) and a mixed system of hydrogen bromide and acetic acid were sequentially added to a three-mouth bottle with a magnetic rotor, heated to 120°C, and subjected to a reflux reaction. The reaction was performed for 12 h. The reaction mixture was diluted with ethyl acetate, added dropwise with a saturated sodium bicarbonate solution to neutralize PH to alkaline, and extracted three times with ethyl acetate; and organic phases were merged, dried with anhydrous sodium sulfate, and distilled at reduced pressure to remove a solvent. The crude product obtained was separated and purified by silica gel column chromatography to obtain a product L16.

**Synthesis of Pt16:** L16 (1.00 equivalent) and dipotassium tetrachloroplatinate (1.05 equivalent) were sequentially added to a three-mouth bottle with a magnetic rotor, subjected to nitrogen replacement three times, added with acetic acid by injection, bubbled with nitrogen for 30 min, stirred at room temperature for 8 h, then heated 120°C, and reacted for 24 h. The reaction mixture was distilled at reduced pressure to remove acetic acid; and the reaction mixture was then separated and purified by silica gel column chromatography, and distilled at reduced pressure to remove a solvent, thereby obtaining a solid product Pt16.

### Example 5: platinum complex Pt5 may be synthesized according to the following route:

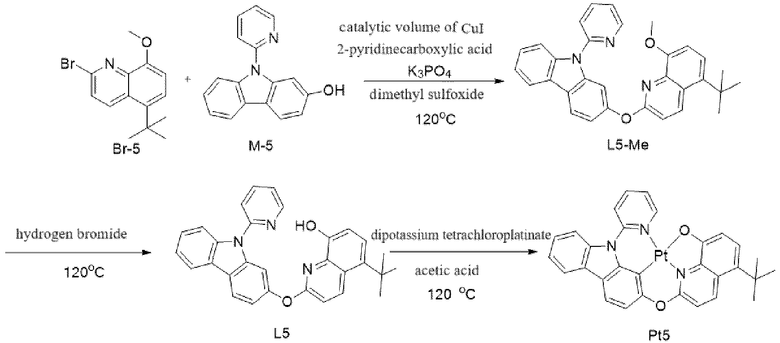

**Synthesis of intermediate L5-Me:** Br-5 (1.00 equivalent), M-5 (1.05 equivalent), CuI (0.1 equivalent), 2-pyridinecarboxylic acid (0.2 equivalent), and K₃CO₄ (2.1 equivalent) were sequentially added to a three-mouth bottle with a magnetic rotor, subjected to nitrogen replacement three times, then added with dimethyl sulfoxide by injection, heated to 120°C, and reacted for 48 h. The reaction mixture was quenched with water, diluted with ethyl acetate, extracted three times with ethyl acetate and dried with anhydrous sodium sulfate; and a crude product obtained was separated and purified by silica gel column chromatography, and distilled at reduced pressure to remove a solvent, thereby obtaining a product L5-Me.

**Synthesis of intermediate L5:** L5-Me (1.00 equivalent) and a mixed system of hydrogen bromide and acetic acid were sequentially added to a three-mouth bottle with a magnetic rotor, heated to 120°C, and subjected to a reflux reaction. The reaction was performed for 12 h. The reaction mixture was diluted with ethyl acetate, added dropwise with a saturated sodium bicarbonate solution to neutralize PH to alkaline, and extracted three times with ethyl acetate; and organic phases were merged, dried with anhydrous sodium sulfate, and distilled at reduced pressure to remove a solvent. The crude product obtained was separated and purified by silica gel column chromatography to obtain a product L5.

**Synthesis of Pt5:** L5 (1.00 equivalent) and dipotassium tetrachloroplatinate (1.05 equivalent) were sequentially added to a three-mouth bottle with a magnetic rotor, subjected to nitrogen replacement three times, added with acetic acid by injection, bubbled with nitrogen for 30 min, stirred at room temperature for 8 h, then heated 120°C, and reacted for 24 h. The reaction mixture was distilled at reduced pressure to remove acetic acid; and the reaction mixture was then separated and purified by silica gel column chromatography, and distilled at reduced pressure to remove a solvent, thereby obtaining a solid product Pt5.

### Example 6: platinum complex Pt17 may be synthesized according to the following route:

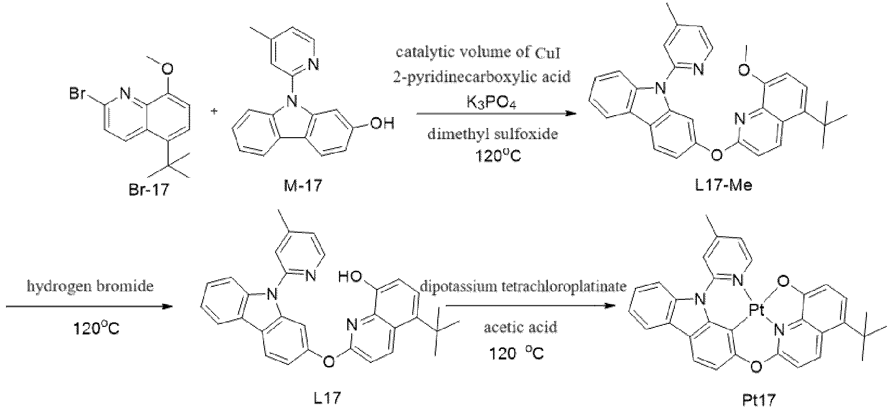

**Synthesis of intermediate L17-Me:** Br-17 (1.00 equivalent), M-5 (1.05 equivalent), CuI (0.1 equivalent), 2-pyridinecarboxylic acid (0.2 equivalent), and K₃CO₄ (2.1 equivalent) were sequentially added to a three-mouth bottle with a magnetic rotor, subjected to nitrogen replacement three times, then added with dimethyl sulfoxide by injection, heated to 120°C, and reacted for 48 h. The reaction mixture was quenched with water, diluted with ethyl acetate, extracted three times with ethyl acetate, and dried with anhydrous sodium sulfate; a crude product obtained was separated and purified by silica gel column chromatography, and distilled at reduced pressure to remove a solvent, thereby obtaining a product L17-Me.

**Synthesis of intermediate L17:** L17-Me (1.00 equivalent) and a mixed system of hydrogen bromide and acetic acid were sequentially added to a three-mouth bottle with a magnetic rotor, heated to 120°C, and subjected to a reflux reaction. The reaction was performed for 12 h. The reaction mixture was diluted with ethyl acetate, added dropwise with a saturated sodium bicarbonate solution to neutralize PH to alkaline, and extracted three times with ethyl acetate; and organic phases were merged, dried with anhydrous sodium sulfate, and distilled at reduced pressure to remove a solvent. The crude product obtained was separated and purified by silica gel column chromatography to obtain a product L17.

**Synthesis of Pt17:** L17 (1.00 equivalent) and dipotassium tetrachloroplatinate (1.05 equivalent) were sequentially added to a three-mouth bottle with a magnetic rotor, subjected to nitrogen replacement three times, added with acetic acid by injection, bubbled with nitrogen for 30 min, stirred at room temperature for 8 h, then heated 120°C, and reacted for 24 h. The reaction mixture was distilled at reduced pressure to remove acetic acid; and the reaction mixture was then separated and purified by silica gel column chromatography, and distilled at reduced pressure to remove a solvent, thereby obtaining a solid product Pt17.

### Explanation of photophysical tests and theoretical calculations

Steady-state emission test and lifetime measurement were performed on a Horiba Jobin Yvon FluoroLog-3 spectrometer. A Pt(II) complex was theoretically calculated using a Titan software package. The density functional theory (DFT) was used to optimize the geometry of ground-state (S₀) molecules. DFT calculation was performed using B3LYP functional, wherein a 6-31G(d) basis set was used for C, H, O, and N atoms, and a LANL2DZ basis set was used for a Pt atom.

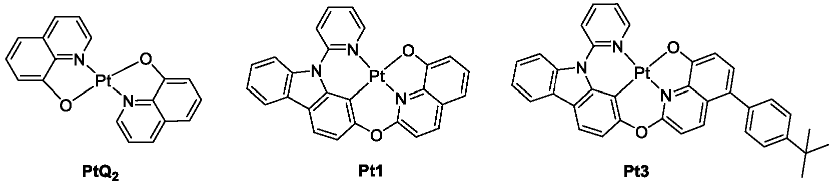

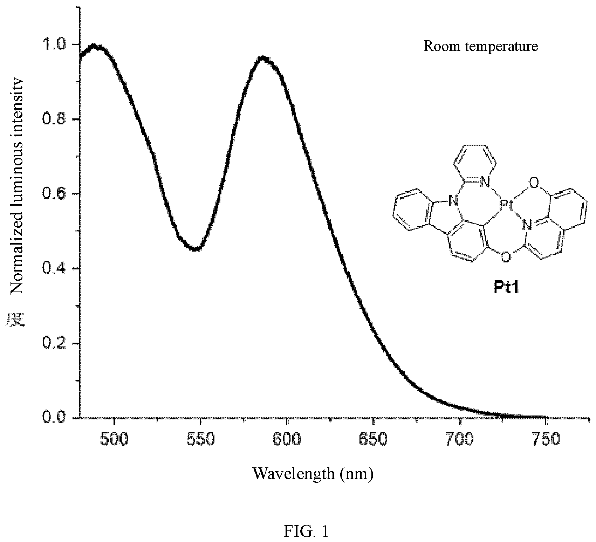

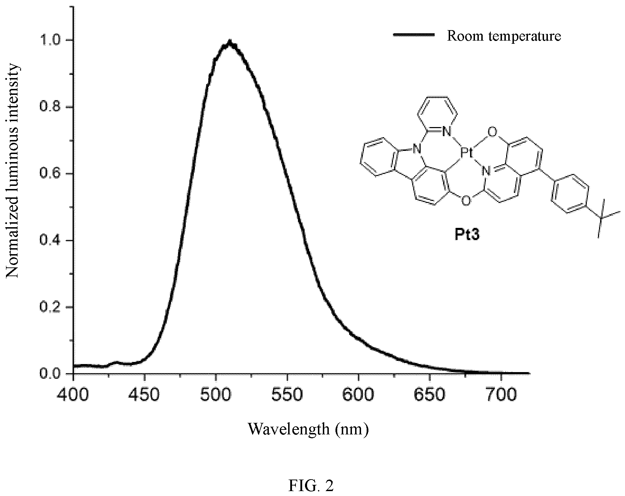

As can be seen from FIGS. 1 and 2, platinum complexes Pt1 and Pt3 can emit light intensively in a dichloromethane solution, with maximum emission wavelengths of 487 nm and 510 nm respectively, and the quantum efficiency of the solution being greater than 50%. However, the quantum efficiency of a comparative platinum complex PtQ₂ based on a bidentate ligand in the solution was only about 1.5% (I. Taydakov, K. Lyssenko, R. Saifutyarov, A. Akkuzina, R. Avetisov, A. Mozhevitina, I. Avetissov. Dyes and Pigments, 2016, 135, 80-85). It can be seen that the quantum efficiency of the platinum complex based on the tetradentate ligand in the present application can be greatly improved compared with the platinum complex based on the bidentate ligand.

**Table 1: Frontier orbital energy levels for some metal complexes**

| Metal complex | HOMO/eV | LUMO/eV | Gap/eV |
|---|---|---|---|
| Pt1 | -4.85 | -1.57 | 3.28 |
| Pt2 | -4.81 | -1.47 | 3.34 |
| Pt3 | -4.76 | -1.58 | 3.18 |
| Pt4 | -4.83 | -1.58 | 3.25 |
| Pt5 | -4.77 | -1.55 | 3.22 |
| Pt6 | -5.22 | -1.77 | 3.45 |
| Pt7 | -4.73 | -1.61 | 3.45 |
| Pt8 | -4.88 | -1.74 | 3.14 |
| Pt9 | -4.99 | -2.06 | 2.93 |
| Pt10 | -5.00 | -2.12 | 2.88 |
| Pt11 | -5.04 | -1.93 | 3.11 |
| Pt12 | -5.02 | -1.71 | 3.31 |
| Pt13 | -4.63 | -1.36 | 3.27 |
| Pt14 | -4.77 | -1.53 | 3.24 |
| Pt15 | -4.68 | -1.51 | 3.17 |
| Pt16 | -4.73 | -1.47 | 3.26 |
| Pt17 | -4.58 | -1.51 | 3.07 |
| Pt18 | -4.30 | -1.54 | 2.76 |
| Pt19 | -4.68 | -1.51 | 3.17 |
| Pt20 | -3.59 | -1.41 | 2.18 |
| Pt21 | -4.89 | -1.67 | 3.22 |
| Pt22 | -4.69 | -1.88 | 2.81 |
| Pt23 | -4.77 | -1.55 | 3.22 |
| Pt24 | -4.68 | -2.38 | 2.30 |
| Pt25 | -4.79 | -1.44 | 3.35 |
| Pt26 | -4.74 | -1.55 | 3.19 |
| Pt27 | -4.82 | -1.46 | 3.36 |
| Pt28 | -5.06 | -2.38 | 2.68 |
| Pd1 | -4.83 | -1.52 | 3.31 |
| Pd2 | -4.87 | -1.57 | 3.30 |
| Pd3 | -4.70 | -1.52 | 3.18 |
| Pd4 | -4.74 | -1.57 | 3.17 |
| Pd5 | -4.76 | -1.37 | 3.39 |
| Pd6 | -4.68 | -1.52 | 3.16 |
| Pd7 | -4.62 | -1.44 | 2.82 |
| Pd8 | -4.95 | -2.03 | 2.92 |

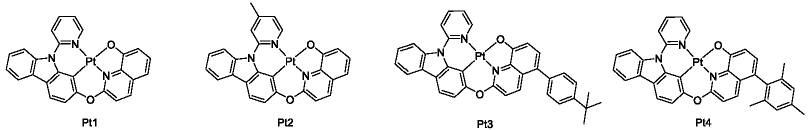

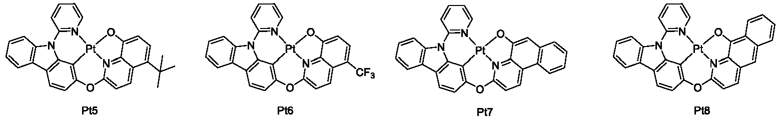

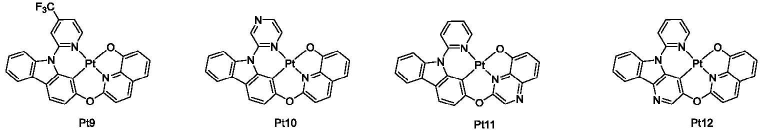

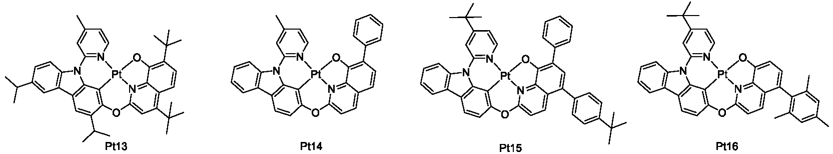

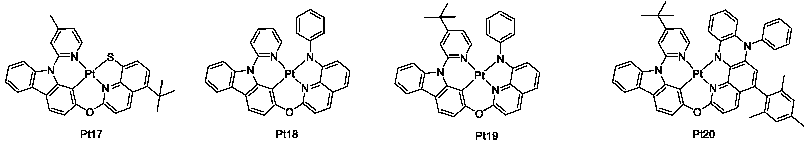

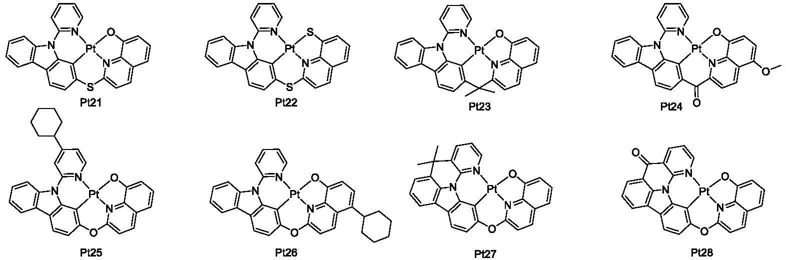

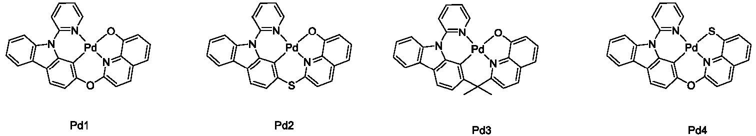

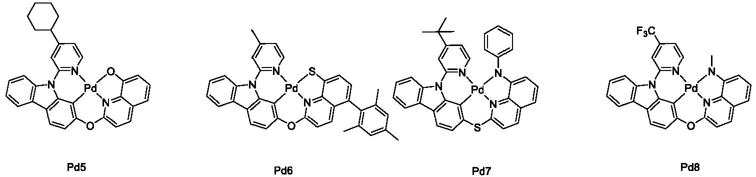

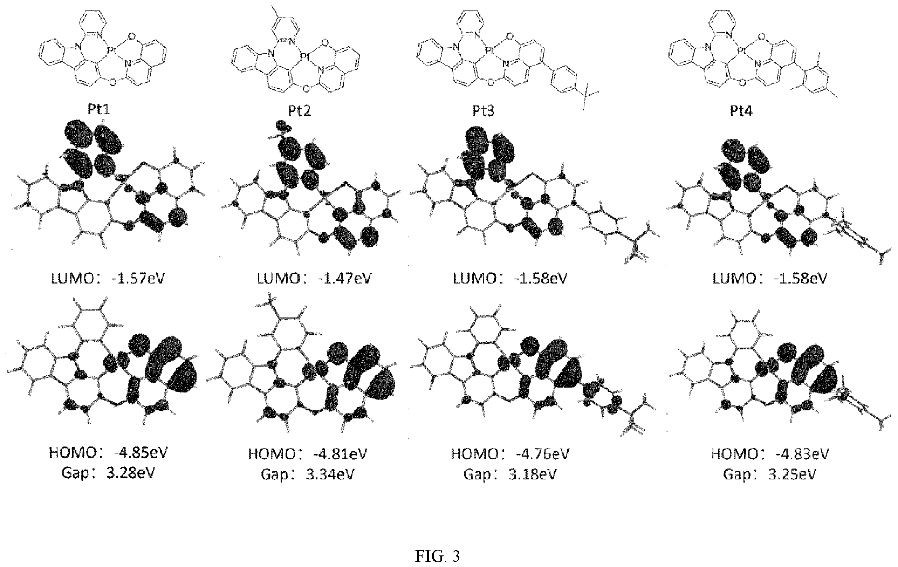

As can be seen from FIG. 3, compared with Pt1, Pt2 introduced methyl on pyridine, had little effects on the highest occupied molecular orbital (HOMO) and the lowest unoccupied molecular orbital (LUMO), as well as little change in △E, but could increase the molecular stability. Compared with Pt1, Pt3 introduced p-tert-butylphenyl in a quinoline moiety, made HOMO distribution delocalized obviously, had little effect on the distribution of LUMO, as well as reduced △E and blue-shifted emission spectrum. At the same time, the introduction of p-tert-butylbenzene could effectively inhibit π-π accumulation between molecules, which was conducive to sublimation and purification. Compared with Pt1, Pt4 introduced trimethylphenyl in a quinoline moiety, and had little effects on HOMO and LUMO, as well as little change in △E, so it was expected that a spectrum would not change much. It might be because a dihedral angle was larger, interrupting its conjugated system.

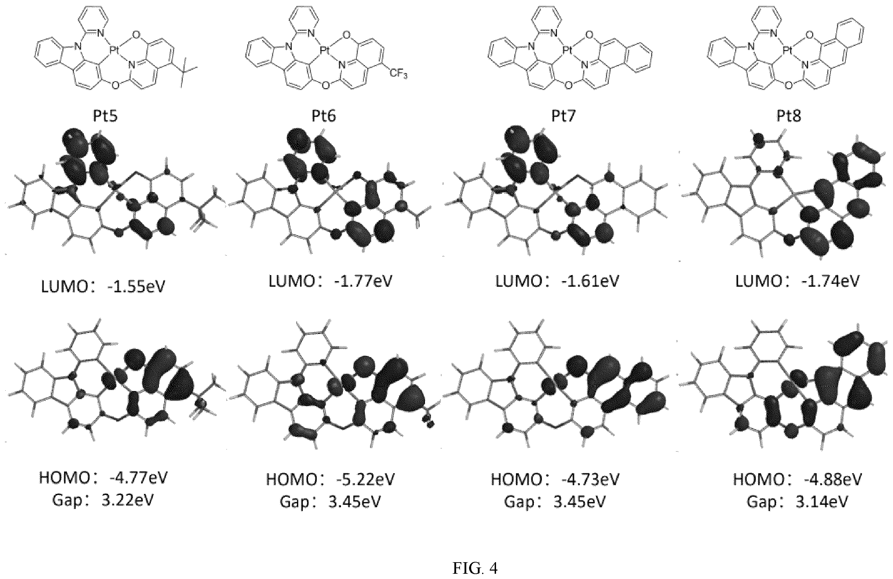

As can be seen from FIG. 4, compared with Pt1, Pt5 introduced tert-butyl in a quinoline moiety, and but the introduction of an electron-donating group had little effect on LUMO. Therefore, it can be seen that the introduction of an electron-withdrawing group in the quinoline moiety had little effect on the distribution of molecular electron clouds, and the intermolecular π-π accumulation could also be inhibited by introducing the electron-donating group (i.e., tert-butyl) with a large steric hindrance to this this region. Compared with Pt1, Pt6 had significantly reduced LUMO as observed obviously. Because LUMO was mainly distributed in a quinoline moiety, the introduction of an electron-withdrawing group (trifluoromethyl) in a quinoline moiety could significantly reduce the LUMO distribution, so the electron-withdrawing group could be used at this position to efficiently regulate its LUMO, and then the photophysical properties of molecules could be regulated. Compared with Pt1, Pt7 introduced phenyl on the right side of quinoline to increase a conjugated system, so it was obvious that part of its HOMO was delocalized on the phenyl, with an increase in △E, so it was expected that an emission spectrum was blue-shifted. Compared with Pt1, Pt8 in which acridinyl and quinolyl were connected by phenyl made HOMO mainly distributed in a quinoline moiety, and LUMO delocalized to a phenylbenzoquinoline moiety, with a decrease in △E, such that an emission spectrum was red-shifted.

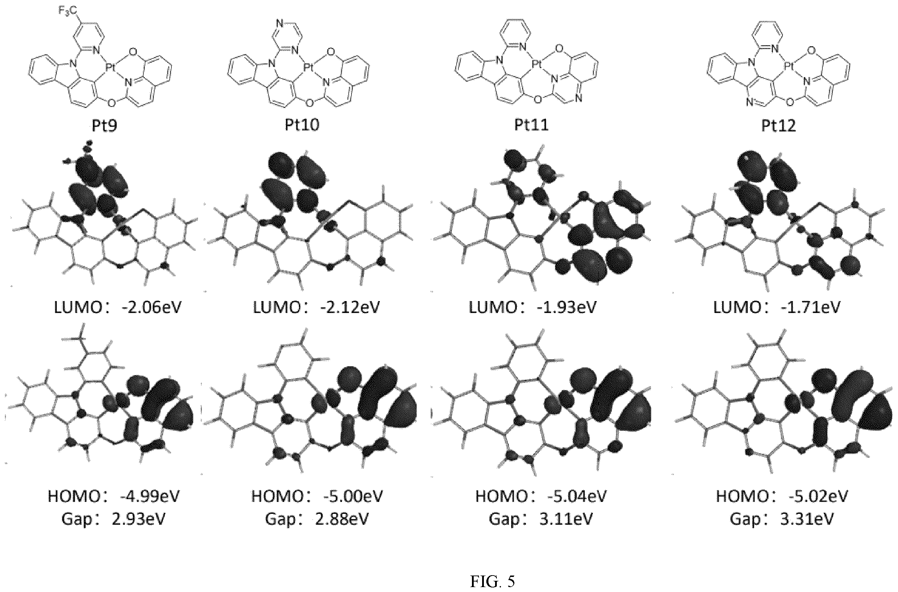

As can be seen from FIG. 5, compared with Pt1, Pt9 introduced an electron-withdrawing group (trifluoromethyl) on pyridine since its LUMO moieties were partially distributed on a pyridine ring, and made LUMO distribution delocalized in a direction of the pyridine ring, so that the LUMO was mainly distributed in the pyridine moiety, which significantly reduced the LUMO and had little effect on the distribution of HOMO, with a decrease in △E, so it was expected that an emission spectrum was red-shifted. Compared with Pt1, Pt10 could be observed that its LUMO was partially delocalized to a pyridine moiety similar to Pt9 since nitrogen atoms were similar to trifluoromethyl, both of which were electron-withdrawing groups, with a decrease in △E, so it was expected that an emission spectrum was red-shifted. Compared with Pt1, Pt11 introduced nitrogen atoms into a quinoline moiety, and could be observed that its LUMO was delocalized to the quinoline moiety, with a decrease in LUMO, so it was expected that an emission spectrum was red-shifted. Pt12 introduced nitrogen atoms into a carbazole group, and could be observed that there was no significant change in HOMO and LUMO energy levels, so it was inferred that the carbazole moiety contributed little to HOMO and LUMO.

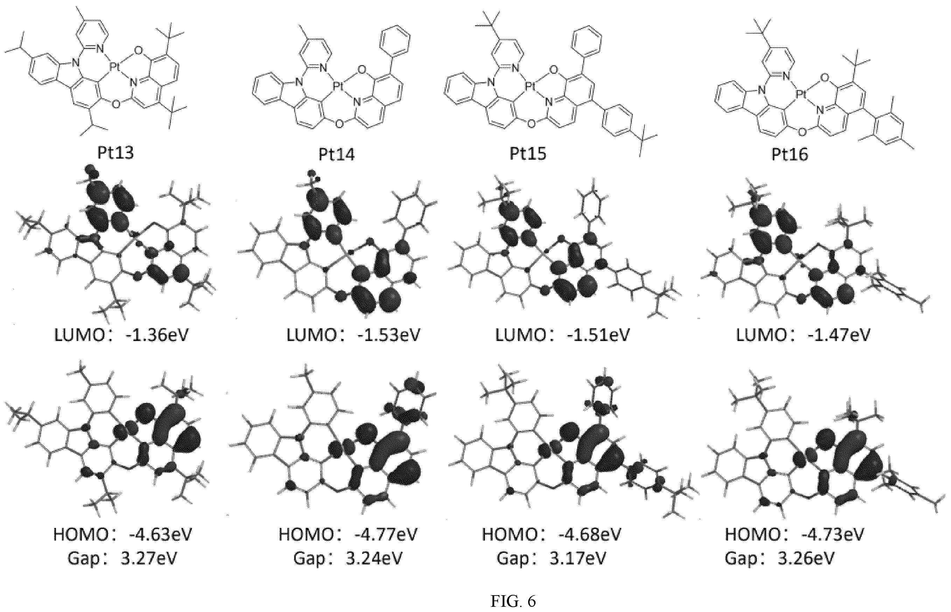

As can be seen from FIG. 6, compared with Pt1, Pt13 increased LUMO and HOMO energy levels without changing an energy band, and could match more suitable host materials in a device, and meanwhile, the exciton utilization efficiency could be improved by a large number of large steric hindrance substituents, i.e., isopropyl and tert-butyl. Compared with Pt2, Pt14 increased a conjugated system due to the introduction of phenyl, and made its HOMO be delocalized, so △E did not change much. Compared with Pt3, Pt15 introduced phenyl in a quinoline moiety and tert-butyl in a pyridine moiety, and could be observed that except for a certain conjugated delocalization effect of phenyl on HOMO, had little effects on the distribution of HOMO and HOMO, so the introduction of tert-butyl into a pyridine ring could effectively increase its steric hindrance, and had less effect on the density of electron cloud distribution, thereby improving its exciton utilization efficiency. However, the introduction of a conjugated system in a quinoline region could enhance the molecular rigidity and had little effect on the electron cloud distribution. Compared with Pt4, Pt16 introduced tert-butyl in a quinoline moiety and a pyridine moiety respectively, wherein the tert-butyl on the pyridine ring had little effect on the density of electron cloud distribution, and increased the steric hindrance, which was conducive to improving the exciton utilization efficiency. By observing the electron cloud density distribution, the tert-butyl on the quinoline side had little effect on its distribution, so the spectral properties did not change much, and the structures of two tert-butyl could inhibit the π-π accumulation between molecules, which was more conducive to improving the exciton utilization efficiency.

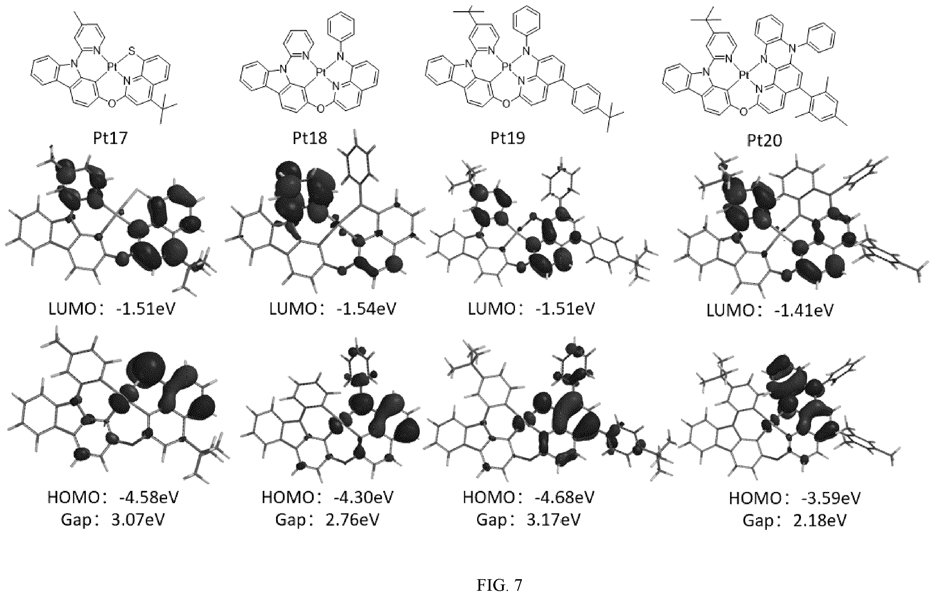

In FIG. 7, Pt17 could be observed that the introduction of methyl on the pyridine ring had little effect on the electron cloud distribution, and a coordinated oxygen atom was substituted by a sulfur atom. Due to stronger electron-absorbing ability of the sulfur atom, HOMO was delocalized to the sulfur atom, with a decrease in △E, so it was expected that an emission spectrum was red-shifted . Pt18 may be replaced by aniline. Due to its large dihedral angle of a conjugate plane with a quinoline plane, a conjugated system was broken, and the molecular rigidity could be enhanced, so the electron-donating ability could significantly improve HOMO, so it was expected that an emission spectrum was red-shifted. Large steric hindrance groups introduced by Pt19 and Pt20 had little effect on the electron cloud distribution due to their large dihedral angles with the quinoline plane, but their steric hindrances could inhibit the intermolecular π-π accumulation.

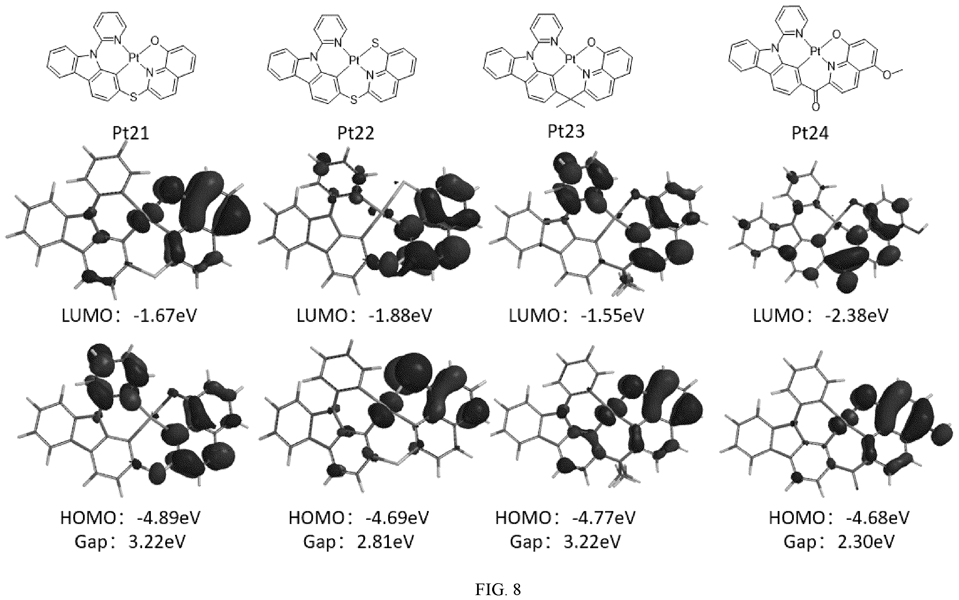

In FIG. 8, the electron cloud distribution of different bridging groups was calculated. It can be seen from Pt21 that replacing an oxygen atom linking group with a sulfur atom did not greatly change the electron cloud distribution, while the coordinated sulfur atom can greatly increase the HOMO, with a decrease in ΔE, such that an emission spectrum was red-shifted. After replacing with carbonyl, it can be observed that LUMO was greatly reduced and is delocalized to a carbazopyridine ring, which may be due to a strong electron-withdrawing effect of the carbonyl, with a decrease in ΔE, so it was expected that an emission spectrum was red-shifted.

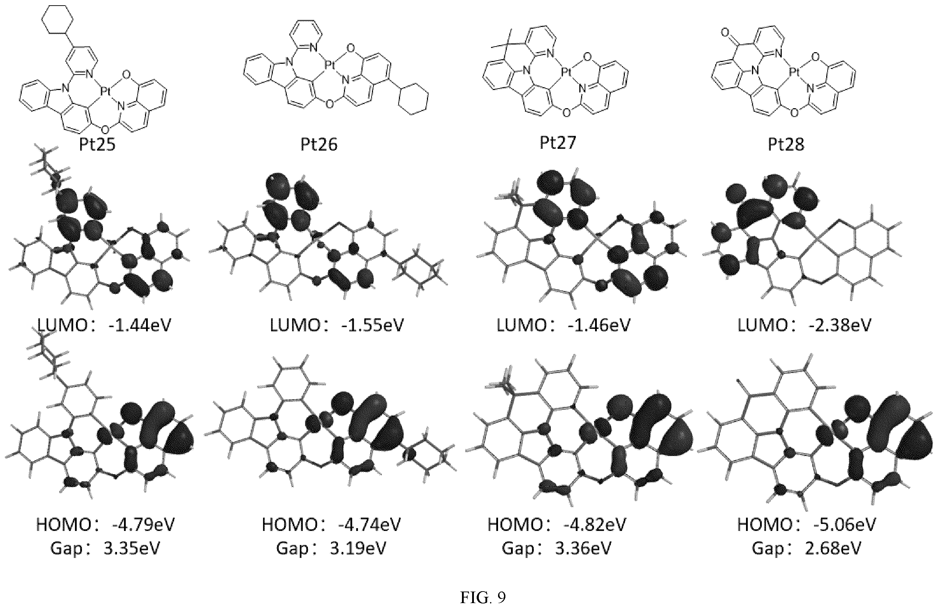

In FIG. 9, Pt25 and Pt26 introduced cyclohexyl at different positions, respectively, which had little effect on the electron cloud distribution due to their large dihedral angles with a quinoline plane, but could increase the molecular stability and inhibited the intermolecular π-π accumulation. In Pt28, due to a strong electron-withdrawing effect of the carbonyl, LUMO was significantly delocalized to the carbonyl, which was not conducive to the intramolecular transfer of charges.

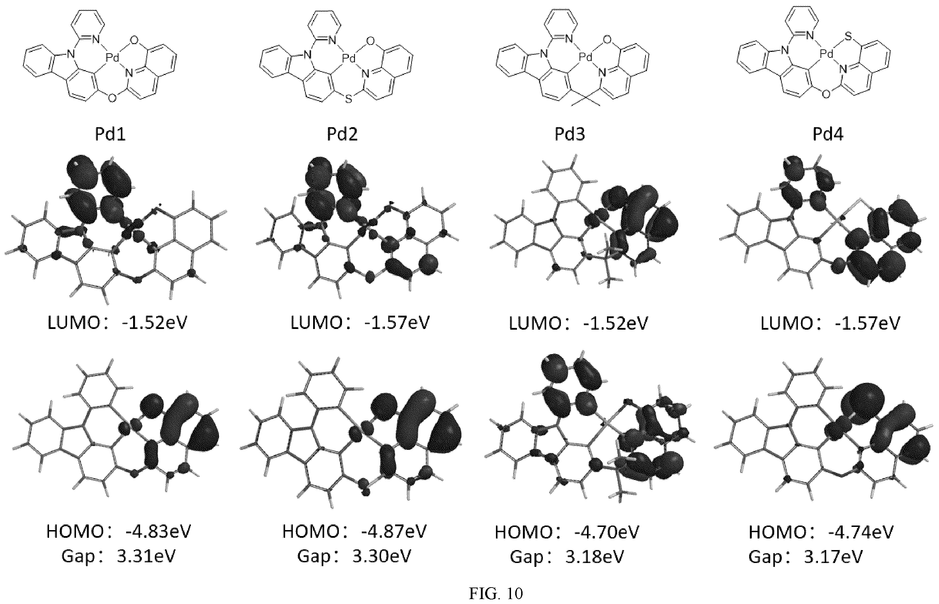

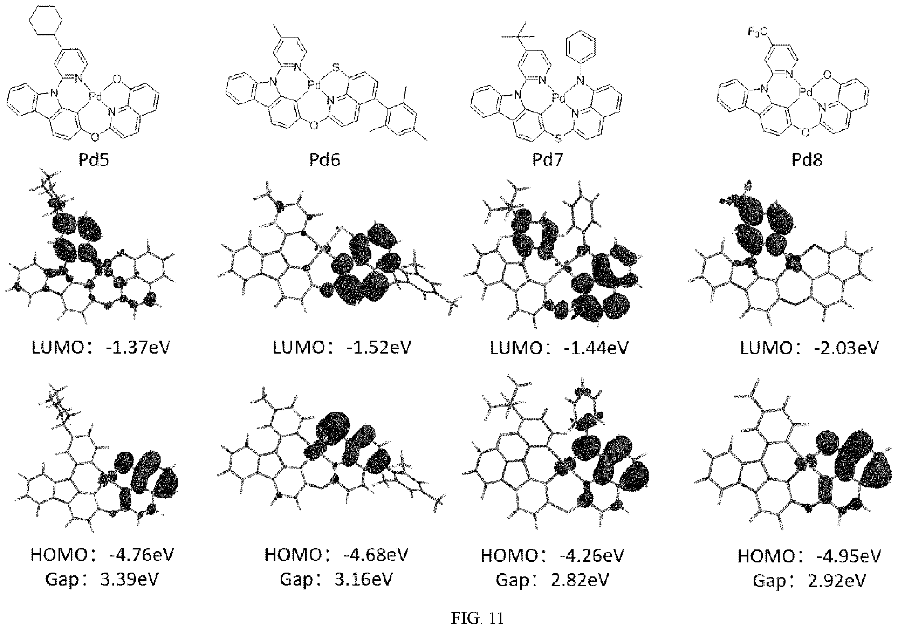

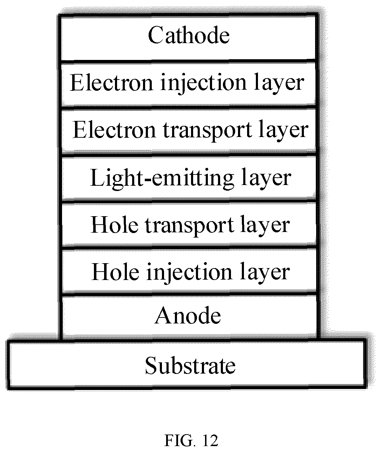

In FIGS. 10 and 11, a coordinated platinum atom was substituted by a palladium atom, and in general, a palladium atom-coordinated tetradentate metal complex had less ΔE compared with a platinum atom-coordinated tetradentate metal complex, so that an emission spectrum of the complex could be blue-shifted, and a luminescence color could be adjusted by changing a central metal atom thereof.

In summary, the introduction of a strong electron-withdrawing structure in an oxygen para-position of the quinoline ring could significantly reduce its LUMO energy level. The introduction of a strong electron-withdrawing structure into the pyridine ring could reduce its LUMO energy level. The introduction of p-tert-butylphenyl or trimethylphenyl in the oxygen para-position in the quinoline ring could inhibit the π-π accumulation of molecules under the condition that it had little effects on HOMO and LUMO, which was conducive to the sublimation and purification of metal complexes of materials. Meanwhile, the appropriate addition of the conjugated structure in the quinoline ring could enhance its molecular rigidity and extend the conjugated system, thereby adjusting its photophysical properties.

The oxygen-bridged metal platinum (II) and palladium (II) complex containing the quinoline structural unit in the present invention may be used as a light-emitting layer for an organic electroluminescent device. In an organic light-emitting element, a carrier was injected into a light-emitting material from positive and negative electrodes to produce an excited light-emitting material and make it emit light. The compound of the present invention represented by general formula (1) could be used as a luminescent material in organic light-emitting elements such as organic photoluminescent elements or organic electroluminescent elements. The organic photoluminescent element had a structure that formed at least a light-emitting layer on a substrate. In addition, the organic electroluminescent element had a structure that formed at least an anode, a cathode, and an organic layer between the anode and the cathode. The organic layer included at least a light-emitting layer and might be composed of the light-emitting layers only, or of more than one organic layer in addition to the light-emitting layer. As such other organic layers, a hole transport layer, a hole injection layer, an electron barrier layer, a hole barrier layer, an electron injection layer, an electron transport layer, an exciton barrier layer, etc. might be enumerated. The hole transport layer might also be a hole injection transport layer with a hole injection function, and the electron transport layer might also be an electron injection transport layer with an electron injection function. A schematic structural diagram of a specific organic light-emitting element was shown in FIG. 7. In FIG. 7, a total of seven layers from bottom to top represented a substrate, an anode, a hole injection layer, a hole transport layer, a light-emitting layer, an electron transport layer and a cathode in sequence, wherein the light-emitting layer was a hybrid layer in which a guest material was doped into a host material.

Each layer of the organic light-emitting device of the present invention might be formed by methods such as vacuum evaporation, sputtering and ion plating, or wet film formation such as spin coating, printing, impression and other methods. There was no special restriction on a solvent used.

The electron transport layer can be jointly formed by an organic material and one or more n-type dopants such as LiQ. The compound represented in Example 1 applied to an OLED device as a circularly polarized light-emitting material was structurally expressed as follows: on ITO-containing glass, the hole injection layer (HIL) was HT-1:P-3 (95:5 v/v%) with a thickness of 10 nm; the hole transport layer (HTL) was HT-1 with a thickness of 90 nm; the electron barrier layer (EBL) was HT-10 with a thickness is 10 nm; the light-emitting layer (EML) is was a host material (H-1 or H-2 or H-3 or H-4): the platinum metal complex (95:5 v/v%) of the present invention has a thickness of 35 nm, the electron transport layer (ETL) was ET-13:LiQ (50:50 v/v%) with a thickness of 35 nm, and then an evaporation cathode Al was 70 nm.

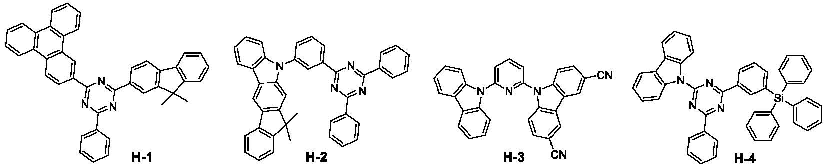

**Table 3**

| Device | Platinum metal complex in the light-emitting layer | Voltage (V) (Relative value, %) | Efficiency (cd/A) (Relative value, %) | LT₉₅(hr) (Relative value, %) |
|---|---|---|---|---|
| Device 1 | Pt-1 | 84 | 243 | 274 |
| Device 2 | Pt-3 | 85 | 286 | 306 |
| Device 3 | Pt-10 | 85 | 283 | 285 |
| Device 4 | Pt-16 | 83 | 274 | 324 |
| Device 5 | Pt-5 | 84 | 287 | 289 |
| Device 6 | Pt-17 | 83 | 256 | 283 |
| Comparative device | PtQ2 | 100 | 100 | 100 |

As can be seen from Table 3, the device structures in the above examples and comparative example were consistent except for the difference in the light-emitting layer. With the performances of PtQ2-based devices as a reference, a device containing a divalent platinum metal complex of the present invention had significantly improved the current efficiency and significantly prolonged the lifetime compared with conventional organic light-emitting devices. In summary, the novel divalent platinum metal complex in the present invention had great application values in organic optoelectronic devices.

It should be noted that the structure was an example of an application of a circularly polarized light-emitting material of the present invention, and did not constitute the limitation of the specific OLED device structure shown in the present invention, and the light-emitting material was also not limited to the compound represented in the example.

A person of ordinary skill in the art may understand that each of the above embodiments is a specific example of the present invention, and in practical applications, various changes may be made to the present invention in form and detail without deviating from the spirit and scope of the present invention. For example, without departing from the spirit of the present invention, many of the substituent structures described herein may be replaced by other structures.

## Claims

1. A metal platinum (II) and palladium (II) complex containing a quinoline structural unit and a bridging structure, wherein the metal platinum (II) and palladium (II) complex containing the quinoline structural unit has a structure as shown in general formula (I): 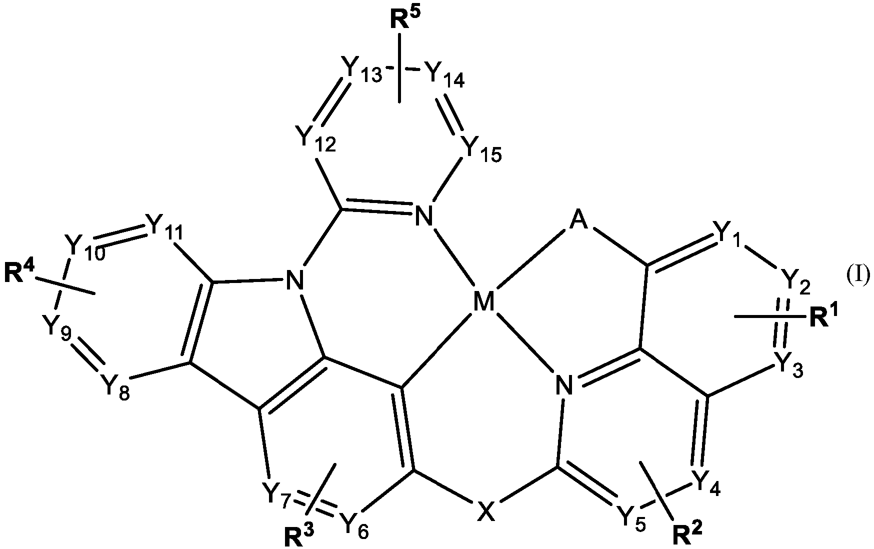 in which:
M is Pt or Pd;
X is O, S, CH₂, CHD, CD₂, CR⁷R⁸, C=O, SiR⁹R¹⁰, NR¹¹, PH, PD, PR¹², R¹³P=O, S=O or SO₂;
A is O, S or NR⁶;
Y¹, Y², Y³, Y⁴, Y⁵, Y⁶, Y⁷, Y⁸, Y⁹, Y¹⁰, Y¹¹, Y¹², Y¹³, Y¹⁴ and Y¹⁵ are each independently N or CH; and
substitution modes of R¹, R², R³, R⁴ and R⁵ are each independently expressed as single substitution, double substitution, triple substitution, quadruple substitution or no substitution; R¹, R², R³, R⁴ and R⁵ are each independently expressed as hydrogen, deuterium, alkyl, haloalkyl, cycloalkyl, alkoxyl, aryl, heteroaryl, aryloxyl, halogen, cycloalkenyl, heterocyclyl, alkenyl, alkynyl, hydroxyl, sulfhydryl, nitro, cyano, amino, monoalkylamino or dialkylamino, monoarylamino or diarylamino, ester group, nitrile group, isonitrile group, alkoxycarbonyl, acylamino, alkoxycarbonylamino, aryloxycarbonylamino, sulfonylamino, sulfamido, aminocarbonyl, alkylthio, sulfinyl, uramido, phosphinamide group, imido, sulfo, carboxyl, hydrazino, silyl, substituted silyl, polymerized group, or a combination thereof; and two or more adjacent R¹, R², R³, R⁴ and R⁵ can be selectively linked to form a fused ring.

2. The metal platinum (II) and palladium (II) complex containing the quinoline structural unit and the bridging structure according to claim 1, wherein the metal platinum (II) and palladium (II) complex has a structure as shown in the followings:

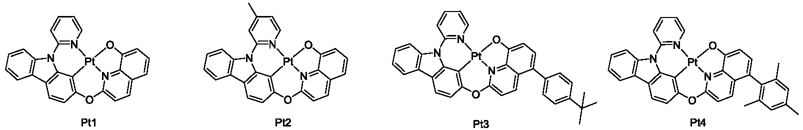

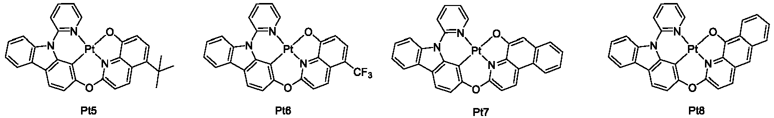

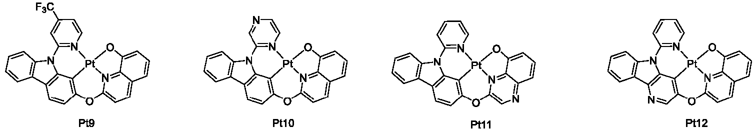

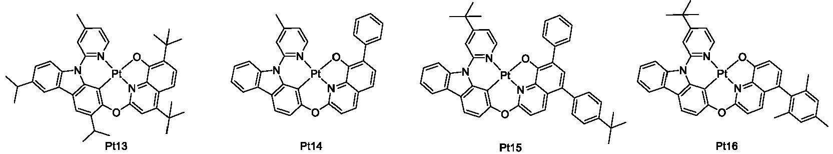

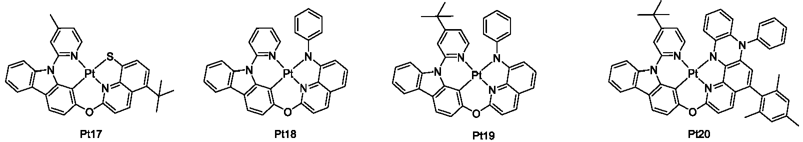

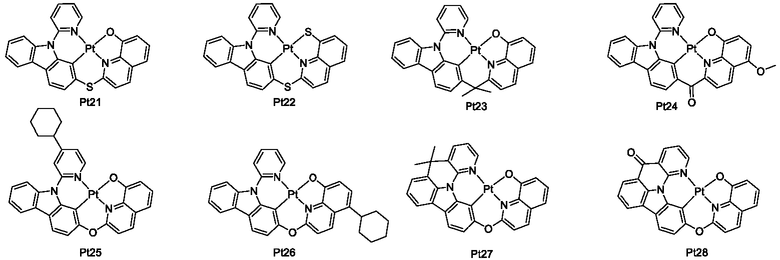

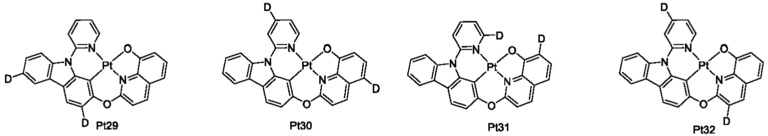

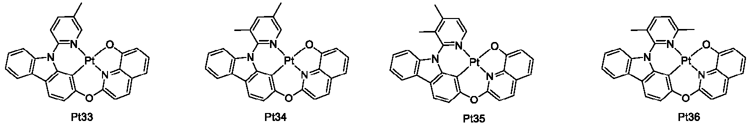

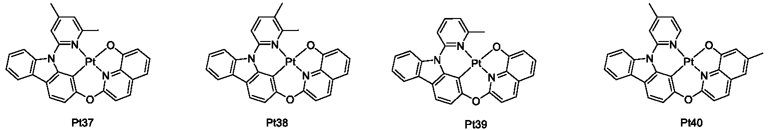

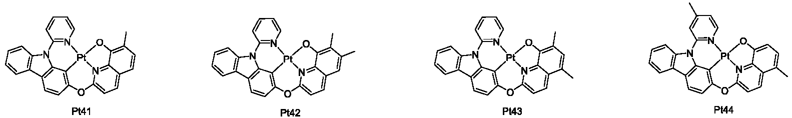

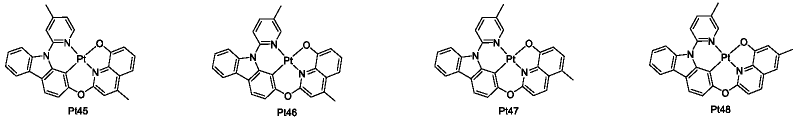

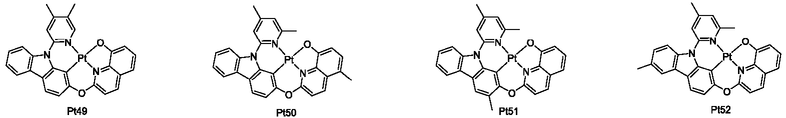

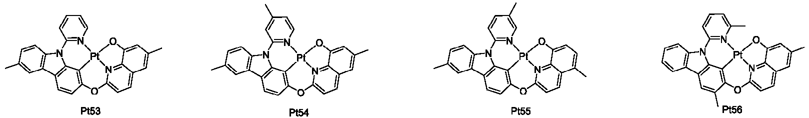

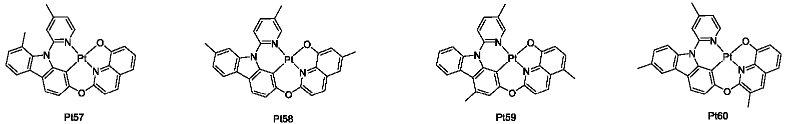

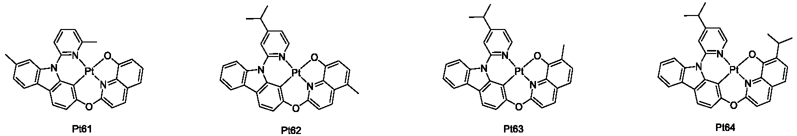

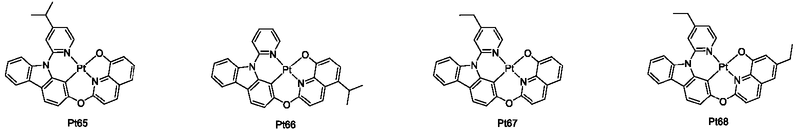

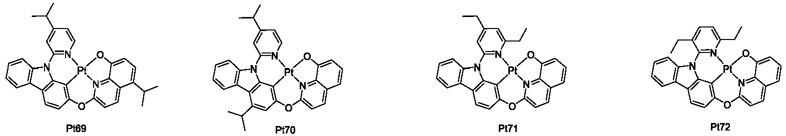

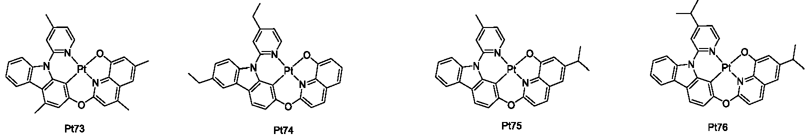

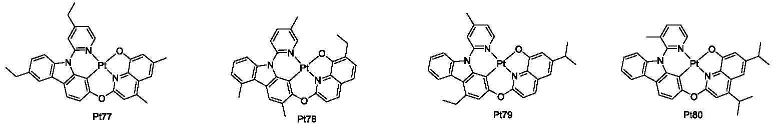

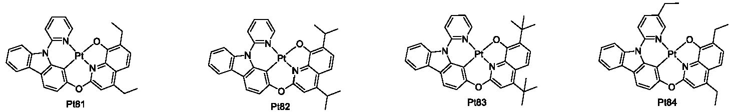

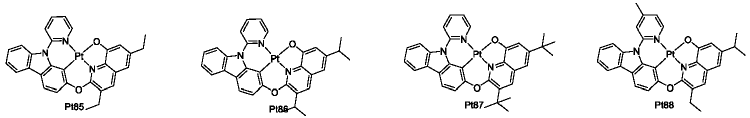

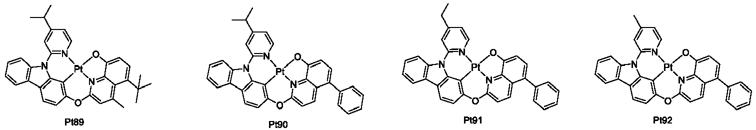

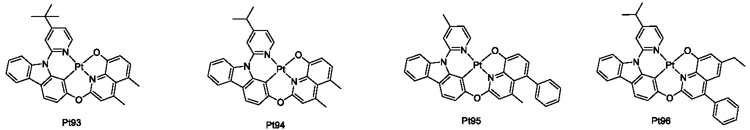

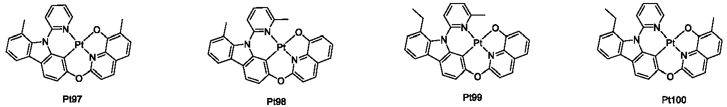

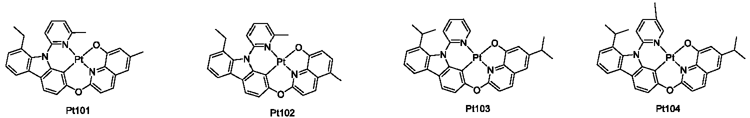

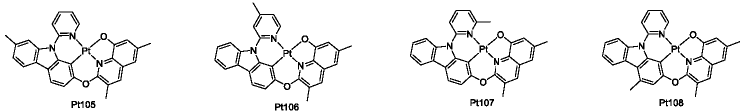

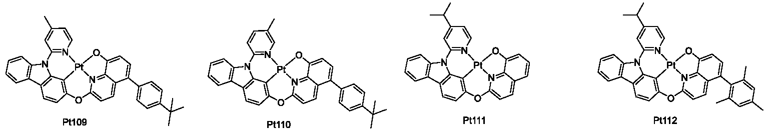

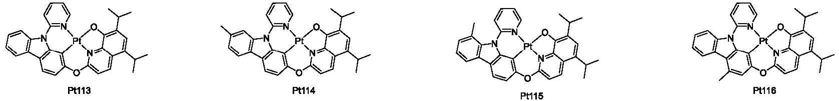

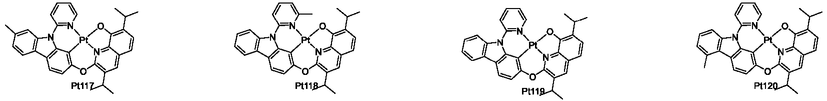

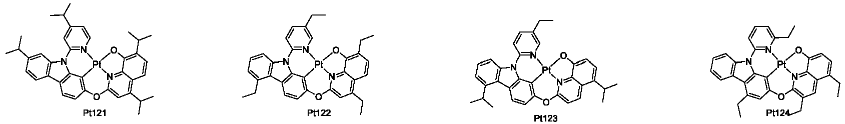

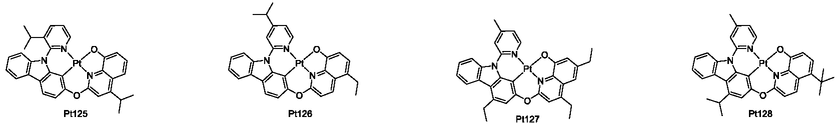

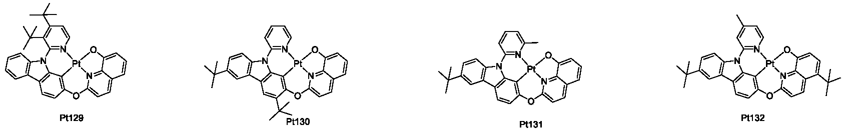

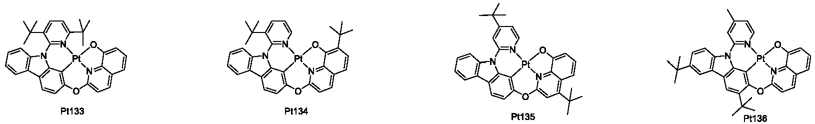

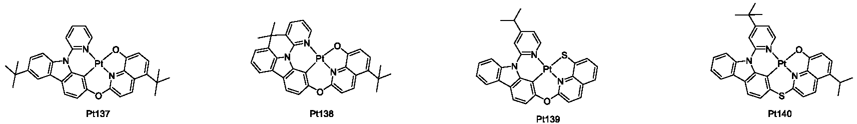

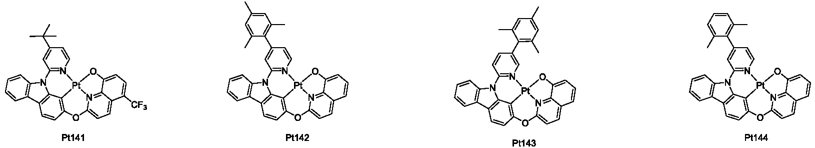

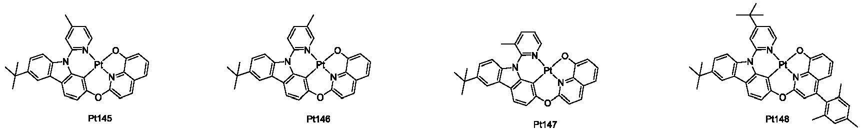

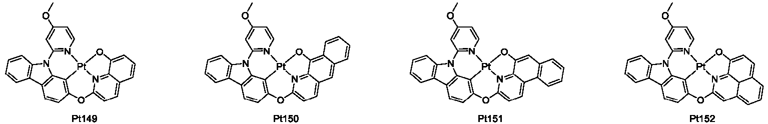

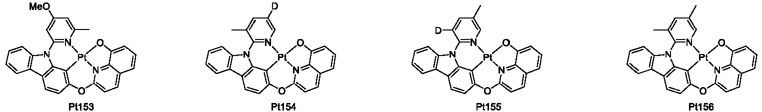

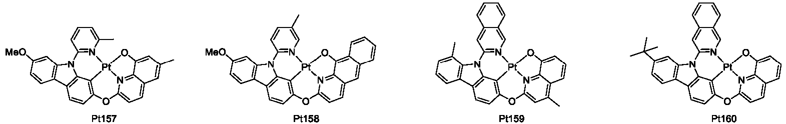

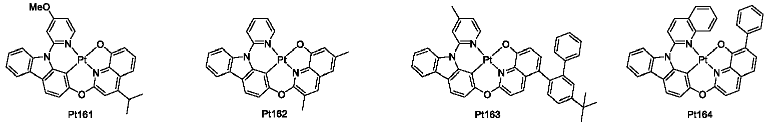

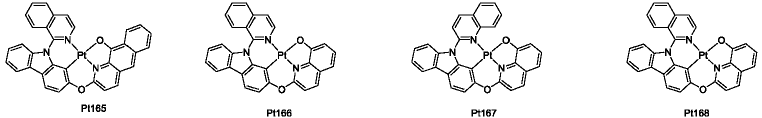

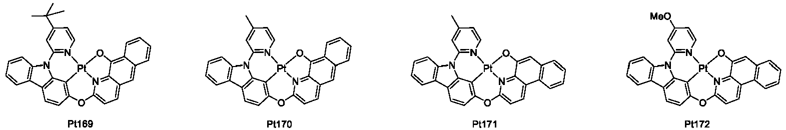

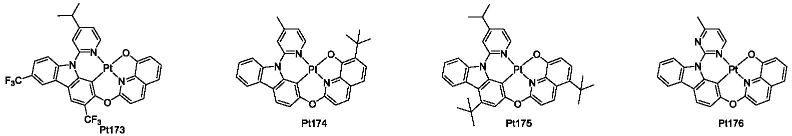

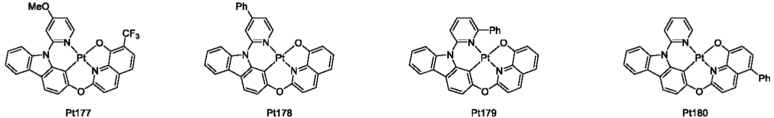

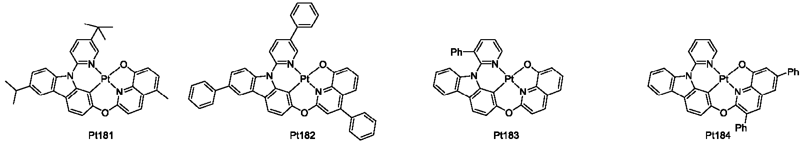

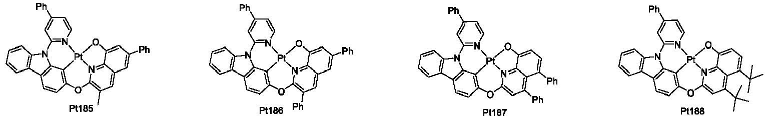

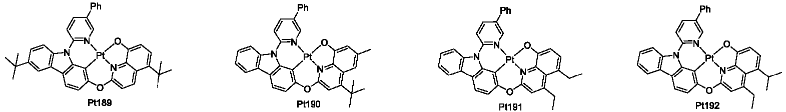

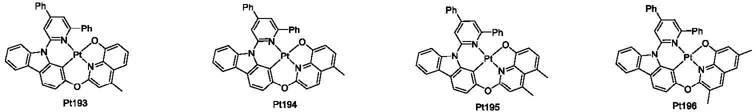

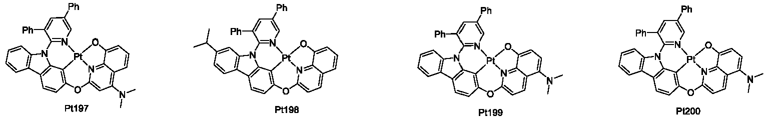

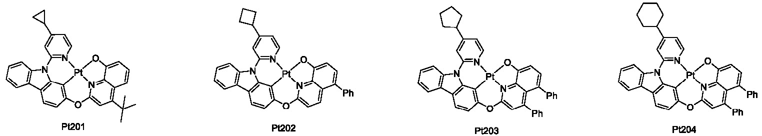

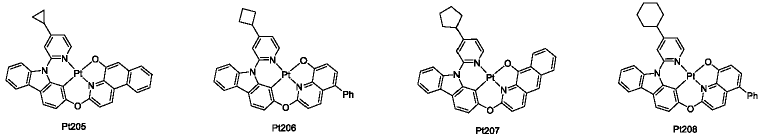

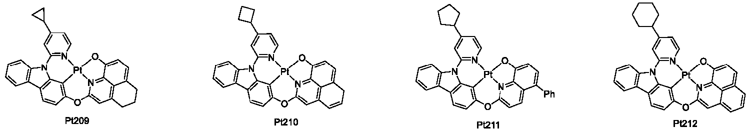

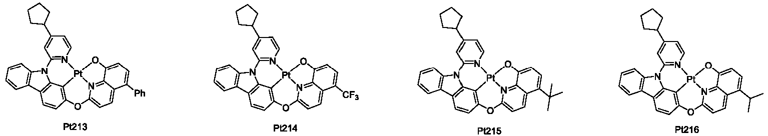

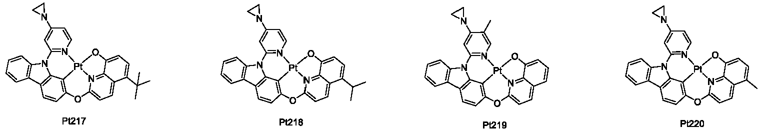

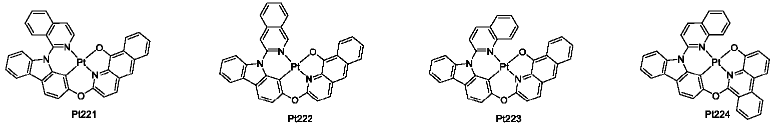

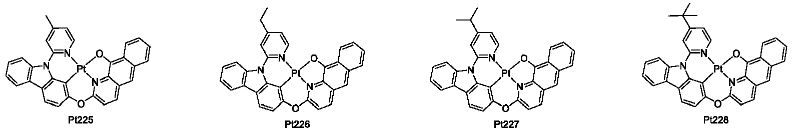

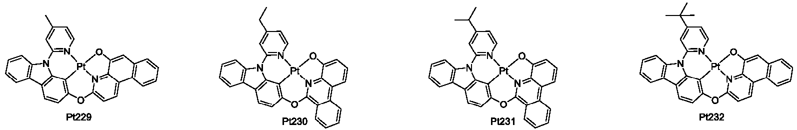

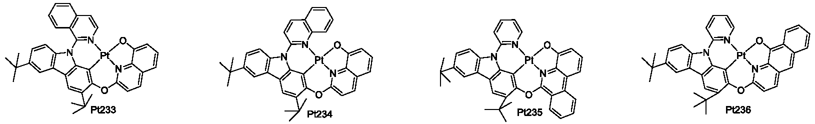

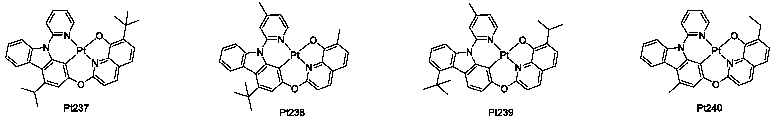

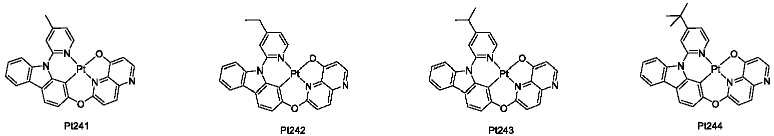

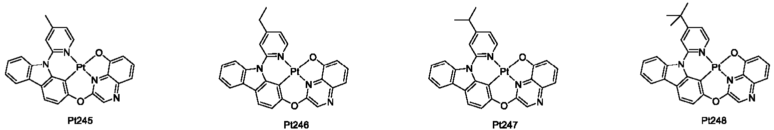

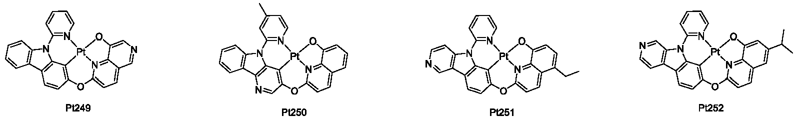

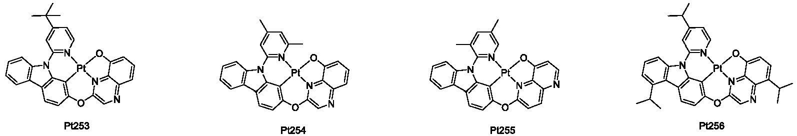

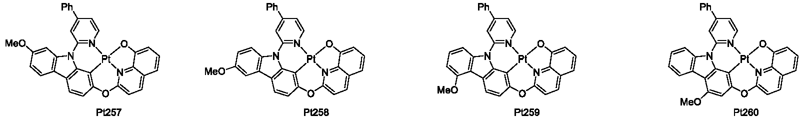

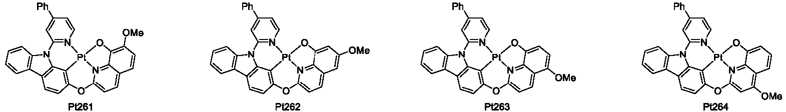

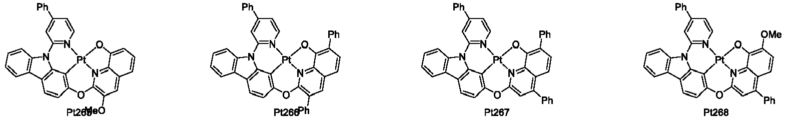

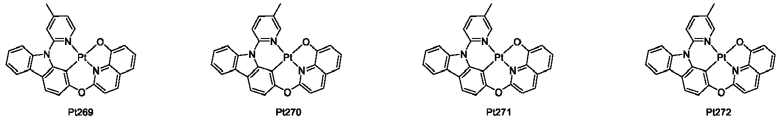

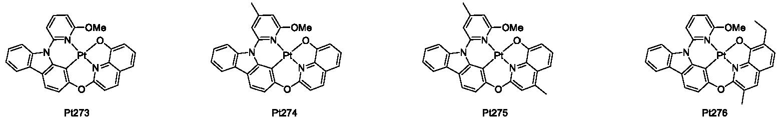

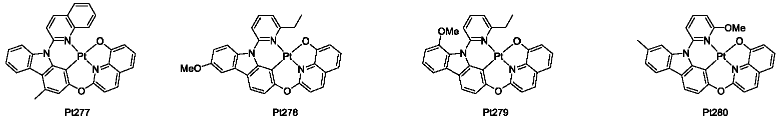

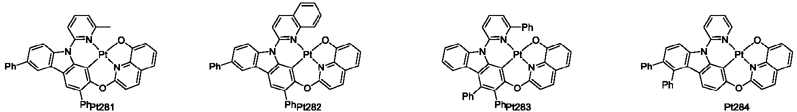

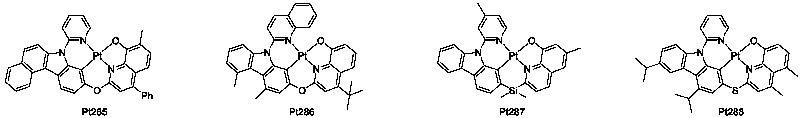

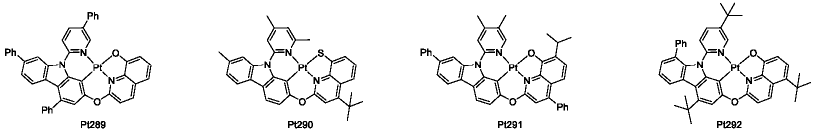

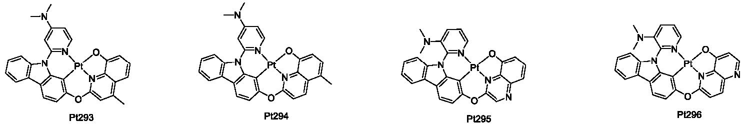

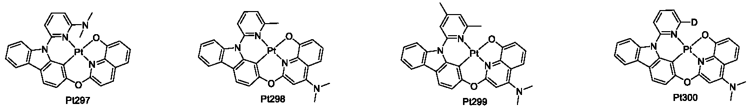

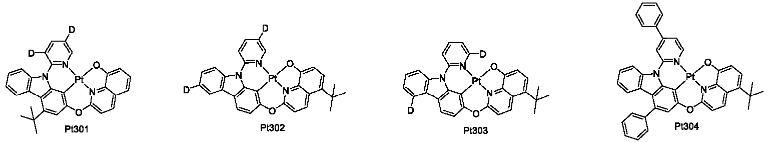

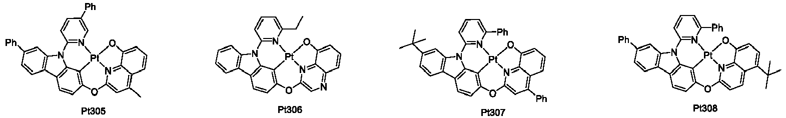

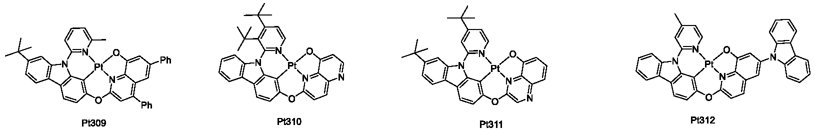

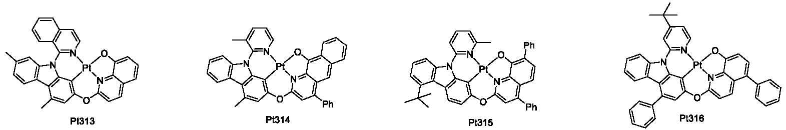

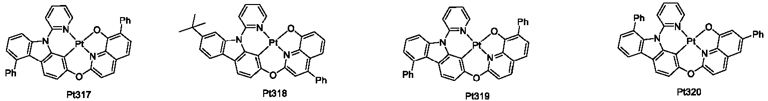

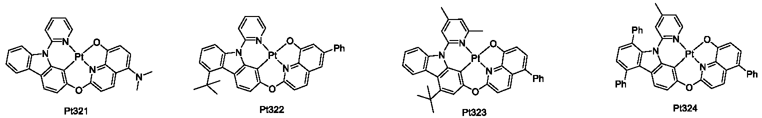

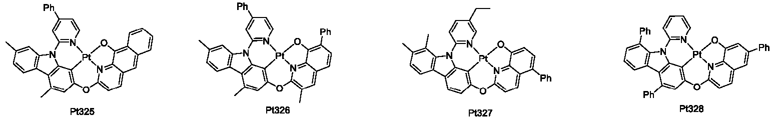

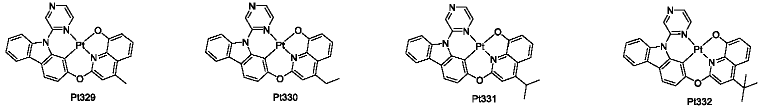

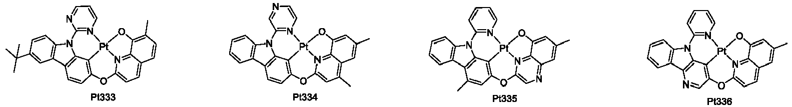

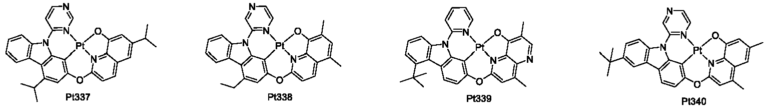

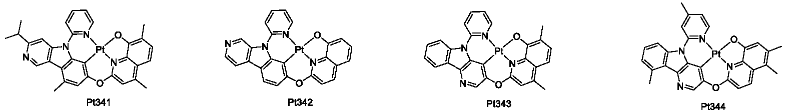

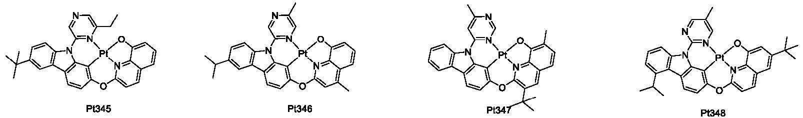

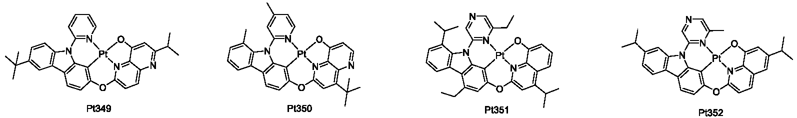

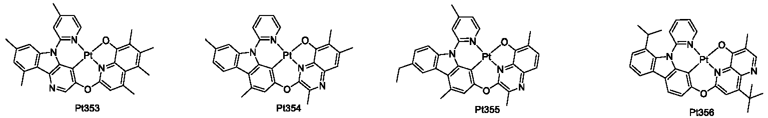

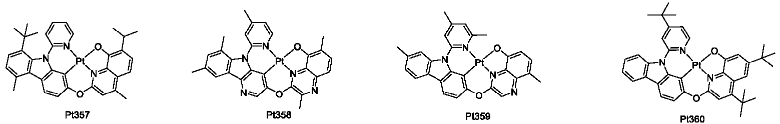

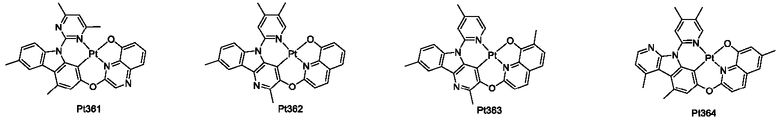

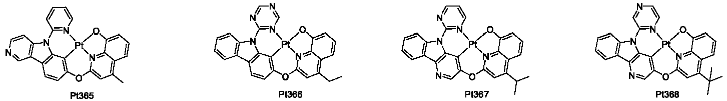

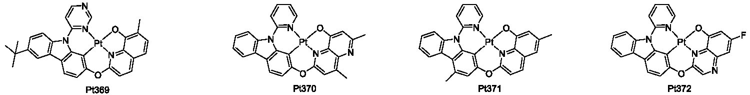

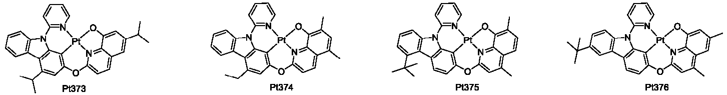

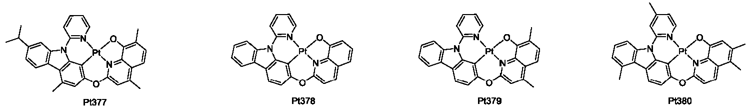

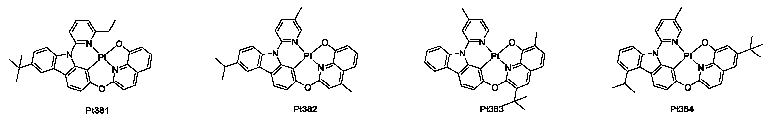

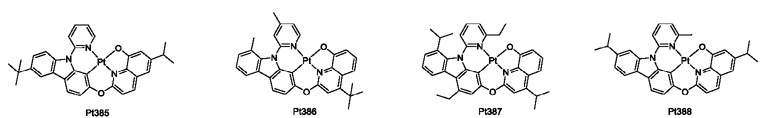

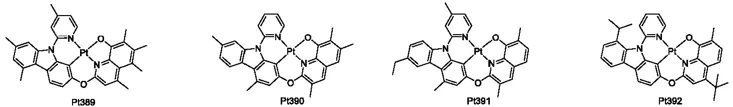

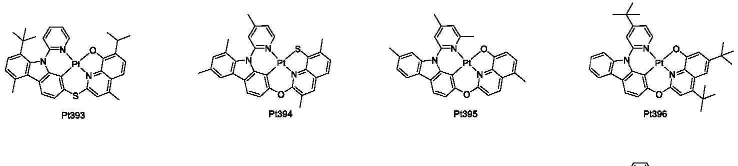

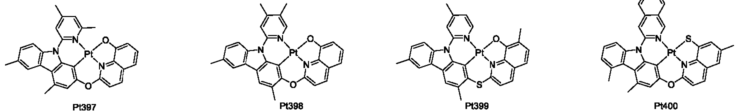

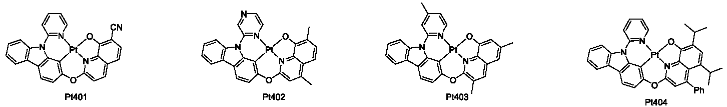

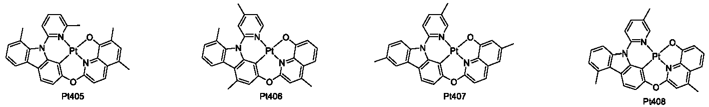

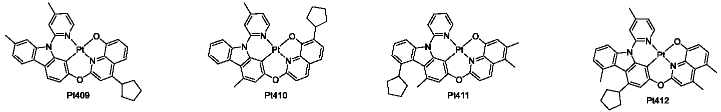

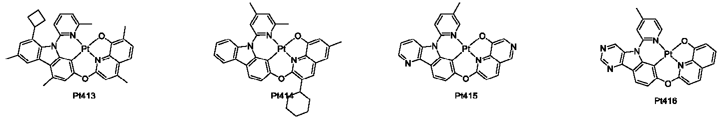

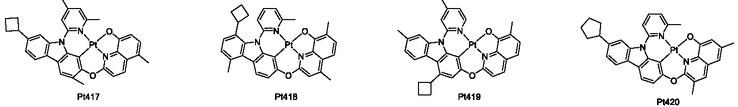

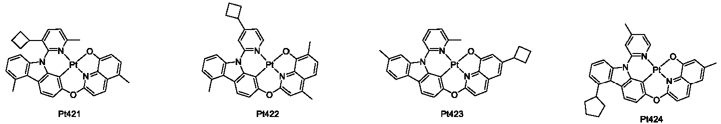

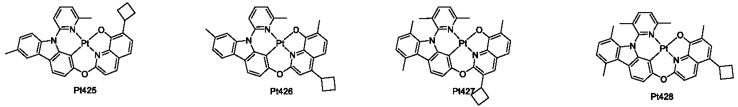

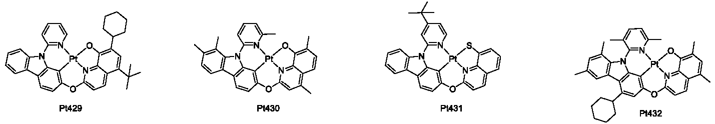

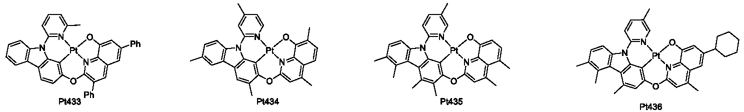

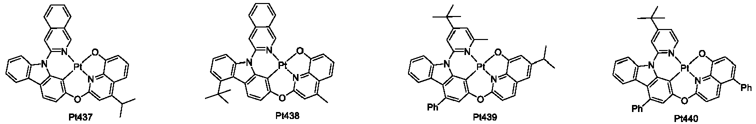

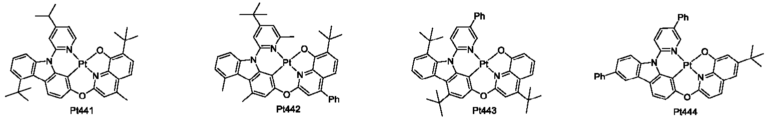

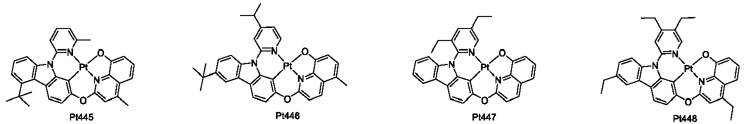

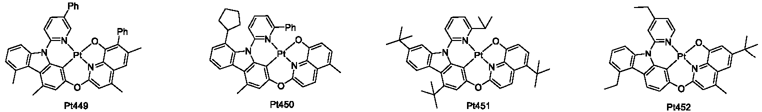

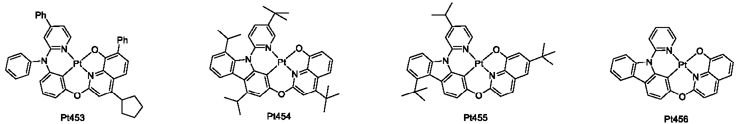

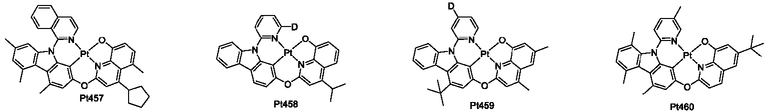

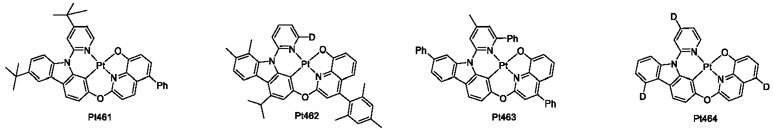

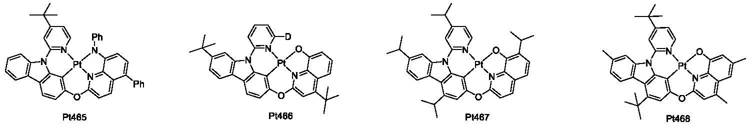

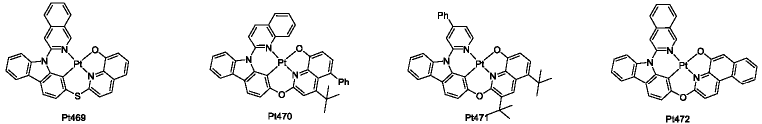

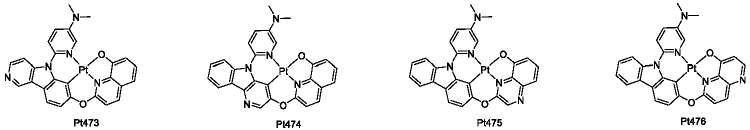

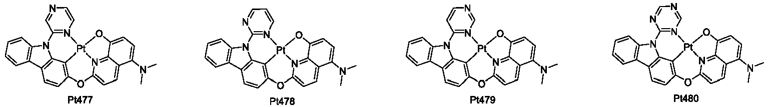

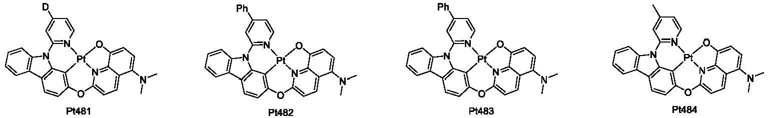

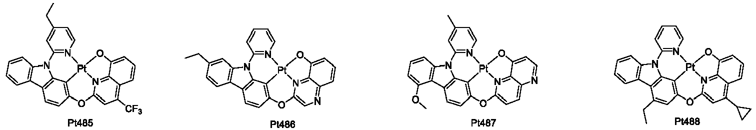

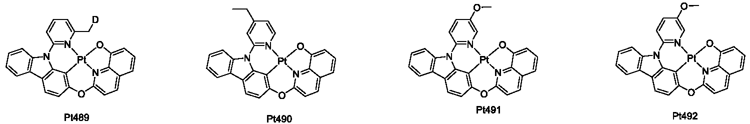

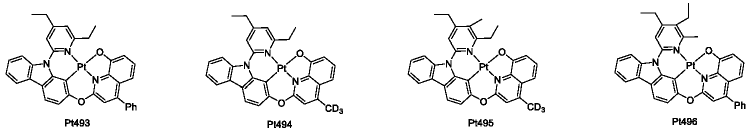

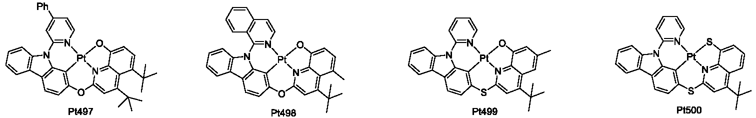

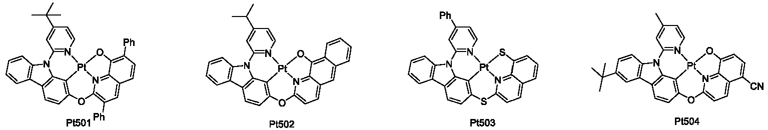

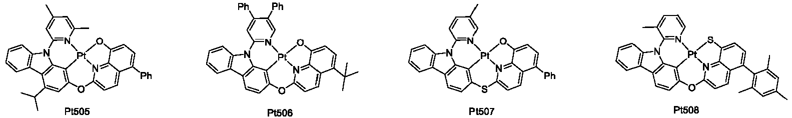

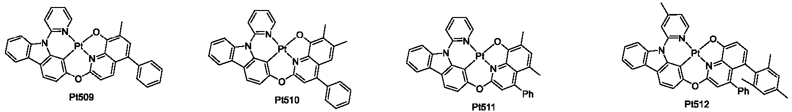

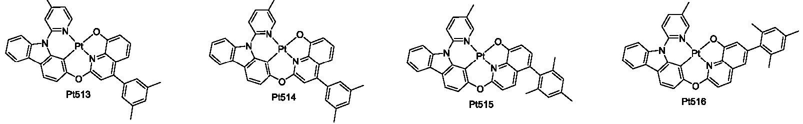

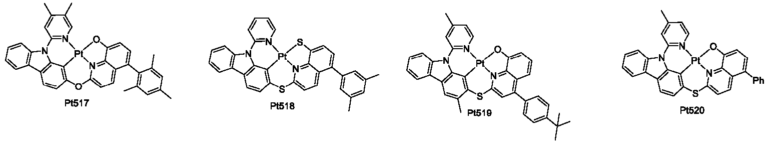

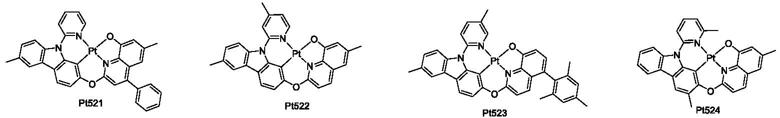

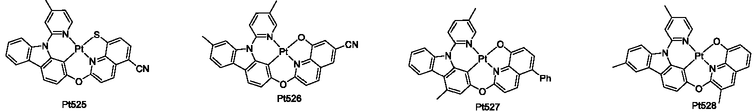

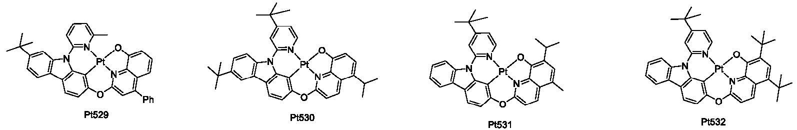

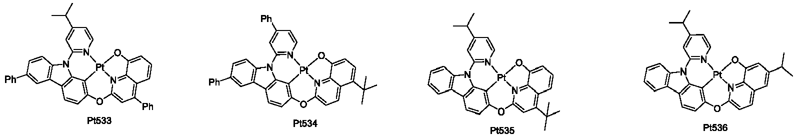

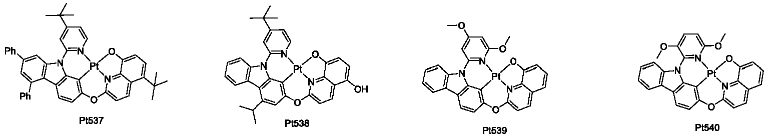

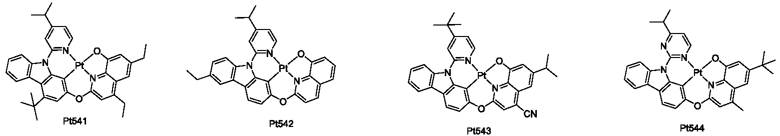

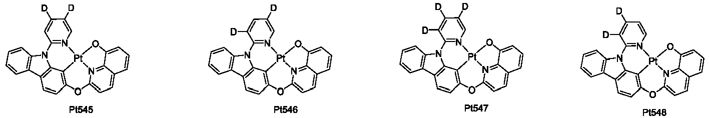

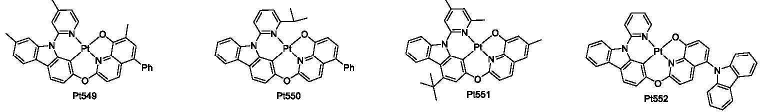

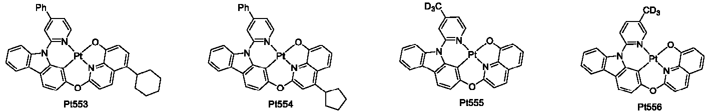

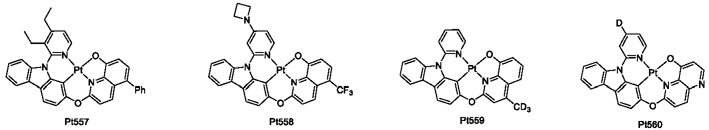

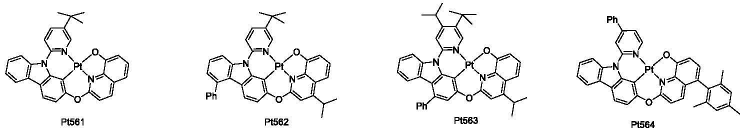

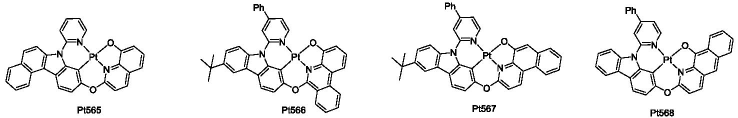

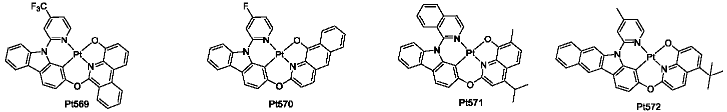

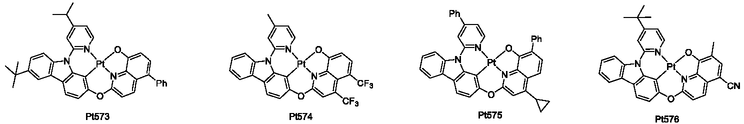

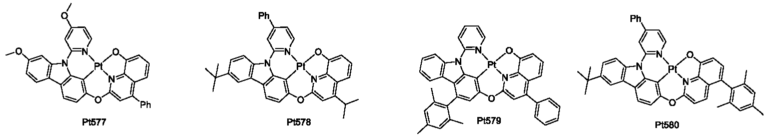

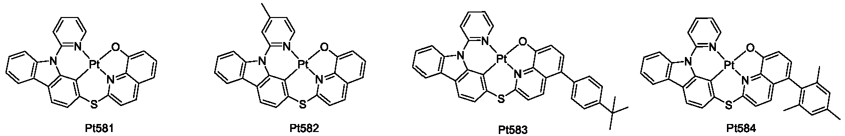

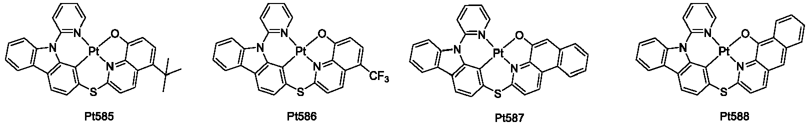

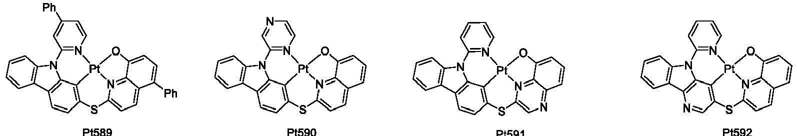

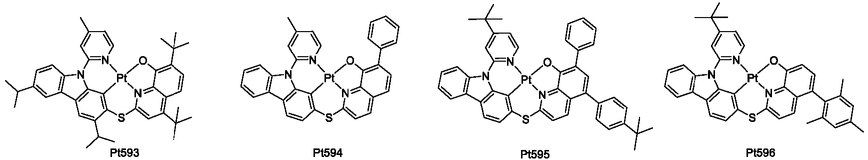

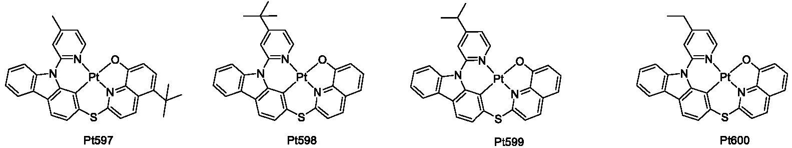

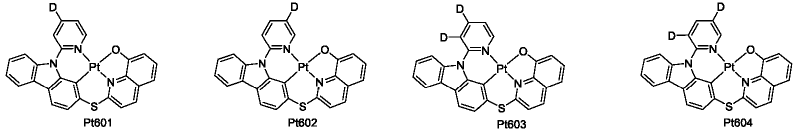

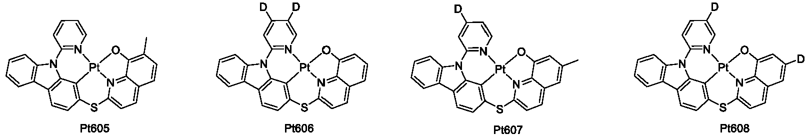

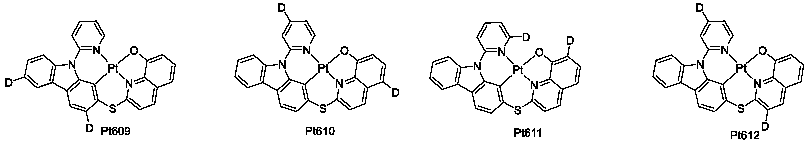

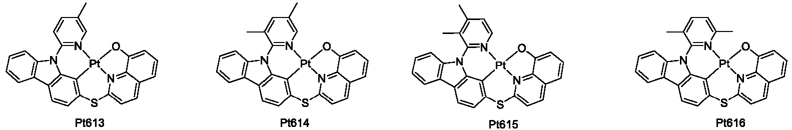

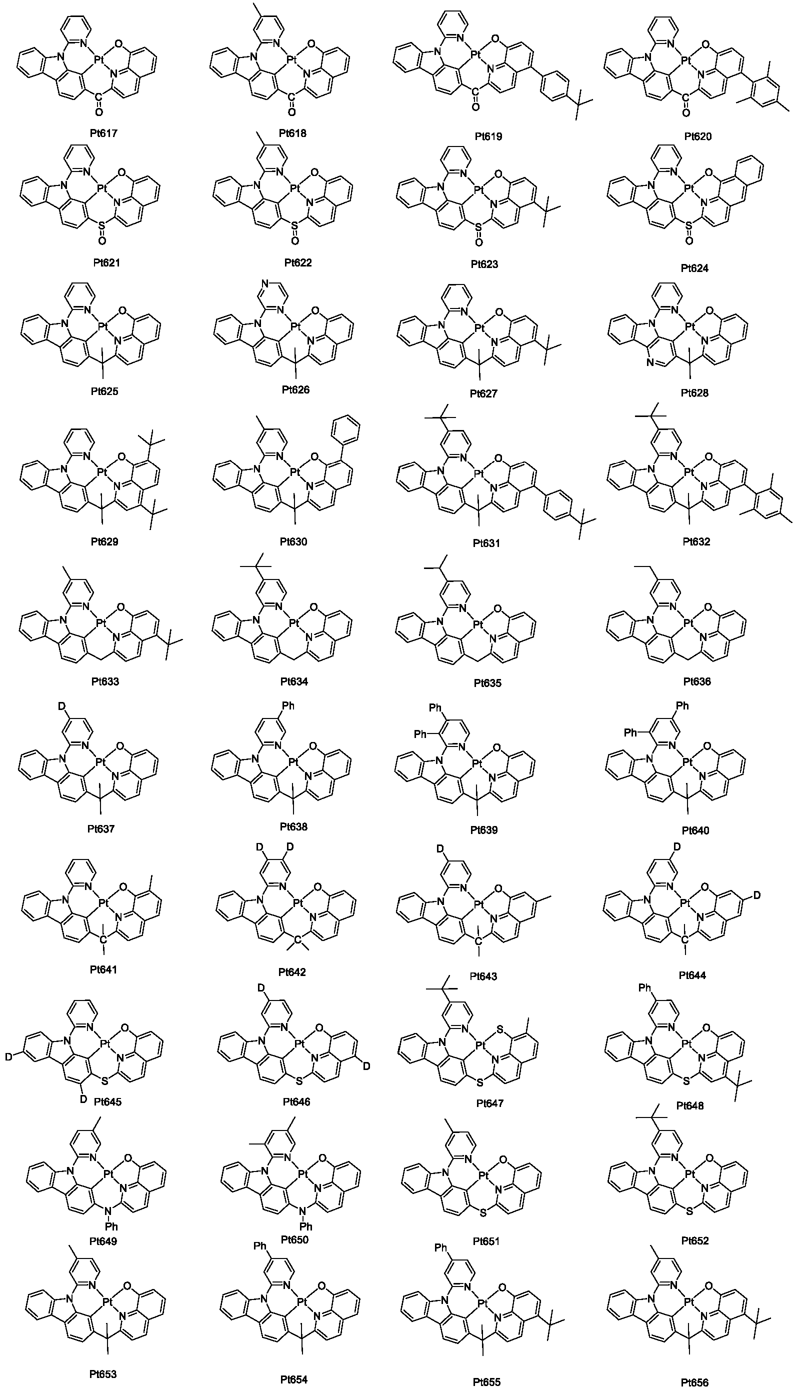

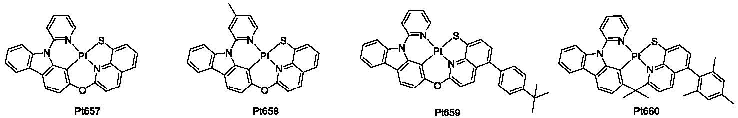

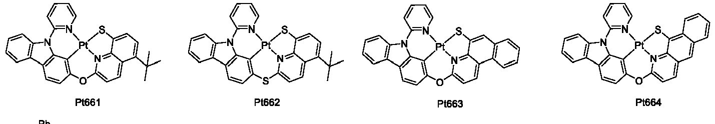

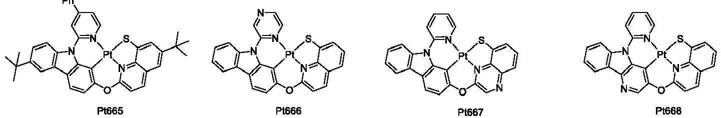

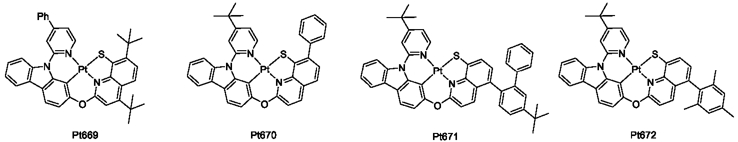

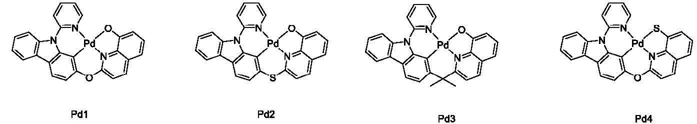

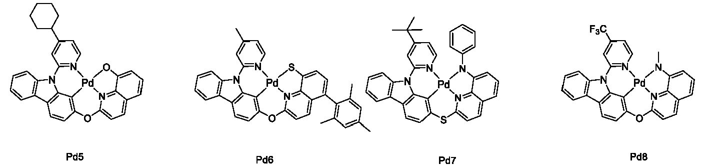

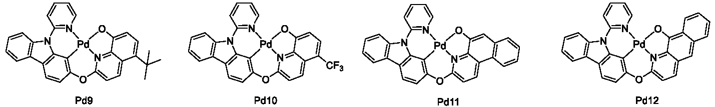

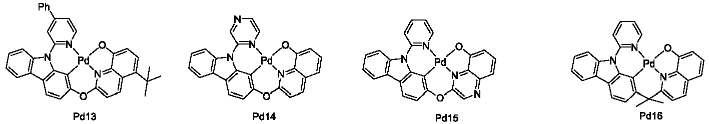

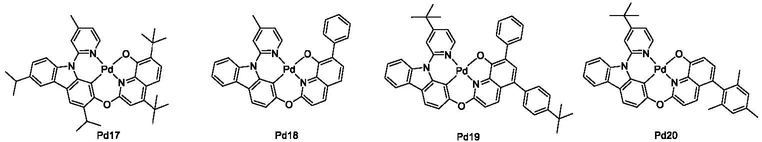

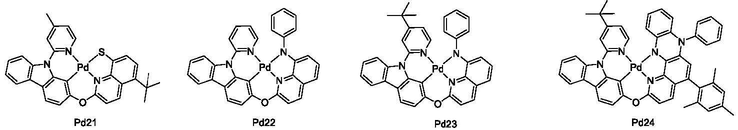

3. An organic light-emitting device, comprising a light-emitting layer on a substrate, the light-emitting layer containing the metal platinum (II) and palladium (II) complex containing the quinoline structural unit and the bridging structure according to claim 1 or 2.

4. An organic light-emitting device, the device containing the metal platinum (II) and palladium (II) complex containing the quinoline structural unit and the bridging structure according to claim 1 or 2.

5. The organic light-emitting device according to claim 4, wherein the device is a full-color display, a photovoltaic device, a light-emitting display device or an organic light-emitting diode.

6. The organic light-emitting device according to claim 5, comprising at least one cathode, at least one anode and at least one light-emitting layer, wherein at least one of the light-emitting layers contains the metal platinum (II) and palladium (II) complex containing the quinoline structural unit and the bridging structure according to claim 1 or 2.

7. The organic light-emitting device according to claim 6, wherein the device is an organic light-emitting diode which has a light-emitting layer, and the light-emitting layer contains a corresponding host material and the metal platinum (II) and palladium (II) complex containing the quinoline structural unit and the bridging structure, wherein a mass percentage of the metal platinum (II) or palladium (II) complex ranges 1% from 50%, and the host material is not limited.

8. A display or lighting apparatus, the display or lighting apparatus comprising the device according to claims 4 to 7.

9. An application of the metal platinum (II) and palladium (II) complex according to claim 1 or 2 in the manufacture of an organic light-emitting device.
